# EUROPEAN PATENT APPLICATION

(11) **EP 4 498 539 A1**
(43) Date of publication of application: **29.01.2025**
(21) Application number: 23759213.4
(22) Date of filing: 22.02.2023
(51) Int. Cl.: H01S 5/183

(54) **SEMICONDUCTOR LASER AND PACKAGING STRUCTURE THEREOF**

(30) Priority: 25.02.2022 US 202263313768 P; 30.06.2022 US 202263357203 P
(71) Applicant: Ireach Corporation, Hsinchu Taiwan 300 (TW)
(72) Inventor: CHUNG, Hsin-Chan, Hsinchu Taiwan 300 (TW); HSU, Tzu-Chieh, Hsinchu Taiwan 300 (TW); LU, Chun-Yi, Hsinchu Taiwan 300 (TW); YANG, Hsiu-Ju, Hsinchu Taiwan 300 (TW); CHEN, Shou-Lung, Hsinchu Taiwan 300 (TW); HUANG, Kuan-Chih, Hsinchu Taiwan 300 (TW); CHEN, Hany-Yi, Hsinchu Taiwan 300 (TW)
(74) Representative: Murgitroyd & Company
(86) International application number: PCT/CN2023/077719
(87) International publication number: WO 2023/160589

(57) **Abstract**

A semiconductor laser (1000, 1001, 1002, 1003, 1004, 1005, 1006, 1007, 1000a, 1000a1, 1000a2, 1000a3, 1000b, 1000b1, 1000b2, 1000b3, 1000b4, 1000b, 2400), comprising a semiconductor stack (10), a first electrode structure, a second electrode structure, and an insulating layer (30, 30B, 301, 302, 601, 601, 602, 90, 93, 108). The semiconductor stack (10) has a first surface (11), a second surface (12), and a side surface (13). The semiconductor stack (10) comprises a first-type semiconductor layer (101, 101U1, 101U2), a second-type semiconductor layer (102, 102U1, 102U2, 102U3, 102U4), and an active layer (103, 103A, 103U1, 103U2, 103U3, 103U4) arranged between the first-type semiconductor layer (101, 101U1, 101U2) and the second-type semiconductor layer (102, 102U1, 102U2, 102U3, 102U4). The first electrode structure is arranged on the first surface (11) and the side surface (13). The second electrode structure is arranged on the second-type semiconductor layer (102, 102U1, 102U2, 102U3, 102U4) and is electrically connected to the second-type semiconductor layer (102, 102U1, 102U2, 102U3, 102U4). The insulating layer (30, 30B, 30U1, 30U2, 60, 60U1, 60U2, 90, 93, 108) is arranged between the semiconductor stack (10) and the first electrode structure and between the semiconductor stack (10) and the second electrode structure. The insulating layer (30, 30B, 30U1, 30U2, 60, 60U1, 60U2, 90, 93, 108) has an opening (31) on the first surface (11), and the first electrode structure is distributed in the opening (31) and in contact with the first-type semiconductor layer (101, 101U1, 101U2).

## Description

The application claims priority to U.S. Application No. 63/313,768 filed on February 25, 2022, and U.S. Application No. 63/357,203 filed on June 30, 2022, the disclosures of which are incorporated by reference herein in their entirety.

### TECHNICAL FIELD

The disclosed embodiments relate to a semiconductor laser and packaging structure thereof.

### BACKGROUND

A vertical cavity surface emitting laser (VCSEL) is a type of semiconductor laser. Due to its structural advantage of emitting light from the epitaxial surface, and with the emergence of more application demands for various Internet of Things products, smart electronic products, and intelligent sensing products, as well as market demand-driven, VCSEL elements have gradually expanded from the network communication product market to various smart products (e.g., optical communication light source modules, proximity sensors in smart tablets/smartphones, depth/distance/3D sensors, LiDAR sensors for advanced driver assistance systems, light sources or panels for micro-projection displays, eye trackers in interactive devices, etc.).

In most of the aforesaid application products, due to various requirements for product development and product use (e.g., low cost, portability, miniaturization, high integration compatibility with other components, stringent environmental reliability for automotive applications, long product life, low power consumption/long usage time, high-frequency electrical driving operation, etc.), the packaging structure of the VCSEL device needs to be adaptively adjusted according to the requirements of different application products to meet the aforesaid specifications.

### SUMMARY

The present disclosure provides embodiments of semiconductor lasers and packaging structures containing the semiconductor lasers. In some embodiments, the electrode structure can be configured on the slanted side surface of the semiconductor stack of the semiconductor laser, such that the size of the packaging structure can be reduced after the laser element is packaged.

Or, in some embodiments, under the constraint of not being able to increase the packaging structure, the electrical bonding is performed through the electrode structure on the slanted side surface of the semiconductor stack to maintain or improve the reliability of the packaging structure.

An embodiment of the present disclosure provides a semiconductor laser, which includes a semiconductor stack, a first electrode structure, and a first insulating layer. The semiconductor stack has a first surface, a second surface, and a side surface. The first surface is opposite to the second surface, and the side surface is located between the first surface and the second surface. The semiconductor stack includes a first-type semiconductor layer, a second-type semiconductor layer, and an active layer. The active layer is located between the first-type semiconductor layer and the second-type semiconductor layer. The first electrode structure is on the first surface and the side surface. In the embodiment, the first electrode structure is on the first surface and extends to the side surface. The first insulating layer is located between the semiconductor stack and the first electrode structure. The first insulating layer includes a first opening on the first surface, and the first electrode structure is further located in the first opening and contacts the first-type semiconductor layer.

In some embodiments, the side surface forms an angle θ with respect to the first surface, and the angle θ ranges from 90 degrees (inclusive) to 120 degrees (inclusive).

In some embodiments, the semiconductor laser further includes a substrate on one side of the second-type semiconductor layer relative to the first-type semiconductor layer.

In those embodiments, the semiconductor laser further includes a second electrode structure on the first surface and the side surface, wherein the first insulating layer is further located between the semiconductor stack and the second electrode structure.

In some embodiments, the second electrode structure and the first insulating layer further extend from the side surface to the substrate surface, and the first insulating layer further includes a second opening on the surface of the substrate, and the second electrode structure extends into the second opening and contacts the substrate, so that the second electrode structure is electrically connected to the second-type semiconductor layer through the substrate.

In some embodiments, the substrate has a surface and a side surface connected to the surface. The second-type semiconductor layer of the semiconductor stack further includes a first platform portion and a second platform portion extending laterally on the surface. The first insulating layer and the second electrode structure are located on the surfaces of the first platform portion and the second platform portion. The first insulating layer has a second opening on the first platform portion, and the second electrode structure extends into the second opening and contacts the first platform portion of the second-type semiconductor layer.

In some embodiments, the second electrode structure is not only located in the second opening of the first insulating layer but also extends to the side surface of the substrate, and the first electrode structure also extends from the side surface of the semiconductor stack through the second platform portion to the side surface of the substrate.

In the embodiment, the semiconductor laser further includes a second insulating layer and an adhesive layer, wherein the second insulating layer is located between the semiconductor stack and the second electrode structure, and the adhesive layer is located between the semiconductor stack and the substrate. The second electrode structure is on the first surface, the side surface, and the second surface. The first insulating layer is located between the semiconductor stack and the second electrode structure, wherein the first insulating layer includes second openings on the second surface, and the second electrode structure is further located in the second openings and contacts the second-type semiconductor layer.

In some embodiments, the second electrode structure is not only located in the second openings of the first insulating layer but also on the first surface of the semiconductor stack and extends to the side surface and the second surface.

In some embodiments, the adhesive layer and the substrate are transparent, the adhesive layer is on the second-type semiconductor layer and covers the second electrode structure and the second insulating layer, while the substrate is on the adhesive layer.

In some embodiments, the semiconductor stack further includes a first current blocking layer located between the active layer and the first-type semiconductor layer, the first current blocking layer includes a first current blocking region and a first current conducting region, and the first current conducting region is surrounded by the first current blocking region.

In some embodiments, either the first-type semiconductor layer or the second-type semiconductor layer, or both the first-type semiconductor layer and the second-type semiconductor layer have a reflective mirror layer.

In some embodiments, the semiconductor stack further includes a first current blocking layer and a second current blocking layer. The first current blocking layer is located between the active layer and the first-type semiconductor layer, the first current blocking layer includes a first current blocking region and a first current conducting region, and the first current conducting region is surrounded by the first current blocking region. The second current blocking layer is located between the first-type semiconductor layer and the second-type semiconductor layer, the second current blocking layer includes a second current blocking region and a second current conducting region, and the second current conducting region is surrounded by the second current blocking region. The active layer has a first quantum well layer, a second quantum well layer, and a spacer layer, and the active layer further includes a tunnel junction layer located between the first quantum well layer and the second quantum well layer. The first current blocking layer is on the first quantum well layer, the spacer layer is located between the first quantum well layer and the tunnel junction layer, and the second quantum well layer is located between the second current blocking layer and the second-type semiconductor layer.

In some embodiments, the semiconductor laser further includes a first conductive connection, a second conductive connection, and a third insulating layer. The first conductive connection is on a side away from the substrate and connects to the first electrode structure. The second conductive connection is on one side away from the substrate and connects to the second electrode structure. The third insulating layer is located between the first electrode structure and the first conductive connection, and between the second electrode structure and the second conductive connection.

In some embodiments, the second electrode structure located on the second surface includes an electrode opening corresponding to the positions of the first current conducting region and the second current conducting region, wherein the width of the electrode opening is greater than the width of the first current conducting region, and the width of the electrode opening is greater than or equal to the width of the second current conducting region.

In one embodiment, a packaging structure is provided, which includes a package substrate, a semiconductor laser, and a packaging layer. The semiconductor laser has a light-output surface and a surface opposite to the light-output surface. The semiconductor laser is on the package substrate, and the surface contacts the package substrate, wherein the first electrode structure and the second electrode structure located on the side surface of the semiconductor laser are electrically connected to the first conductive pad structure and the second conductive pad structure of the package substrate through connection structures, respectively. The packaging layer includes a packaging material and covers the semiconductor laser. The packaging layer has filler particles.

In some embodiments, the semiconductor laser further has a third insulating layer on one side surface (adjacent to the side surface near the second electrode structure), wherein the third insulating layer extends to the light-output surface to cover a portion of the first electrode structure. There is a gap between the lowest portion of the first electrode structure and the second electrode structure and the upper surface of the package substrate, wherein the gap is 30 to 50 micrometers.

In some embodiments, the first surface of the main body of the package substrate further includes a barrier wall, and the semiconductor laser is on the first surface and surrounded by the barrier wall. The packaging layer is filled in the area surrounded by the barrier wall and covers the semiconductor laser.

In some embodiments, the first conductive pad structure of the package substrate includes a first conductive pad portion, a first inner connection portion, and a second conductive pad portion, and the second conductive pad structure of the package substrate includes a third conductive pad portion, a second inner connection portion, and a fourth conductive pad portion. The first conductive pad portion and the third conductive pad portion are on the first surface of the package substrate and surrounded by the barrier wall. The first inner connection portion and the second inner connection portion are embedded in the main body and individually connected to the first conductive pad portion and the third conductive pad portion, respectively. The second conductive pad portion and the fourth conductive pad portion are on the second surface of the main body and individually connected to the first inner connection portion and the second inner connection portion, respectively.

In one embodiment, a semiconductor laser is provided, which includes a semiconductor stack, a first electrode structure, a first insulating layer, a substrate, a second electrode structure, and a second insulating layer, wherein the substrate is a conductive layer, and the second electrode structure includes a second contact electrode portion and a second extended electrode portion. The semiconductor stack has a first surface, a second surface, and a side surface. The second surface is opposite to the first surface, and the side surface is located between the first surface and the second surface. The side surface forms an angle θ with respect to the first surface, and the angle θ is substantially 90 degrees. The semiconductor stack includes a first-type semiconductor layer, a second-type semiconductor layer, and an active layer, wherein the active layer is located between the first-type semiconductor layer and the second-type semiconductor layer. The first electrode structure is on the first surface. The first insulating layer is located between the semiconductor stack and the first electrode structure, wherein the first insulating layer includes a first opening on the first surface, and the first electrode structure is further located in the first opening and contacts the first-type semiconductor layer. The substrate is on one side of the second-type semiconductor layer relative to the first-type semiconductor layer. The first insulating layer is further located between the semiconductor stack and the second electrode structure, and between the first electrode structure and the second electrode structure, wherein the first insulating layer has a through-hole penetrating through the semiconductor stack. The second contact electrode portion of the second electrode structure is in the through-hole and contacts the substrate, so that the second electrode structure is electrically connected to the second-type semiconductor layer through the substrate. The second insulating layer is in the through-hole and between the second contact electrode portion and the semiconductor stack to isolate the second contact electrode portion from the first-type semiconductor layer and the active layer. The second extended electrode portion of the second electrode structure connects to the second contact electrode portion and extends from the first surface to the side surface.

In the embodiment, the semiconductor laser further includes a second insulating layer and an adhesive layer, wherein the second insulating layer is located between the semiconductor stack and the second electrode structure, and the adhesive layer is located between the semiconductor stack and the substrate. The second electrode structure is on the first surface, the side surface, and the second surface. The first insulating layer is located between the semiconductor stack and the second electrode structure, wherein the first insulating layer includes second openings on the second surface, and the second electrode structure is further located in the second openings and contacts the second-type semiconductor layer.

In some embodiments, the second electrode structure is not only located in the second openings of the first insulating layer but also located on the first surface of the semiconductor stack and extends to the side surface and the second surface.

In some embodiments, the adhesive layer and the substrate are transparent, the adhesive layer is on the second-type semiconductor layer and covers the second electrode structure and the second insulating layer, while the substrate is on the adhesive layer.

In some embodiments, the semiconductor stack further includes a first current blocking layer located between the active layer and the first-type semiconductor layer, the first current blocking layer includes a first current blocking region and a first current conducting region, and the first current conducting region is surrounded by the first current blocking region.

In some embodiments, either the first-type semiconductor layer or the second-type semiconductor layer, or both the first-type semiconductor layer and the second-type semiconductor layer have a reflective mirror layer.

In some embodiments, the semiconductor stack further includes a first current blocking layer and a second current blocking layer. The first current blocking layer is located between the active layer and the first-type semiconductor layer, the first current blocking layer includes a first current blocking region and a first current conducting region, and the first current conducting region is surrounded by the first current blocking region. The second current blocking layer is located between the first-type semiconductor layer and the second-type semiconductor layer, the second current blocking layer includes a second current blocking region and a second current conducting region, and the second current conducting region is surrounded by the second current blocking region. The active layer has a first quantum well layer, a second quantum well layer, and a spacer layer, and the active layer further includes a tunnel junction layer located between the first quantum well layer and the second quantum well layer. The first current blocking layer is on the first quantum well layer, the spacer layer is located between the first quantum well layer and the tunnel junction layer, and the second quantum well layer is located between the second current blocking layer and the second-type semiconductor layer.

In some embodiments, the semiconductor laser further includes a first conductive connection, a second conductive connection, and a third insulating layer. The first conductive connection is on a side away from the substrate and connects to the first electrode structure. The second conductive connection is on a side away from the substrate and connects to the second electrode structure. The third insulating layer is located between the first electrode structure and the first conductive connection, and between the second electrode structure and the second conductive connection.

In some embodiments, the second electrode structure located on the second surface has an electrode opening corresponding to the positions of the first current conducting region and the second current conducting region, wherein the width of the electrode opening is greater than the width of the first current conducting region, and the width of the electrode opening is greater than or equal to the width of the second current conducting region.

In one embodiment, a packaging structure is provided, which includes a package substrate, a semiconductor laser, and a packaging layer. The semiconductor laser has a light-output surface and a surface opposite to the light-output surface. The semiconductor laser is on the package substrate, and the surface contacts the package substrate, wherein the first electrode structure and the second electrode structure located on the side surface of the semiconductor laser are electrically connected to the first conductive pad structure and the second conductive pad structure of the package substrate through connection structures, respectively. The packaging layer includes a packaging material and covers the semiconductor laser. The packaging layer has filler particles.

In some embodiments, the semiconductor laser further has a third insulating layer on one side surface (adjacent to the side surface near the second electrode structure), wherein the third insulating layer extends to the light-output surface to cover a portion of the first electrode structure. There is a gap between the lowest portion of the first electrode structure and the second electrode structure and the upper surface of the package substrate, wherein the gap is 30 to 50 micrometers.

In some embodiments, the first surface of the main body of the package substrate further has a barrier wall, and the semiconductor laser is on the first surface and surrounded by the barrier wall. The packaging layer is filled in the area surrounded by the barrier wall and covers the semiconductor laser.

In some embodiments, the first conductive pad structure of the package substrate includes a first conductive pad portion, a first inner connection portion, and a second conductive pad portion, and the second conductive pad structure of the package substrate includes a third conductive pad portion, a second inner connection portion, and a fourth conductive pad portion. The first conductive pad portion and the third conductive pad portion are located on the first surface of the package substrate and surrounded by the barrier wall. The first inner connection portion and the second inner connection portion are embedded in the main body and individually connected to the first conductive pad portion and the third conductive pad portion, respectively. The second conductive pad portion and the fourth conductive pad portion are located on the second surface of the main body and individually connected to the first inner connection portion and the second inner connection portion, respectively.

In one embodiment, a semiconductor laser is provided, which includes a semiconductor stack, a first electrode structure, a first insulating layer, a substrate, a second electrode structure, and a second insulating layer, wherein the substrate is a conductive layer, and the second electrode structure includes a second contact electrode portion and a second extended electrode portion. The semiconductor stack has a first surface, a second surface, and a side surface. The second surface is opposite to the first surface, and the side surface is located between the first surface and the second surface. The side surface forms an angle θ with respect to the first surface, and the angle θ is substantially 90 degrees. The semiconductor stack includes a first-type semiconductor layer, a second-type semiconductor layer, and an active layer, wherein the active layer is located between the first-type semiconductor layer and the second-type semiconductor layer. The first electrode structure is on the first surface. The first insulating layer is located between the semiconductor stack and the first electrode structure, wherein the first insulating layer has a first opening located on the first surface, and the first electrode structure is further located in the first opening and contacts the first-type semiconductor layer. The substrate is on one side of the second-type semiconductor layer relative to the first-type semiconductor layer. The first insulating layer is further located between the semiconductor stack and the second electrode structure, and between the first electrode structure and the second electrode structure, wherein the first insulating layer has a through-hole penetrating through the semiconductor stack. The second contact electrode portion of the second electrode structure is in the through-hole and contacts the substrate, so that the second electrode structure is electrically connected to the second-type semiconductor layer through the substrate. The second insulating layer is in the through-hole and between the second contact electrode portion and the semiconductor stack to isolate the second contact electrode portion from the first-type semiconductor layer and the active layer. The second extended electrode portion of the second electrode structure connects to the second contact electrode portion and extends from the first surface to the side surface.

In one embodiment, a packaging structure is provided, which includes a package substrate and a semiconductor laser, wherein the package substrate includes a main body, a first conductive pad structure, and a second conductive pad structure. The semiconductor laser has a light-output surface and a surface. The surface of the semiconductor stack of the semiconductor laser faces the main body, and the substrate is away from the main body. The first electrode structure located on the side surface of the semiconductor stack and the second electrode structure can be electrically connected to the first conductive pad structure and the second conductive pad structure of the package substrate through connection structures, respectively.

In one embodiment, a semiconductor laser is provided, which includes a semiconductor stack, a first electrode structure, a second electrode structure, an electrode substrate, an adhesive layer, and an insulating layer. The semiconductor laser further has a through-hole, wherein the through-hole penetrates through the semiconductor stack and the adhesive layer. The semiconductor stack has a first surface, a second surface, and a side surface. The second surface is opposite to the first surface, and the side surface is located between the first surface and the second surface. The side surface forms an angle θ with respect to the first surface, and the angle θ is substantially 90 degrees. The semiconductor stack includes a first-type semiconductor layer, a second-type semiconductor layer, and an active layer. The active layer is located between the first-type semiconductor layer and the second-type semiconductor layer. The first electrode structure is on the first surface to make electrical contact with the first-type semiconductor layer. The second electrode structure is on the second surface to make electrical contact with the second-type semiconductor layer. The electrode substrate has a body, a first electrode unit, and a second electrode unit, wherein the body is non-conductive, and the first electrode unit and the second electrode unit are located on two side surfaces of the body and extend to the upper and lower surfaces of the body, and the first electrode unit and the second electrode unit are not in contact with each other. The adhesive layer is located between the first-type semiconductor layer and the electrode substrate and is non-conductive. The insulating layer is in the through-hole and between the semiconductor stack and the second electrode structure to electrically insulate the active layer, the first-type semiconductor layer, and the second electrode structure. The second electrode structure extends from the second surface into the through-hole and contacts the second electrode unit of the electrode substrate. The first electrode structure is further electrically connected to the first electrode unit.

In one embodiment, a packaging structure is provided, which includes a package substrate, a semiconductor laser, and a connection structure, wherein the package substrate includes a main body, a first conductive pad structure, and a second conductive pad structure. The semiconductor laser has a light-output surface and a surface. The semiconductor laser is placed on the package substrate. The electrode substrate of the semiconductor laser is on one side closer to the main body, and the semiconductor stack of the semiconductor laser is on the other side away from the main body. The first electrode structure is electrically connected to the first conductive pad structure of the package substrate through the connection structure and the first electrode unit. The second electrode structure is electrically connected to the second conductive pad structure through the connection structure and the second electrode unit.

In one embodiment, a semiconductor laser is provided, which includes a semiconductor stack, a first electrode structure, a first insulating layer, a second electrode structure, a second insulating layer, an adhesive layer, a substrate, and an optical element. The optical element is on the substrate.

In some embodiments, the semiconductor laser may have plural optical elements located at different positions on the substrate. In some embodiments, a first optical element is on the substrate, while a second optical element is located under the substrate.

In some embodiments, the substrate includes a first substrate, a second substrate, and an adhesive layer, wherein the second substrate is bonded to the first substrate through the adhesive layer. In some embodiments, the second substrate has an optical element.

In some embodiments, the structure of the optical element can be in the surface area of the substrate or inside the body of the substrate.

In some embodiments, the semiconductor laser further includes a third optical element. The structure of the third optical element is on the second surface of the semiconductor stack. The structure of the third optical element is located in the light output opening of the second electrode structure, and the structure of the third optical element is located between the second insulating layer and the adhesive layer, wherein the location of the light output opening corresponds to the location of the first current conducting region in the semiconductor stack.

In some embodiments, the third optical element has a metasurface structure, wherein the metasurface structure is composed of plural periodically arranged nanostructures. In some embodiments, between the adhesive layer and the substrate of the semiconductor laser, there is a fourth optical element to change the propagation direction of the light incident on the substrate. Furthermore, on the light output side of the substrate, there is a fifth optical element to further change the propagation direction of the light emitted from the substrate.

In some embodiments, the fourth optical element is a structural layer between the second insulating layer and the adhesive layer, but the disclosed embodiments are not limited thereto. In some embodiments, the third optical element can be an interfacial structure between the second insulating layer and the adhesive layer.

In some embodiments, the aforesaid optical elements can include, for example, a diffraction optical element (DOE) structure, a micro-lens array (MLA) structure, a metasurface structure or a metalens, or a combination of these various optical element structures.

In some embodiments, the structure of the optical element can be in the surface area of the substrate or inside the body of the substrate, but the disclosed embodiments are not limited thereto.

In some embodiments, the structure of the optical element can also be located inside the body of the adhesive layer, but the disclosed embodiments are not limited thereto.

In one embodiment, a semiconductor laser is provided, which includes a semiconductor stack, a first electrode structure, a first insulating layer, a substrate, and a second electrode structure.

In some embodiments, the semiconductor laser further includes a transparent conductive layer, a current limiting layer, and an insulating layer. The transparent conductive layer is stacked between the semiconductor stack and the first electrode structure. The current limiting layer is stacked between the transparent conductive layer and the semiconductor stack, and the current limiting layer is transparent. The semiconductor stack of the semiconductor laser includes a first-type semiconductor layer, a second-type semiconductor layer, an active layer, and a current limiting layer. The active layer is stacked between the first-type semiconductor layer and the second-type semiconductor layer. The current limiting layer is stacked between the first-type semiconductor layer and the active layer. The current limiting layer includes a current conducting region and a current limiting region. The current limiting layer located on the first-type semiconductor layer has a conduction opening, wherein the location of the conduction opening corresponds to the current conducting region. The transparent conductive layer is on the current limiting layer and in the conduction opening and contacts the first-type semiconductor layer. The insulating layer is on the transparent conductive layer and has an insulating opening, wherein the insulating opening does not overlap with the conduction opening. The first electrode layer is on the insulating layer and in the insulating opening and contacts the transparent conductive layer to electrically connect to the first-type semiconductor layer. The second electrode layer is located below the second-type semiconductor layer and electrically connected to the second-type semiconductor layer.

In some embodiments, the transparent conductive layer is formed on the current limiting layer and in the conduction opening. The transparent conductive layer located in the conduction opening has a first thickness, and the transparent conductive layer not located in the conduction opening has a second thickness, wherein the first thickness is greater than the second thickness.

In some embodiments, the transparent conductive layer of the semiconductor laser has an upper surface and a lower surface, the lower surface being opposite to the upper surface, and the upper surface being planar, while the lower surface has a downwardly protruding surface in the conduction opening.

In some embodiments, the location of the current conducting region corresponds to the location of the conduction opening.

In some embodiments, the current conducting region has a conduction width, and the conduction opening has an opening width, wherein the conduction width is greater than the opening width.

In some embodiments, the transparent conductive layer of the semiconductor laser is formed on the current limiting layer and has a first recessed region, the first recessed region being located above the conduction opening. The transparent conductive layer located in the first recessed region has a first thickness, and the transparent conductive layer not located in the first recessed region has a second thickness, wherein the first thickness is equal to or close to the second thickness. In one embodiment, the transparent conductive layer is conformally formed on the current limiting layer.

In some embodiments, the insulating layer of the semiconductor laser is formed on the transparent conductive layer and has a second recessed region, the second recessed region being located above the first recessed region. The insulating layer located in the second recessed region has a third thickness, and the insulating layer not located in the second recessed region has a fourth thickness, wherein the third thickness is equal to or close to the fourth thickness. In some embodiments, the insulating layer is conformally formed on the transparent conductive layer.

In some embodiments, the first-type semiconductor layer of the semiconductor laser further includes a doped region, wherein in the embodiment, the location of the doped region corresponds to the region above the current conducting region but does not overlap with the center position of the current conducting region.

In some embodiments, the transparent conductive layer of the semiconductor laser includes a first transparent conductive region and a second transparent conductive region, wherein the second transparent conductive region surrounds the first transparent conductive region, and the conduction opening is located between the first transparent conductive region and the second transparent conductive region.

In some embodiments, the semiconductor laser further includes a reflective layer on the upper surface of the transparent conductive layer, and the reflective layer is located in the opening defined by the first electrode structure, and the insulating layer is distributed between the reflective layer and the first electrode structure to electrically insulate the reflective layer from the first electrode structure.

In some embodiments, the reflective layer can be, for example, a distributed Bragg reflector (DBR) structure. Furthermore, the reflective layer can be formed by alternately stacking two or more dielectric layers with different refractive indices, such as silicon oxide layers and titanium oxide layers.

In some embodiments, a width of the reflective layer is less than or equal to a width of the conduction opening.

In some embodiments, the semiconductor laser includes a semiconductor stack, a substrate, a first electrode structure, a second electrode structure, and a first insulating layer. The semiconductor stack is on the substrate. The first insulating layer is located between the semiconductor stack and the first electrode structure, and the first insulating layer has a first opening. The first electrode structure is distributed on the first insulating layer and extends into the first opening to electrically connect to the semiconductor stack. The substrate is located between the semiconductor stack and the second electrode structure, and the substrate is conductive to allow the second electrode structure to electrically connect to the semiconductor stack. The semiconductor stack includes an upper reflector layer, a lower reflector layer, and an active layer, wherein the active layer is located between the upper reflector layer and the lower reflector layer. In the embodiment, the lower reflector layer is a second-type semiconductor layer and has a distributed Bragg reflector (DBR) structure. The upper reflector layer includes a first upper reflector layer and a second upper reflector layer, wherein the first upper reflector layer is located between the active layer and the second upper reflector layer, and the second upper reflector layer is located between the first upper reflector layer and the first electrode structure. The first upper reflector layer is a first-type semiconductor layer and has a distributed Bragg reflector (DBR) structure. The second upper reflector layer includes an intermediate reflective region and a current path region, wherein the current path region is on both sides of the intermediate reflective region, and the first electrode structure electrically connects to the current path region of the second upper reflector layer through the first opening of the first insulating layer.

In some embodiments, the upper reflector layer has a distributed Bragg reflector (DBR) structure, wherein the DBR structure located in the current path region has doping or a relatively higher doping concentration (compared to the intermediate reflective region).

In some embodiments, the semiconductor stack further includes a current limiting layer located between the active layer and the upper reflector layer. The current limiting layer includes a current limiting region and a current conducting region, and the current conducting region is surrounded by the current limiting region. The current conducting region surrounded by the current limiting region has a first distribution width.

In some embodiments, the first electrode structure defines an electrode opening located on the first insulating layer, and the location of the electrode opening corresponds to the location of the current conducting region. The electrode opening has an opening width. The intermediate reflective region between the two side current path regions has a second distribution width, and the location of the intermediate reflective region corresponds to the location of the current conducting region.

In some embodiments, the opening width of the first electrode structure is less than or equal to the second distribution width of the intermediate reflective region.

In some embodiments, the opening width of the first electrode structure is greater than or equal to the first distribution width of the current conducting region.

In some embodiments, the opening width of the first electrode structure is greater than or equal to the second distribution width of the intermediate reflective region, and the second distribution width is greater than or equal to the first distribution width of the current conducting region.

### BRIEF DESCRIPTION OF THE DRAWINGS

The drawings are used to better understand the embodiments of the present disclosure and do not constitute an improper limitation on the embodiments of the present disclosure, wherein:
FIG. 1A is a schematic sectional view of an epitaxial layer structure of a vertical cavity surface emitting laser (VCSEL);
FIG. 1B is a schematic sectional view of a VCSEL element;
FIG. 2 is a schematic sectional view of a semiconductor laser according to at least one embodiment of the present disclosure;
FIG. 3 is a schematic sectional view of a semiconductor laser according to at least one embodiment of the present disclosure;
FIG. 4 is a schematic sectional view of a semiconductor laser according to at least one embodiment of the present disclosure;
FIG. 5 is a schematic sectional view of a semiconductor laser according to at least one embodiment of the present disclosure;
FIG. 6 is a schematic sectional view of a semiconductor laser according to at least one embodiment of the present disclosure;
FIG. 7A is a schematic sectional view of a packaging structure according to at least one embodiment of the present disclosure;
FIG. 7B is another schematic sectional view of a packaging structure according to at least one embodiment of the present disclosure;
FIG. 7C is another schematic sectional view of a packaging structure according to at least one embodiment of the present disclosure;
FIG. 7D is another schematic sectional view of a packaging structure according to at least one embodiment of the present disclosure;
FIG. 7E is a schematic sectional view of a packaging structure according to at least one embodiment of the present disclosure;
FIG. 8 is a schematic sectional view of a semiconductor laser according to at least one embodiment of the present disclosure;
FIG. 9 is a schematic sectional view of a packaging structure according to at least one embodiment of the present disclosure;
FIG. 10 is a schematic sectional view of a semiconductor laser according to at least one embodiment of the present disclosure;
FIG. 11 is a schematic sectional view of a packaging structure according to at least one embodiment of the present disclosure;
FIG. 12A is a schematic sectional view of a semiconductor laser according to at least one embodiment of the present disclosure;
FIG. 12B is a schematic sectional view of a semiconductor laser according to at least one embodiment of the present disclosure;
FIG. 12C is a schematic sectional view of a semiconductor laser according to at least one embodiment of the present disclosure;
FIG. 13 is a schematic sectional view of a semiconductor laser according to at least one embodiment of the present disclosure;
FIG. 14A is a schematic sectional view of a semiconductor laser according to at least one embodiment of the present disclosure;
FIG. 14B is a mode schematic view of a semiconductor laser according to at least one embodiment of the present disclosure;
FIG. 15A is a schematic sectional view of a semiconductor laser according to at least one embodiment of the present disclosure;
FIG. 15B is a mode schematic view of a semiconductor laser according to at least one embodiment of the present disclosure;
FIGS. 16A and 16B are top schematic views of a light-emitting aperture of a semiconductor laser according to at least one embodiment of the present disclosure;
FIG. 17 is a schematic sectional view of a semiconductor laser according to at least one embodiment of the present disclosure;
FIG. 18A is a schematic sectional view of a semiconductor laser according to at least one embodiment of the present disclosure;
FIG. 18B is a mode schematic view of a semiconductor laser according to at least one embodiment of the present disclosure;
FIGS. 18C to 18E are top schematic views of a light-emitting aperture of a semiconductor laser according to at least one embodiment of the present disclosure;
FIG. 19 is a schematic sectional view of a semiconductor laser according to at least one embodiment of the present disclosure;
FIG. 20 is a schematic sectional view of a semiconductor laser according to at least one embodiment of the present disclosure;
FIGS. 21A to 21F are cross-sectional views schematically showing fabricating steps of the semiconductor laser according to the embodiment shown in FIG. 3;
FIGS. 22A to 22G are cross-sectional views schematically showing fabricating steps of the semiconductor laser according to the embodiment shown in FIG. 4;
FIGS. 23A to 23K are cross-sectional views schematically showing fabricating steps of the semiconductor laser according to the embodiment shown in FIG. 5;
FIGS. 24A to 24C are a schematic sectional view, a schematic bottom view, and a schematic top view, respectively, of a semiconductor laser according to at least one embodiment of the present disclosure;
FIG. 25 is a schematic sectional view of a packaging structure of a light-emitting device according to at least one embodiment of the present disclosure;
FIG. 26 is a schematic sectional view of a packaging structure of a light-emitting device according to at least one embodiment of the present disclosure;
FIG. 27 is a schematic sectional view of a packaging structure of a light-emitting device according to at least one embodiment of the present disclosure;
FIG. 28 is a schematic sectional view of a packaging structure of a light-emitting device according to at least one embodiment of the present disclosure;
FIG. 29 is a schematic sectional view of a packaging structure of a light-emitting device according to at least one embodiment of the present disclosure;
FIG. 30A is a schematic view of the light emission angle of a light-emitting device without an adjustment layer;
FIG. 30B is a schematic view of the light emission angle of a light-emitting device further including an adjustment layer according to the embodiment of FIG. 30A;
FIG. 31A is a side perspective schematic view of a packaging structure of a light-emitting and receiving device according to at least one embodiment of the present disclosure;
FIG. 31B is a top view of the packaging structure of the light-emitting and receiving device according to the embodiment of FIG. 31A;
FIG. 32 is a top view of a packaging structure of a light-emitting and receiving device according to at least one embodiment of the present disclosure;
FIG. 33 is a top view of a packaging structure according to at least one embodiment of the present disclosure;
FIG. 34 is a schematic sectional view of a packaging structure according to at least one embodiment of the present disclosure;
FIG. 35 is a schematic sectional view of a packaging structure according to at least one embodiment of the present disclosure;
FIG. 36 is a schematic sectional view of a packaging structure according to at least one embodiment of the present disclosure;
FIG. 37 is a schematic sectional view of a packaging structure according to at least one embodiment of the present disclosure;
FIG. 38 is a schematic sectional view of a packaging structure according to at least one embodiment of the present disclosure;
FIG. 39 is a schematic sectional view of a packaging structure according to at least one embodiment of the present disclosure;
FIG. 40 is a schematic sectional view of a packaging structure according to at least one embodiment of the present disclosure;
FIG. 41 is a schematic sectional view of a packaging structure according to at least one embodiment of the present disclosure;
FIG. 42 is a schematic sectional view of a packaging structure according to at least one embodiment of the present disclosure;
FIG. 43 is a schematic sectional view of a packaging structure according to at least one embodiment of the present disclosure;
FIG. 44A is a schematic sectional view of a packaging structure according to at least one embodiment of the present disclosure; and
FIG. 44B is a top view of the packaging structure of the embodiment of FIG. 44A.

### DETAILED DESCRIPTION OF DISCLOSED EMBODIMENTS

The following illustrative embodiments of the present disclosure are described in conjunction with the accompanying drawings, which include various details of the embodiments of the present disclosure to aid in understanding. They should be regarded as merely illustrative. Therefore, those skilled in the art should recognize that various changes, combinations, or adjustments can be made to the embodiments described herein without departing from the scope and spirit of the present disclosure.

The terms 'first', 'second', 'third', etc., used in the specification are used to identify and describe the corresponding features of the various embodiments and do not necessarily imply any order, hierarchy, or sequence (e.g., spatial position, temporal sequence, step sequence, etc.).

The terms 'on', 'under', 'left', 'right', 'front', 'rear', 'lower', 'higher', 'top', or 'bottom' used in the specification are used to describe the relative spatial distribution relationship of one element to another element (or one structure to another structure) in the figures. It can be understood that if the structure shown in the figures is inverted upside down, the element described on the 'under' or 'lower' side will become the element on the 'on' or 'higher' side.

When bonding a laser chip to a circuit board by a flip-chip packaging manner, if the positive electrode pad and negative electrode pad on the circuit board are too close, during the flip-chip packaging process, the applied solder may cause the positive electrode pad and negative electrode pad to be connected with each other due to solder paste overflow, resulting in a short circuit problem. If the size of the positive and negative electrode pads on the circuit board and/or the electrode pads on the laser chip element is too small, during the flip-chip packaging alignment process, the electrode pads of the laser chip may be misaligned with the electrode pads on the circuit board due to the alignment error of the alignment mechanism, resulting in short circuit problem, open circuit problem, or bad bonding problem. Therefore, to avoid the aforesaid problems, the distance between the positive electrode pad and the negative electrode pad on the circuit board needs to be greater than a specific spacing (e.g., a spacing of about 90 micrometers needs to be maintained), and the size of the electrode pads also needs to be sufficiently large (e.g., generally 80 micrometers × 50 micrometers) to provide sufficient voltage. However, this makes it difficult to significantly reduce the overall package size of the laser device after packaging.

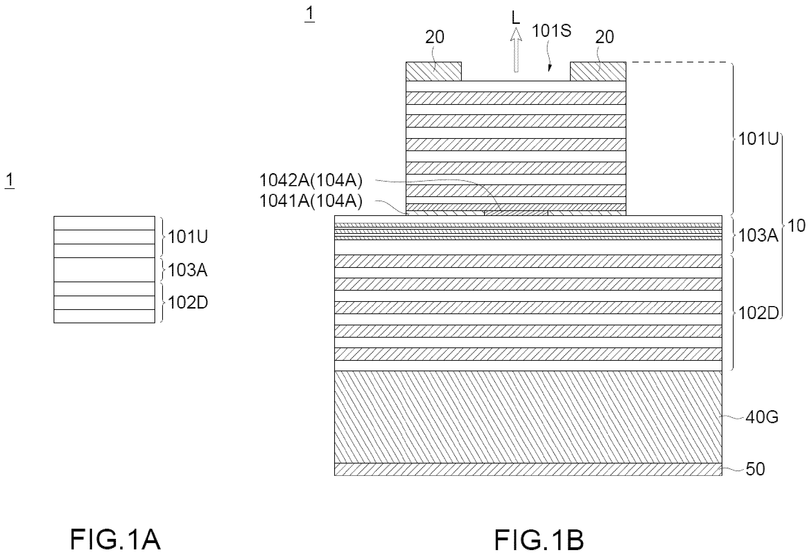

FIG. 1A is a schematic sectional view of the epitaxial layer structure of a VCSEL; FIG. 1B is a schematic sectional view of a VCSEL device. Referring to FIG. 1A, the VCSEL device 1 includes a semiconductor stack 10 formed on a conductive growth substrate 40G by semiconductor epitaxial technology, wherein the semiconductor stack 10 includes a first-type semiconductor reflecting layer 101U, a second-type semiconductor reflecting layer 102D, and an active layer 103A stacked between the first-type semiconductor reflecting layer 101U and the second-type semiconductor reflecting layer 102D.

In this disclosure, the first type and the second type refer to semiconductor structures of different conductivity types, respectively. If the semiconductor structure has holes as the majority carriers, it is a P-type semiconductor; if the semiconductor structure has electrons as the majority carriers, it is an N-type semiconductor. For example, the first-type semiconductor layer can be a P-type semiconductor, and the second-type semiconductor layer can be an N-type semiconductor, or vice versa.

Referring to FIG. 1B, the VCSEL device 1 further includes an electrode structure 20 electrically connected to the first-type semiconductor reflecting layer 101U and an electrode structure 50 electrically connected to the second-type semiconductor reflecting layer 102D. By providing a driving power through the electrode structure 20 and the electrode structure 50 to the semiconductor stack 10, carriers (electrons and holes) in the first-type semiconductor reflecting layer 101U and the second-type semiconductor reflecting layer 102D are injected into the active layer 103A, causing the active layer 103A to emit light.

The first-type semiconductor reflecting layer 101U and the second-type semiconductor reflecting layer 102D are both reflecting layers with high reflectivity. Since the active layer 103A is in the region of the resonant cavity between the first-type semiconductor reflecting layer 101U and the second-type semiconductor reflecting layer 102D, the light emitted from the active layer 103A can be reflected back and forth therein to produce coherent light. The first-type semiconductor reflecting layer 101U and the second-type semiconductor reflecting layer 102D may include a distributed Bragg reflector (DBR) structure. As shown in FIG. 1B, in the embodiment, the DBR structure can be formed by stacking two or more films with different refractive indexes, such as formed by AlAs/GaAs, AlGaAs/GaAs or InGaP/GaAs.

As shown in FIG. 1B, in the VCSEL device 1, one of the first-type semiconductor reflecting layer 101U and the second-type semiconductor reflecting layer 102D has a lower reflectivity than the other. For example, when the reflectivity of the first-type semiconductor reflecting layer 101U is lower than the reflectivity of the second-type semiconductor reflecting layer 102D, the coherent light produced between the first-type semiconductor reflecting layer 101U and the second-type semiconductor reflecting layer 102D will mostly transmit through the first-type semiconductor reflecting layer 101U to be the output light L at the surface 101S of the semiconductor stack 10.

As shown in FIG. 1B, the VCSEL device 1 further includes a current confinement layer 104A between the active layer 103A and the first-type semiconductor layer 101U. The current confinement layer 104A includes a current limiting region 1041A and a current conducting region 1042A, and the current conducting region 1042A is surrounded by the current limiting region 1041A. The conductivity of the current conducting region 1042A is greater than that of the current limiting region 1041A, so that the current is concentrated and conducted in the current conducting region 1042A.

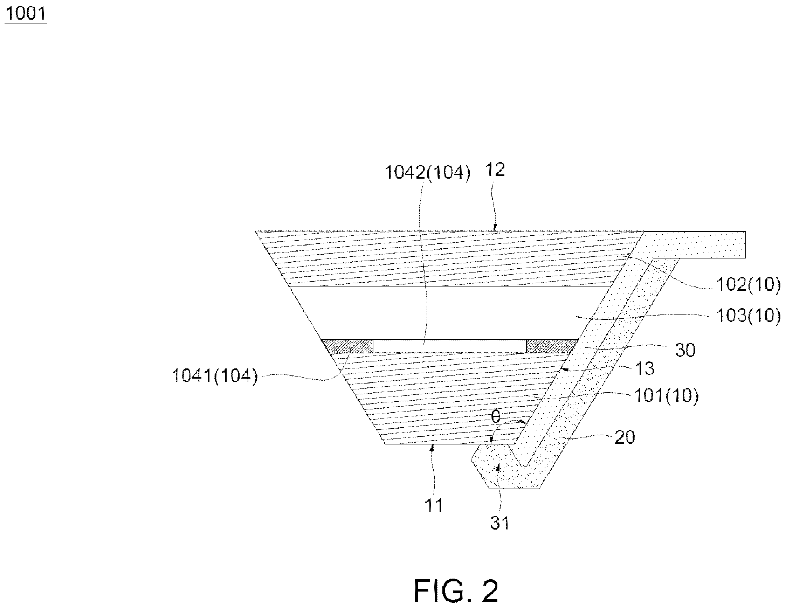

FIG. 2 is a schematic sectional view of a semiconductor laser 1001 of at least one embodiment of the present disclosure. The semiconductor laser 1001 includes a semiconductor stack 10, an electrode structure 20, and an insulating layer 30. The semiconductor stack 10 has a surface 11, a surface 12, and a side-surface 13. The surface 12 is opposite to the surface 11, and the side-surface 13 is between the surface 11 and the surface 12. The semiconductor stack 10 includes a first-type semiconductor layer 101, a second-type semiconductor layer 102, and an active layer 103. The active layer 103 is between the first-type semiconductor layer 101 and the second-type semiconductor layer 102. In the embodiment, the first-type semiconductor layer 101 is a P-type semiconductor layer, and the second-type semiconductor layer 102 is an N-type semiconductor layer, but embodiments of the present disclosure are not limited thereto.

Referring to FIG. 2, the electrode structure 20 is on the surface 11 and the side-surface 13. In the embodiment, the electrode structure 20 is on the surface 11 and extends to the side-surface 13. Therefore, when subsequently bonding the semiconductor laser 1001 to the conductive pads of a packaging substrate, since the electrode structure 20 extends to the side-surface 13, the bondable area between the electrode structure 20 of the semiconductor laser 1001 and the packaging substrate can be increased without increasing the size of the semiconductor laser 1001. In this way, when packaging the semiconductor laser 1001, the chip size can be reduced while maintaining the spacing between the conductive pads on the packaging substrate.

As shown in FIG. 2, the insulating layer 30 is between the semiconductor stack 10 and the electrode structure 20. The insulating layer 30 has an opening 31 on the surface 11, and the electrode structure 20 further extends into the opening 31 and contacts the first-type semiconductor layer 101.

As shown in FIG. 2, the side-surface 13 has an angle θ relative to the surface 11, and the angle θ ranges from 90 degrees to 120 degrees. For example, for a semiconductor stack 10 that originally has a rectangular shape with a height of 10 micrometers, if the angle θ is 120 degrees, the original chip size of 240 micrometers × 140 micrometers will be reduced to 217 micrometers × 128 micrometers through the configuration of the embodiment. For an electrode structure 20 that originally has a rectangular shape with a height of 30 micrometers, if the angle θ is 120 degrees, the original chip size of 240 micrometers × 140 micrometers will be further reduced to 171 micrometers × 105 micrometers through the configuration of the embodiment. Therefore, by arranging the electrode on the side-surface 13 of the semiconductor stack 10, the size of the packaging structure of the semiconductor laser 1001 can be reduced after packaging.

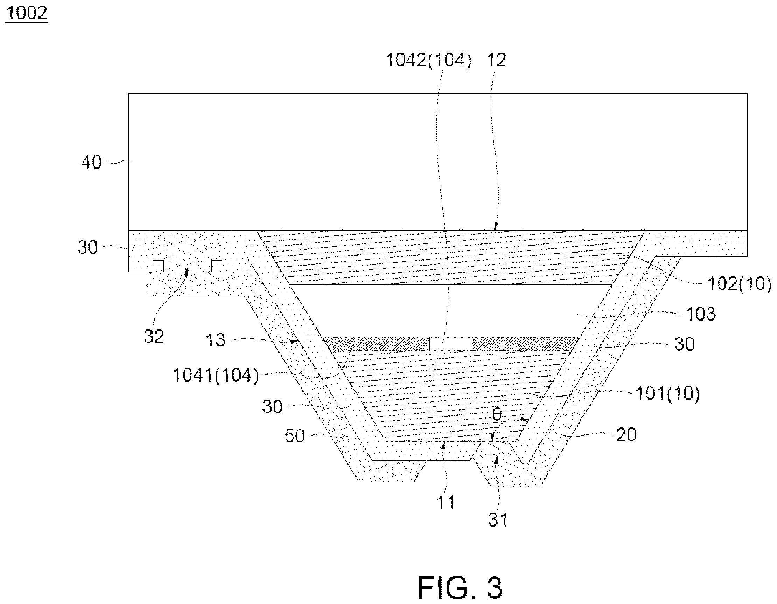

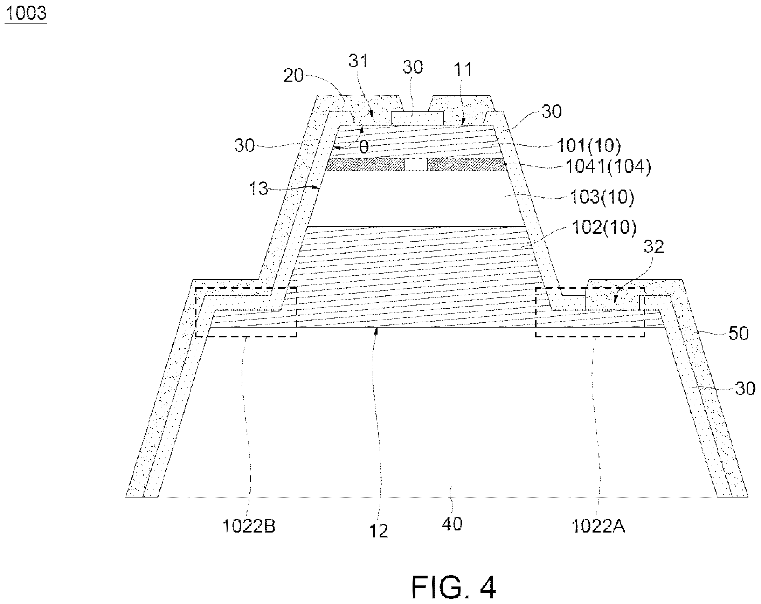

FIGS. 3 and 4 are schematic sectional views of semiconductor lasers 1002 and 1003 of at least one embodiment of the present disclosure, respectively. In these embodiments, the semiconductor stacks of the semiconductor lasers 1002 and 1003 have similar structures to the semiconductor stack 10 of the semiconductor laser 1001 in FIG. 2. The semiconductor lasers 1002 and 1003 further include a base layer 40, wherein the base layer 40 is on the second-type semiconductor layer 102 opposite to the first-type semiconductor layer 101.

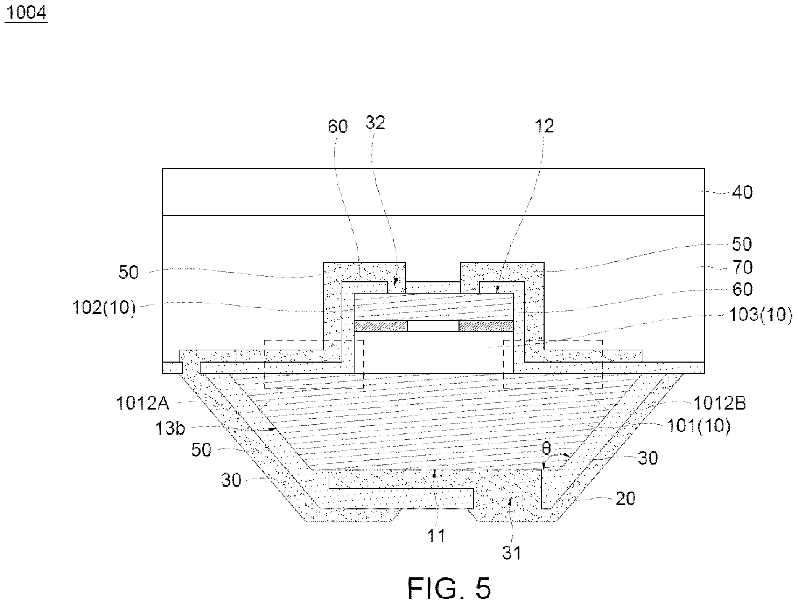

Referring to FIGS. 3 and 4, the base layer 40 can be the growth substrate of the semiconductor stack 10, that is, the semiconductor stack 10 is directly grown on the base layer 40. Or, referring to FIG. 5, the base layer 40 can also be the packaging substrate of the semiconductor stack 10, that is, the semiconductor stack 10 is grown on a growth substrate and then transferred to the base layer 40 for subsequent packaging processes.

Referring to FIGS. 3 and 4, the semiconductor lasers 1002 and 1003 further include an electrode structure 50 located on the surface 11 and the side-surface 13, and the insulating layer 30 is further located between the semiconductor stack 10 and the electrode structure 50.

In some embodiments, as shown in FIG. 3, the base layer 40 is conductive, and the electrode structure 50 and the insulating layer 30 further extend from the side-surface 13 to the base layer 40. The insulating layer 30 further has an opening 32 on the surface of the base layer 40, and the electrode structure 50 extends into the opening 32 and contacts the base layer 40, so that the electrode structure 50 is electrically connected to the second-type semiconductor layer 102 through the base layer 40. Therefore, according to the embodiment of the semiconductor laser 1002, the bondable areas between the electrode structure 20 and the electrode structure 50 of the semiconductor laser 1002 and the conductive pads of the packaging substrate can be further increased.

In some embodiments, as shown in FIG. 4, the base layer 40 is conductive or electrically insulating. The base layer 40 has a surface 41 and a side-surface 42 connected to the surface 41. The second-type semiconductor layer 102 of the semiconductor stack 10 further includes platform portions 1022A and 1022B laterally extending on the surface 41. The insulating layer 30 and the electrode structure 50 are further located on the surfaces of the platform portions 1022A and 1022B. The insulating layer 30 has an opening 32 on the platform portion 1022A, and the electrode structure 50 extends into the opening 32 and contacts the platform portion 1022A of the second-type semiconductor layer 102. In the embodiment, the electrode structure 50 is not only located in the opening 32 of the insulating layer 30 but also extends to the side-surface 42 of the base layer 40. The electrode structure 20 also extends from the side-surface 13 of the semiconductor stack 10 to the side-surface 42 of the base layer 40 via the platform portion 1022B. Therefore, according to the embodiment of the semiconductor laser 1003, the bondable areas between the electrode structures 20 and 50 of the semiconductor laser 1003 and the conductive pads of the packaging substrate can be further increased.

FIG. 5 is a schematic sectional view of a semiconductor laser 1004 according to at least one embodiment of the present disclosure. In the embodiment, the semiconductor laser 1004 further includes an insulating layer 60 and an adhesive layer 70, wherein the insulating layer 60 is located between the semiconductor stack 10 and the electrode structure 50, and the adhesive layer 70 is located between the semiconductor stack 10 and the base layer 40.

Referring to FIG. 5, in the embodiment, the electrode structure 50 is on the surface 11, the side-surface 13, and the surface 12. In the embodiment, the side-surface 13 of the semiconductor stack 10 is further divided into a first side-surface 13a (upper side-surface) and a second side-surface 13b (lower side-surface). The insulating layer 30 is located between the semiconductor stack 10 and the electrode structure 50, wherein the insulating layer 30 has plural openings 32 located on the surface 12, and the electrode structure 50 is further located in the openings 32 and contacts the second-type semiconductor layer 12. In the embodiment, the electrode structure 50 is not only located in the openings 32 of the insulating layer 30 but also located on the surface 11 of the semiconductor stack 10 and extends to the side-surface 13 and the surface 12. Furthermore, in the embodiment, the first-type semiconductor layer 101 of the semiconductor stack 10 has platform portions 1012A and 1012B laterally protruding from the first side-surface 13a. Therefore, according to the embodiment of the semiconductor laser 1004, the contact area between the electrode structure 20 and the conductive pads of the packaging substrate, as well as the contact area between the electrode structure 50 and the conductive pads of the packaging substrate, can be further increased.

Referring to FIG. 5, in the embodiment, the adhesive layer 70 and the base layer 40 are transparent, the adhesive layer 70 is on the second-type semiconductor layer 12 and covers the electrode structure 50 and the insulating layer 60, and the base layer 40 is on the adhesive layer 70.

In some embodiments, the first-type semiconductor layer 101 and the second-type semiconductor layer 102 have DBR structures, so that the light emitted from the active layer 103 can be reflected between the two reflectors to form coherent light.

Referring to FIGS. 3 to 5, in some embodiments, the semiconductor stack 10 further includes a current confinement layer 104 located between the active layer 103 and the first-type semiconductor layer 101. The current confinement layer 104 includes a current limiting region 1041 and a current conducting region 1042, and the current conducting region 1042 is surrounded by the current limiting region 1041. The conductivity of the current conducting region 1042 is higher than that of the current limiting region 1041, so that the current is concentrated and conducted in the current conducting region 1042. In some embodiments (as shown in FIG. 5), the current confinement layer can also be arranged between the active layer 103 and the second-type semiconductor layer 102; or, in the semiconductor stack 10, current confinement layers can be arranged separately between the active layer 103 and the first-type semiconductor layer 101, and between the active layer 103 and the second-type semiconductor layer 102.

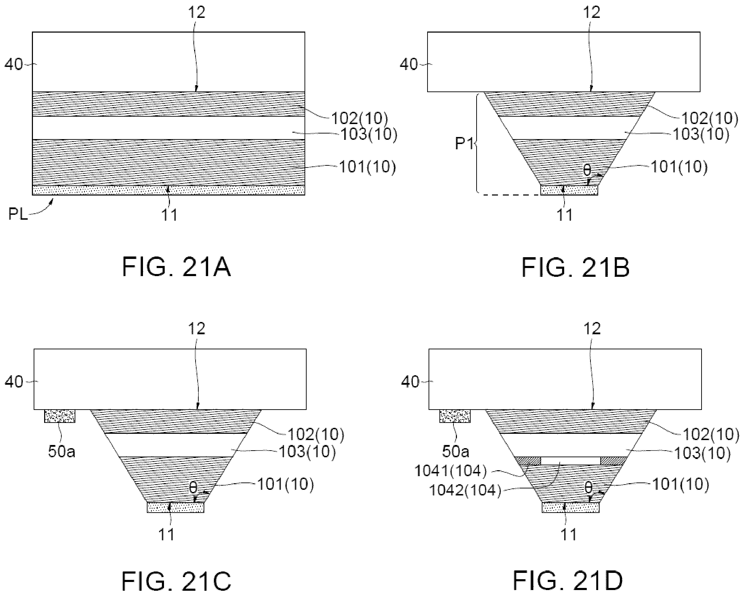

To illustrate the fabrication processes of the semiconductor lasers 1002~1004 shown in embodiments of FIGS. 3 to 5, please refer to FIGS. 21A to 21F, 22A to 22G, and 23A to 23K, respectively.

FIGS. 21A to 21F are cross-sectional views schematically showing fabricating steps of the semiconductor laser 1002 in the embodiment of FIG. 3. As shown in FIG. 21A, an epitaxial chip 2 is provided. The epitaxial chip 2 includes a semiconductor stack layer 10 formed on a base layer 40, where the semiconductor stack layer 10 sequentially includes a first-type semiconductor layer 101, an active layer 103, and a second-type semiconductor layer 102 on the base layer 40. The first-type semiconductor layer 101 and/or the second-type semiconductor layer 102 may be multi-layer structures. In the embodiment, the first-type semiconductor layer 101 is a P-type semiconductor layer, and the second-type semiconductor layer 102 is an N-type semiconductor layer. The semiconductor stack layer 10 can be epitaxially grown on the base layer 40 with epitaxial methods including, but not limited to, metal-organic chemical vapor deposition, hydride vapor phase epitaxy, molecular beam epitaxy, liquid phase epitaxy, etc. The base layer 40 includes, but is not limited to, III-V compound materials, with its lattice constant matching that of the semiconductor stack layer 10. In the embodiment, the material of the base layer 40 is gallium arsenide (GaAs). In other embodiments, the material of the base layer 40 may be indium phosphide (InP), sapphire, gallium nitride (GaN), or silicon carbide (SiC), etc...

Next, as shown in FIG. 21B, a protection layer PL is first formed to cover the first-type semiconductor layer 101 of the epitaxial chip 2, where the material(s) of the protection layer PL can be insulating material(s) including, but not limited to, silicon nitride. Then, an etching process is performed on the aforesaid chip 2, using a corresponding mask pattern to etch and remove portions of the first-type semiconductor layer 101, portions of the active layer 103, and portions of the second-type semiconductor layer 102, exposing portions of the base layer 40, thereby forming a mesa structure P1 at the side of the first-type semiconductor layer 101 and defining the side-surface 13 of the semiconductor stack layer 10.

Next, as shown in FIG. 21C, a contact portion 50a of the electrode structure 50 is formed on the base layer 40.

Next, as shown in FIG. 21D, a current confinement layer 104 is formed in the semiconductor stack layer 10. In the embodiment, the formation method of the current confinement layer 104 can be treated by an oxidation process to oxidize the predetermined region to form the current limiting region 1041. For example, the aluminum content of at least one layer of the first-type semiconductor layer 101 (defined as the layer to form the current confinement layer 104) is greater than 97% and higher than the aluminum content of the active layer 103 and the second-type semiconductor layer 102. Therefore, during the oxidation process, the high aluminum content region (defined as the predetermined region to form the current confinement layer 104) in the semiconductor stack layer 10 is oxidized from the side-surface 13 inward at a higher rate than other regions, thereby forming the current limiting region 1041 with low electrical conductivity in the current confinement layer 104. Alternatively, a current limiting region 1041 with low electrical conductivity can be formed in the semiconductor stack layer 10 through an ion implantation process, and a current conducting region 1042 can be simultaneously defined using a mask. The ion implantation can be achieved by implanting hydrogen ions, helium ions, or argon ions, etc., in the predetermined region to form the current limiting region 1041, where the ion concentration in the current limiting region 1041 is much higher than that in the current conducting region 1042, making the electrical conductivity of the current limiting region 1041 lower.

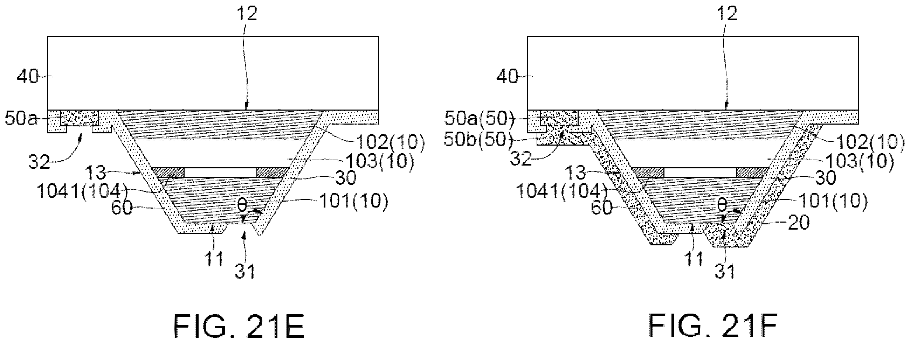

Next, as shown in FIG. 21E, an insulating layer 30 is formed to cover the side-surface 13, the top surface 11 of the semiconductor stack layer 10, and portions of the surface of the base layer 40. Furthermore, an opening 31 is formed in the insulating layer 30 to expose a portion of the first-type semiconductor layer 101. Similarly, as shown in FIG. 21E, the insulating layer 30 is further formed to cover the surface of the contact portion 50a. Furthermore, an opening 32 is formed in the insulating layer 30 to expose the contact portion 50a. From a top-view, the openings 31 and 32 can be in shape of annular, circular, elliptical, polygonal, square, or irregular, etc... In the embodiment, the shapes of the openings 31 and 32 are annular, but the disclosure is not limited thereto.

Finally, as shown in FIG. 21F, an electrode structure 20 is formed in the opening 31 and extending onto the insulating layer 30 at the location of the side-surface 13, so that the electrode structure 20 is electrically connected to the first-type semiconductor layer 101 and extends through the side-surface 13 of the semiconductor stack layer 10 to increase the distribution range of the electrode structure 20. Additionally, an extending electrode portion 50b is formed in the opening 32 and extending onto the insulating layer 30 at the location of the other side-surface 13, to form the electrode structure 50 and extend through the side-surface 13 of the semiconductor stack layer 10 to increase the distribution range of the electrode structure 50. In the embodiment, the base layer 40 is conductive, e.g., a GaAs substrate, and the electrode structure 50 is electrically connected to the second-type semiconductor layer 102 through the conductive base layer 40.

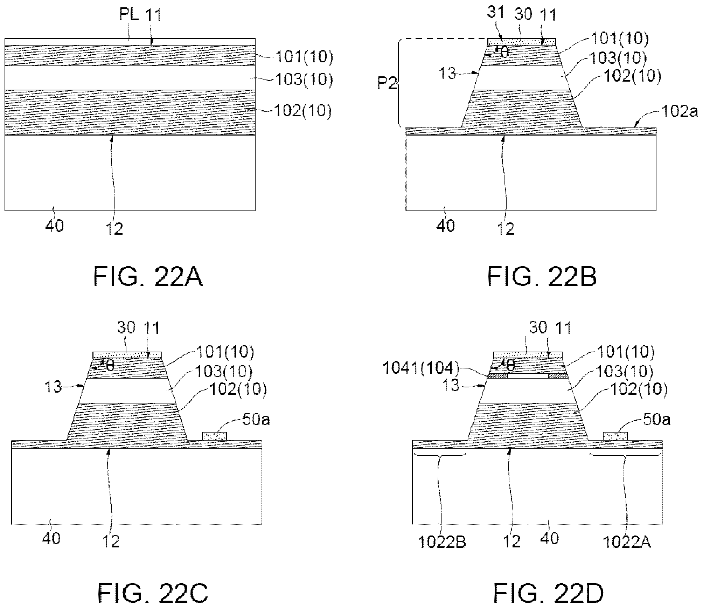

FIGS. 22A to 22G are cross-sectional views schematically showing fabricating steps of the semiconductor laser 1003 in the embodiment of FIG. 4.

As shown in FIG. 22A, an epitaxial chip 3 is provided, and a protection layer PL is formed to cover the first-type semiconductor layer 101, where the material of the protection layer PL can be an insulating material including, but not limited to, silicon nitride. The epitaxial chip 3 includes a semiconductor stack layer 10 formed on a base layer 40, where the semiconductor stack layer 10 sequentially includes a first-type semiconductor layer 101, an active layer 103, and a second-type semiconductor layer 102 on the base layer 40. The first-type semiconductor layer 101 and/or the second-type semiconductor layer 102 may be multi-layer structures. In the embodiment, the first-type semiconductor layer 101 is a P-type semiconductor layer, the second-type semiconductor layer 102 is an N-type semiconductor layer, and the base layer 40 is a semi-insulating GaAs substrate, but the disclosure is not limited thereto.

Next, as shown in FIG. 22B, an etching process is performed on the aforesaid epitaxial chip 3, using a corresponding mask pattern to etch and remove portions of the first-type semiconductor layer 101, portions of the active layer 103, and portions of the second-type semiconductor layer 102, exposing the end facet 102a of the second-type semiconductor layer 102, thereby forming a mesa structure P2 at the side of the first-type semiconductor layer 101 and defining the side-surface 13, the platform part 1022A, and the platform part 1022B of the semiconductor stack layer 10.

Next, as shown in FIG. 22C, a contact portion 50a of the electrode structure 50 is formed on the end facet 102a of the platform part 1022A of the second-type semiconductor layer 102, so that the contact portion 50a is electrically connected to the second-type semiconductor layer 102.

Next, as shown in FIG. 22D, a current confinement layer 104 is formed in the semiconductor stack layer 10.

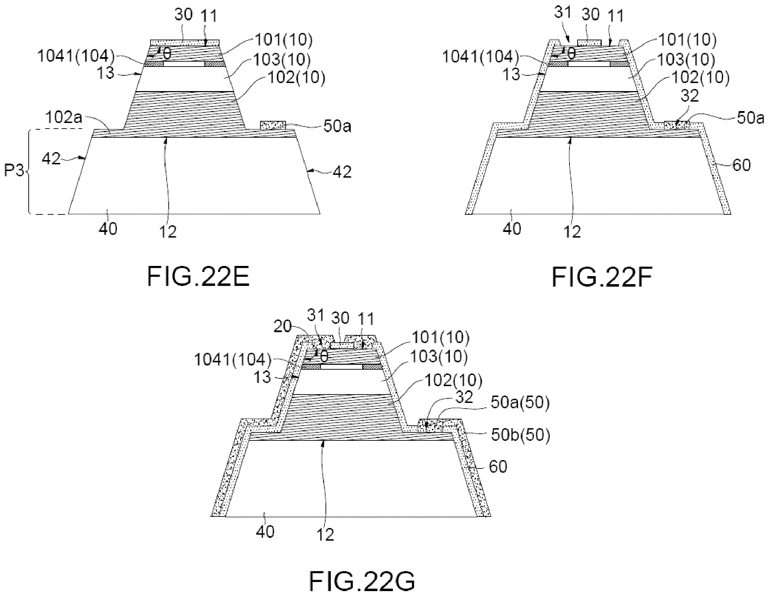

Next, as shown in FIG. 22E, an etching process is performed to the aforesaid epitaxial chip 3 from the first-type semiconductor layer 101, using a corresponding mask pattern to etch and remove portions of the platform portions 1022A, 1022B of the second-type semiconductor layer 102 and portions of the base layer 40, thereby forming a protrusive mesa P3 with the second-type semiconductor layer 102 and the base layer 40, and defining the inclined side surface 42 of the base layer 40.

Next, as shown in FIG. 22F, the insulating layer 30 is formed to cover the upper surface 11 and the side surface 13 of the semiconductor stack 10. An opening 31 is further formed in the insulating layer 30 to expose a portion of the first-type semiconductor layer 101. Similarly, as shown in FIG. 22F, the insulating layer 30 is subsequently formed to cover the end surfaces 102a of the platform portions 1022A, 1022B of the second-type semiconductor layer 102, the contact portion 50a, and the inclined side surface 42 of the substrate layer. An opening 32 is further formed in the insulating layer 30 to expose the contact portion 50a.

Next, as shown in FIG. 22G, the electrode structure 20 is formed in the opening 31, allowing the electrode structure 20 to be electrically connected to the first-type semiconductor layer 101. The electrode structure 20 is also extended to the side surface 13, the platform portion 1022B, and the side surface 42 of the base layer 40 on the insulating layer 30, thereby increasing the distribution range of the electrode structure 20. Additionally, the extended portion 50b is formed at the location of the opening 32 and extended onto the insulating layer 30 on the side surface 42 of the base layer 40. Thus, the contact portion 50a and the extended portion 50b are in contact with each other, and the distribution range of the electrode structure 50 is increased through the side surface 42 of the base layer 40.

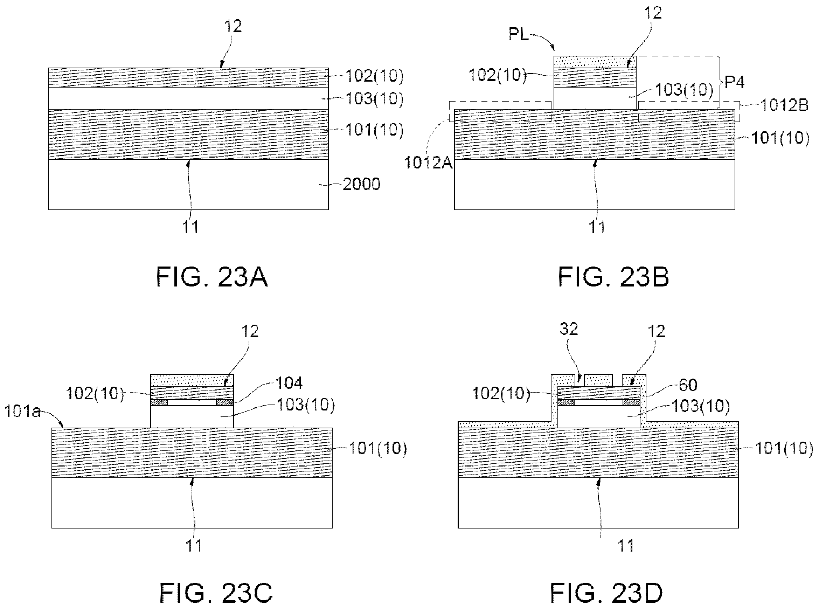

FIGS. 23A to 23K are schematic sectional views schematically illustrating fabricating steps of the semiconductor laser 1004 in the embodiment of FIG. 5.

As shown in FIG. 23A, an epitaxial chip 4 is provided. The epitaxial chip 4 includes a semiconductor stack 10 formed on a growth substrate 2000. The semiconductor stack 10 sequentially includes a first-type semiconductor layer 101, an active layer 103, and a second-type semiconductor layer 102 formed on the growth substrate 2000. The first-type semiconductor layer 101 and/or the second-type semiconductor layer 102 can be multi-layer structures. In the embodiment, the first-type semiconductor layer 101 is an N-type semiconductor layer, and the second-type semiconductor layer 102 is a P-type semiconductor layer, but the present disclosure is not limited thereto. The semiconductor stack 10 can be epitaxially grown on the growth substrate 2000. The growth substrate 2000 includes a III-V compound material, and its lattice constant matches that of the semiconductor stack 10. In the embodiment, the material of the growth substrate 2000 is gallium arsenide (GaAs), but the present disclosure is not limited thereto. In other embodiments, the material of the growth substrate 2000 can be indium phosphide (InP), sapphire, gallium nitride (GaN), or silicon carbide (SiC), among others.

Next, as shown in FIG. 23B, a protection layer PL is first formed to cover the second-type semiconductor layer 102. The material of the protection layer PL can be an insulating material including, but not limited to, silicon nitride. Then, an etching process is performed on the aforesaid epitaxial chip 4, using a corresponding mask pattern to etch and remove portions of the second-type semiconductor layer 102 and portions of the active layer 103, exposing the end facet 101a of a portion of the first-type semiconductor layer 101, thereby forming a protrusive mesa P4, a platform portion 1012A, and a platform portion 1012B of the first-type semiconductor layer 101 from the second-type semiconductor layer 102.

Next, as shown in FIG. 23C, a current confinement layer 104 is formed in the semiconductor stack 10.

Next, as shown in FIG. 23D, an insulating layer 60 is formed to cover the second-type semiconductor layer 102 and extend to cover the end facets 101a of the platform portions 1012A and 1012B of the first-type semiconductor layer 101. An opening 32 is further formed in the insulating layer 60 on the protrusive mesa P4 to expose a portion of the second-type semiconductor layer 102.

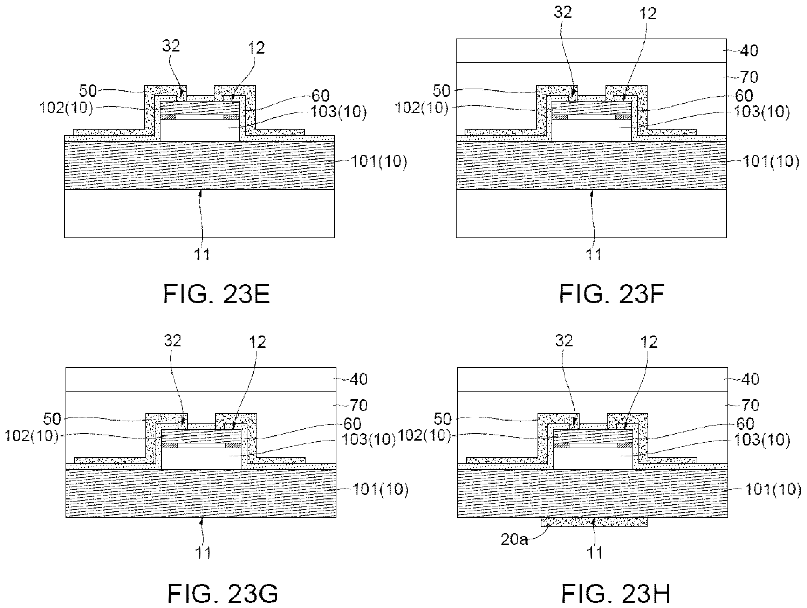

Next, as shown in FIG. 23E, the electrode structure 50 is formed in the opening 32 and extended to cover the side edge of the protrusive mesa P4 and the insulating layer 60 on the platform portions 1012A and 1012B.

Next, as shown in FIG. 23F, the epitaxial chip 4 with the insulating layer 60 and the electrode structure 50 is bonded to the base layer 40 through an adhesive layer 70. In the embodiment, the base layer 40 includes a material with high transparency to the light emitted from the active layer 103, such as sapphire with a transparency greater than 80%. After the epitaxial chip 4 with the insulating layer 60 and the electrode structure 50 is bonded to the base layer 40, the growth substrate 2000 on the first-type semiconductor layer 101 is removed, resulting in the structure shown in FIG. 23G.

Next, as shown in FIG. 23H, a contact electrode portion 20a of the electrode structure 20 is formed on the first-type semiconductor layer 101 away from the base layer 40 (i.e., formed on the surface 11 of the semiconductor stack 10).

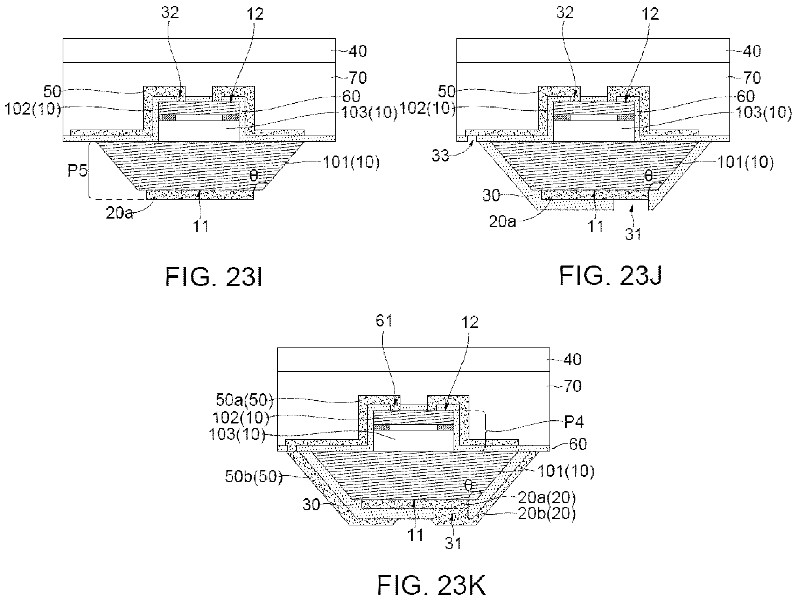

Next, as shown in FIG. 23I, an etching process is performed on the aforesaid epitaxial chip 4, using a corresponding mask pattern to etch and remove portions of the first-type semiconductor layer 101, exposing a portion of the insulating layer 60, thereby forming a protrusive mesa P5 of the first-type semiconductor layer 101 and defining the side surface 13 of the semiconductor stack 10.

Next, as shown in FIG. 23J, the insulating layer 30 is formed to cover the first-type semiconductor layer 101 and the contact electrode portion 20a. An opening 31 is further formed in the insulating layer 30 to expose the contact electrode portion 20a, and an opening 33 is formed in the insulating layer 60 to expose the electrode structure 50.

Next, as shown in FIG. 23K, an extended electrode portion 20b is formed in the opening 31 and extended to the surface of the insulating layer 30 on the side surface 13, allowing the electrode structure 20 to be electrically connected to the first-type semiconductor layer 101 and increasing the distribution range of the electrode structure 20 through the side surface 13 of the semiconductor stack 10. Additionally, an extended portion 50b is formed in the opening 33 and extended to the surface of the insulating layer 30 on the side surface 13, allowing the electrode structure 50 to extend its distribution from the second-type semiconductor layer 102 to the first-type semiconductor layer 101, and increasing the distribution area of the electrode structure 50 through the side surface 13 of the semiconductor stack 10.

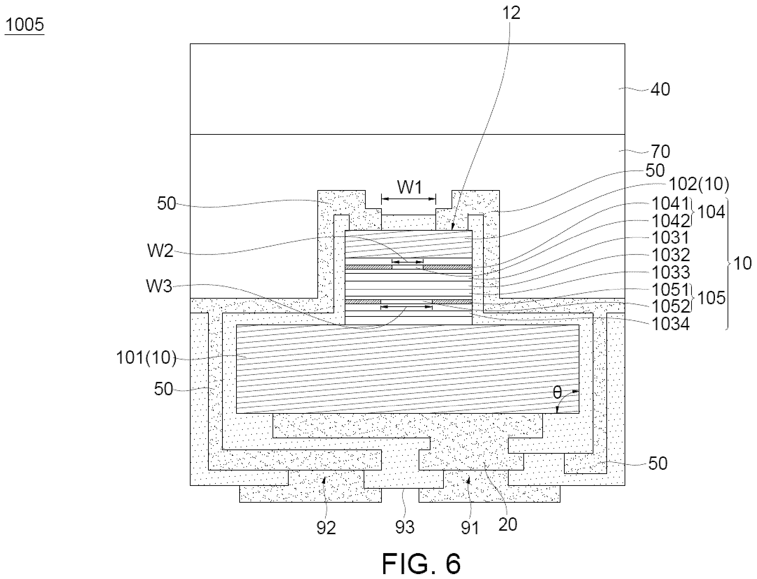

FIG. 6 is a schematic sectional view of the semiconductor laser 1005 according to at least one embodiment of the present disclosure. The structure of the semiconductor laser 1005 in the embodiment is similar to the semiconductor laser 1004 in FIG. 5. In the embodiment, the angle θ is substantially 90 degrees, but the embodiments of the present disclosure are not limited thereto. Furthermore, in the embodiment, in addition to the current confinement layer 104, the semiconductor stack 10 further includes a current confinement layer 105 located between the first-type semiconductor layer 101 and the second-type semiconductor layer 102. The current confinement layer 105 also includes a current limiting region 1051 and a current conducting region 1052, and the current conducting region 1052 is surrounded by the current limiting region 1051. In the embodiment, the active layer 103 includes a quantum well layer 1031, a quantum well layer 1034, and a spacer layer 1032. Furthermore, the active layer 103 further includes a tunnel junction layer 1033 located between the quantum well layer 1031 and the quantum well layer 1034.

Referring to FIG. 6, in the embodiment, the current confinement layer 104 is on the quantum well layer 1031, the spacer layer 1032 is located between the quantum well layer 1031 and the tunnel junction layer 1033, and the quantum well layer 1034 is located between the current confinement layer 105 and the second-type semiconductor layer 102. The tunnel junction layer 1033 includes a highly doped semiconductor layer, and the highly doped semiconductor layer is at least one of a highly doped p-type semiconductor layer and a highly doped N-type semiconductor layer. In other words, in the embodiment, the highly doped semiconductor layer can be a highly doped P-type semiconductor layer, a highly doped N-type semiconductor layer, or a mixed layer of a highly doped P-type semiconductor layer and a highly doped N-type semiconductor layer. Additionally, the material of the tunnel junction layer 1033 can be a material matched to the substrate 40. For example, if the base layer 40 uses GaAs, the tunnel junction layer 1033 can use GaAs, AlGaAs, InGaP, AlInP, AlGaInP or GaP.

In some embodiments, referring to FIG. 6, the semiconductor laser 1005 further includes a conductive connection 91, a conductive connection 92, and an insulating layer 93. The conductive connection 91 is on the side away from the base layer 40 and is connected to the electrode structure 20. The conductive connection 92 is on the side away from the base layer 40 and is connected to the electrode structure 50. The insulating layer 93 is located between the electrode structure 20 and the conductive connection 91 and the electrode structure 50 and the conductive connection 92, to avoid electrical short circuit between the electrode structure 20 and the electrode structure 50.

In some embodiments, referring to FIG. 6, the electrode structure 50 located on the surface 12 has an electrode opening 52 corresponding to the current conducting region 1042 and the current conducting region 1052, wherein the electrode opening 52 has a width W1, the current conducting region 1042 has a width W2, the current conducting region 1052 has a width W3, and the width W1 is greater than the width W2, and the width W1 is greater than or equal to the width W3. This can adjust the spatial mode distribution and emission angle of the semiconductor laser 1005.

In some embodiments, a thickness of the highly doped semiconductor layer in the tunnel junction layer 1033 is less than 100 angstroms.

In some embodiments, a thickness of the spacer layer 1032 is greater than a thickness of the quantum well layer 1031, greater than a thickness of the quantum well layer 1034, and also greater than a thickness of the tunnel junction layer 1033.

In some embodiments, a bandgap of the spacer layer 1032 is greater than a bandgap of the quantum well layer 1031 and also greater than a bandgap of the quantum well layer 1034.

In some embodiments, a bandgap of the spacer layer 1032 is greater than a bandgap of the tunnel junction layer 1033.

In one embodiment, the spacer layer 1032 includes InGaP or AlGaAsP.

According to some embodiments, the semiconductor lasers 1001~1005 can be flip-chip type VCSEL elements, and then, the semiconductor lasers 1001-1005 can be flip-chip bonded to a circuit board (e.g., a printed circuit board) or a package substrate by soldering.

According to some embodiments, the materials of the insulating layer 30, the insulating layer 60, and the insulating layer 93 include non-conductive materials. The non-conductive material can be an organic material or an inorganic material. Organic materials include epoxy photoresist (e.g., SU8), bisbenzocyclobutene (B-staged BCB), perfluorocyclobutane (PFCB), epoxy resin, acrylic resin, cyclic olefin copolymer (COC), polymethyl methacrylate (PMMA), polyethylene terephthalate (PET), polycarbonate (PC), polyetherimide, or fluorocarbon polymer. Inorganic materials include silicone or glass, aluminum oxide, silicon nitride, silicon oxide, titanium oxide, or magnesium fluoride. In some embodiments, the insulating layer 30, the insulating layer 60, and/or the insulating layer 93 include a multilayer structure (e.g., a DBR structure, formed by stacking two layers with different materials, such as silicon oxide layers and titanium oxide layers).

According to some embodiments, materials of the electrode structure 20, the electrode structure 50, the conductive connection 91, and the conductive connection 92 can include metal, such as aluminum (Al), silver (Ag), chromium (Cr), platinum (Pt), nickel (Ni), germanium (Ge), beryllium (Be), gold (Au), titanium (Ti), tungsten (W), or zinc (Zn). Materials of the electrode structure 20 and the electrode structure 50 can be metal, such as gold (Au), tin (Sn), titanium (Ti), or their alloys. The electrode structure 20 and the electrode structure 50 can have the same material and composition, or the electrode structure 20 and the electrode structure 50 can respectively be a multilayer structure with different compositions. The electrode structure 20 and the electrode structure 50 can be multilayer structures.

According to some embodiments, the electrode structure 20 and the electrode structure 50 can be multilayer structures. For example, in a direction away from the base layer 40, the electrode structure 20 and the electrode structure 50 can include, for example, a titanium (Ti)/gold (Au) layer, or a titanium (Ti)/platinum (Pt)/gold (Au) layer, or a titanium tungsten (TiW)/gold (Au) layer.

According to some embodiments, materials of the current confinement layer 104 and 105 can be III-V semiconductor materials. In the embodiment, materials of the current confinement layers 104 and 105 are AlGaAs, and materials of the quantum well layers 1031 and 1034, the first-type semiconductor layer 101, and the second-type semiconductor layer 102 all contain aluminum. The aluminum content of the current confinement layer 104 and 105 is higher than the aluminum content of the quantum well layers 1031 and 1034, the first-type semiconductor layer 101, and the second-type semiconductor layer 102. For example, the aluminum content of the current confinement layer 104 and 105 is greater than 97%. In the embodiment, the oxygen content of the current limiting regions 1041 and 1051 is higher than the oxygen content of the current conducting regions 1042 and 1052, respectively, making the conductivity of the current limiting regions 1041 and 1051 lower than the conductivity of the current conducting regions 1042 and 1052, respectively.

According to some embodiments, the adhesive layer 70 includes material(s) with high optical transmittance according to the light emitted from the quantum well layers 1031 and 1034, such as a transmittance greater than 80%. A material of the adhesive layer 70 includes an insulating material, such as cycloolefin polymer resin, epoxy resin, polyimide, spin-on glass (SOG), silicone gel, or perfluorocyclobutane.

According to some embodiments, depending on the materials, the quantum well layers 1031 and 1034 can emit infrared light with a peak wavelength between 700 nm and 1700 nm, red light with a peak wavelength between 610 nm and 700 nm, yellow light with a peak wavelength between 530 nm and 570 nm, green light with a peak wavelength between 490 nm and 550 nm, blue or deep blue light with a peak wavelength between 400 nm and 490 nm, or ultraviolet light with a peak wavelength between 250 nm and 400 nm. In the embodiment, the peak wavelength of the quantum well layers 1031 and 1034 is infrared light between 750 nm and 1200 nm.

In some embodiments, the first-type semiconductor layer 101 and the second-type semiconductor layer 102 include multiple layers with different refractive indices stacked periodically and alternately (e.g., high aluminum content AlGaAs layers and low aluminum content AlGaAs layers stacked periodically alternately) to form a DBR structure, so that the light emitted from the active layer 103 can be reflected between the two reflectors to form coherent light. Materials of the first-type semiconductor layer 101 and the second-type semiconductor layer 102 include III-V compound semiconductors, such as the AlGaInAs series, AlGaInP series, AlInGaN series, AlAsSb series, InGaAsP series, InGaAsN series, AlGaAsP series, etc., such as AlGaInP, GaAs, InGaAs, AlGaAs, GaAsP, GaP, InGaP, AlInP, GaN, InGaN, AlGaN, etc.

In the embodiments disclosed herein, unless otherwise specified, the above chemical formulas include 'stoichiometric compounds' and 'non-stoichiometric compounds', where 'stoichiometric compounds' refer to compounds where the total stoichiometric amount of group III elements is equal to the total stoichiometric amount of group V elements, and 'non-stoichiometric compounds' refer to compounds where the total stoichiometric amount of group III elements is not equal to the total stoichiometric amount of group V elements. For example, the chemical formula AlGaInAs series represents compounds containing group III elements aluminum (Al) and/or gallium (Ga) and/or indium (In), and containing the group V element arsenic (As), where the total stoichiometric amount of group III elements (aluminum and/or gallium and/or indium) can be the same as or different from the total stoichiometric amount of the group V element (arsenic).

Furthermore, if the compounds represented by the above chemical formulas are stoichiometric compounds, the AlGaInAs series represents (Aly1Ga(1-y1))1-x1Inx1As, where 0≤x1≤1, 0≤y1≤1; the AlGaInP series represents (Aly2Ga(1-y2))1-x2Inx2P, where 0≤x2≤1, 0≤y2≤1; the AlInGaN series represents (Aly3Ga(1-y3))1-x3Inx3N, where 0≤x3≤1, 0≤y3≤1; the AlAsSb series represents AlAsx4Sb(1-x4), where 0≤x4≤1; the InGaAsP series represents Inx5Ga1-x5As1-y4Py4, where 0≤x5≤1, 0≤y4≤1; the InGaAsN series represents Inx6Ga1-x6As1-y5Ny5, where 0≤x6≤1, 0≤y5≤1; and the AlGaAsP series represents Alx7Ga1-x7As1-y6Py6, where 0≤x7≤1, 0≤y6≤1.

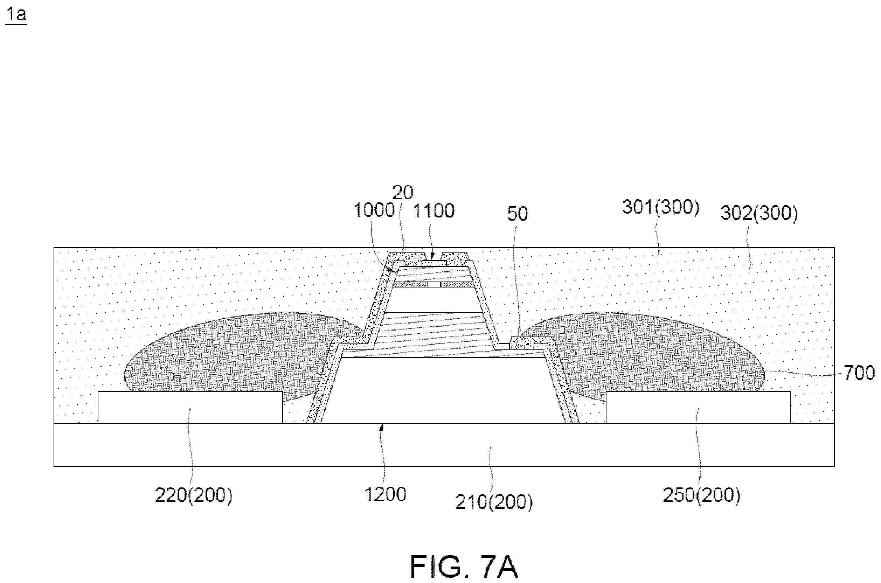

FIG. 7A is a schematic sectional view of a packaging structure 1a according to at least one embodiment of the present disclosure. In the embodiment, the packaging structure 1a includes a packaging substrate 200, a semiconductor laser 1000, and a packaging layer 300, wherein the packaging substrate 200 includes a conductive pad structure 220 and a conductive pad structure 250.

Referring to FIG. 7A and FIG. 4 together, in some embodiments, the semiconductor laser 1000 in the packaging structure 1a can be the aforesaid semiconductor laser 1003. Specifically, referring to FIG. 4, the semiconductor laser 1003 includes a semiconductor stack 10, an electrode structure 20, an insulating layer 30, a base layer 40, and an electrode structure 50.

In the embodiment, the semiconductor laser 1003 has a light-output surface 1100 and a surface 1200 opposite to the light-output surface 1100. The semiconductor laser 1003 is on the packaging substrate 200, with the surface 1200 in contact with the packaging substrate 200. The electrode structure 20 and the electrode structure 50 located on the side surface 13 of the semiconductor laser 1003 are electrically connected to the conductive pad structure 220 and the conductive pad structure 250 of the packaging substrate 200, respectively, through connection structures 700. Therefore, without increasing the width of the semiconductor laser 1003 or reducing the spacing between the conductive pad structure 220 and the conductive pad structure 250, the electrode structure 20 and the electrode structure 50 of the semiconductor laser 1003 can extend and distribute to the side surface 13 to increase the contact area with the connection structure 700, thereby avoiding poor electrical contact (e.g., electrical short circuit, electrical open circuit, etc.) between the semiconductor laser 1003 and the packaging substrate 200 in the packaging structure 1a.

Referring to FIG. 7A, the packaging layer 300 is transparent. The packaging layer 300 includes a packaging material 301 and further includes filler particles 302. Thus, by varying the distribution density or particle size of the filler particles 302 in the packaging layer 300, the light output angle (e.g., output direction, output range, etc.) or output intensity distribution of the packaging structure 1a can be varied.

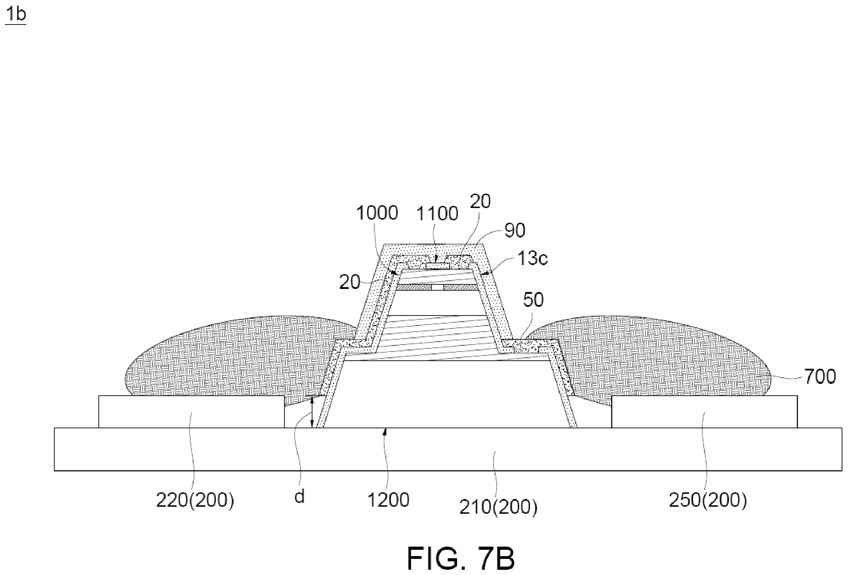

FIG. 7B is another schematic sectional view of a packaging structure 1b according to at least one embodiment of the present disclosure. The embodiment shown in FIG. 7B is similar to the embodiment shown in FIG. 7A. Referring to FIG. 7B and FIG. 4 together, the main difference is as follows: In the packaging structure 1b of the embodiment, the semiconductor laser 1003 further includes an insulating layer 90 on a side surface (the side surface 13c adjacent to the electrode structure 50), wherein the insulating layer 90 extends to the light-output surface 1100 to cover a portion of the electrode structure 20. In the way, when the electrode structure 50 of the semiconductor laser 1003 is electrically connected to the conductive pad structure 250 of the packaging substrate 200, the occurrence of an electrical short circuit due to the connection structure 700 contacting the electrode structure 20 can be avoided.

Furthermore, in the packaging structure 1b of the embodiment, the electrode structure 20 and the electrode structure 50 do not contact the packaging substrate 200. Referring to FIG. 7B, there is a gap d between the lowest ends of the electrode structure 20 and the electrode structure 50 and the upper surface of the packaging substrate 200, wherein the gap d is 30 to 50 micrometers, to avoid electrical short between the conductive structures of the packaging substrate 200 at the bottom of the semiconductor laser 1003. The semiconductor laser 1003 of the packaging structure 1b of the embodiment can also be covered with a packaging layer 300 (not shown), but the present disclosure is not limited thereto.

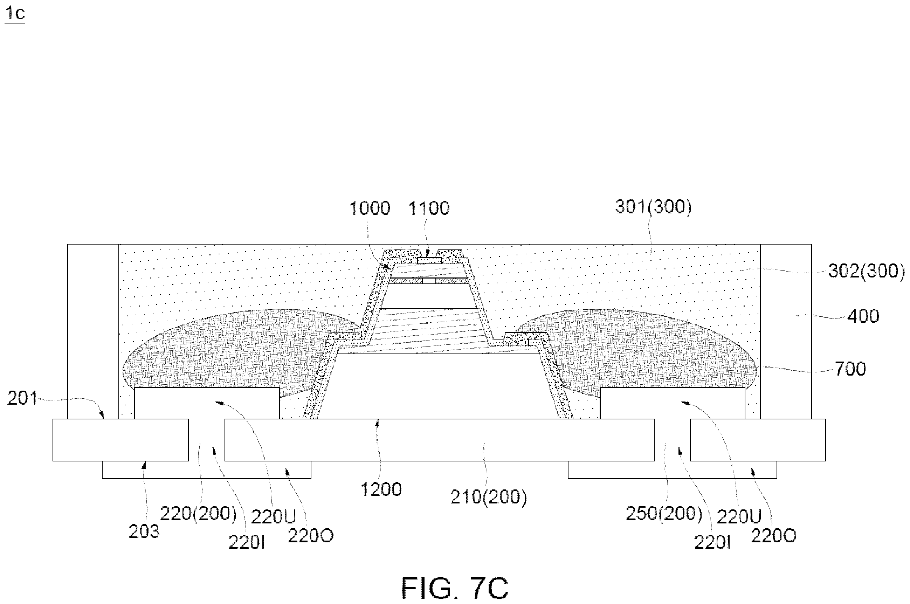

FIG. 7C is another schematic sectional view of a packaging structure 1c according to at least one embodiment of the present disclosure. The embodiment shown in FIG. 7C is similar to the embodiment shown in FIG. 7A, with the main difference being as follows: As shown in FIG. 7C, in the packaging structure 1c of the embodiment, a wall 400 is further provided on the surface 201 of a main body 210 of the packaging substrate 200, and the semiconductor laser 1003 is positioned on the surface 201 and surrounded by the wall 400. The packaging layer 300 is filled in the area surrounded by the wall 400 and covers the semiconductor laser 1003. The packaging layer 300 includes filler particles 302, by varying the distribution density or particle size of the filler particles 302 in the packaging layer 300, the light output angle (e.g., output direction, output range, etc.) or output intensity distribution of the packaging structure 1c can be varied.

Furthermore, the conductive pad structure 220 of the packaging substrate 200 includes a conductive pad portion 220U, an inner connection portion 220I, and a conductive pad portion 2200. The conductive pad structure 250 of the packaging substrate 200 includes a conductive pad portion 250U, an inner connection portion 250I, and a conductive pad portion 2500. The conductive pad portions 220U and 250U are located on the surface 201 and surrounded by the wall 400. The inner connection portions 220I and 250I are embedded in the main body 210 and connected to the conductive pad portions 220U and 250U, respectively. The conductive pad portions 220O and 250O are located on the surface 203 of the main body 210 and connected to the inner connection portions 220I and 250I, respectively. Referring to FIG. 7C, in the embodiment, since the conductive pad portions 220U and 250U are located in the area surrounded by the wall 400 and covered by the packaging layer 300, the semiconductor laser 1003 in the packaging structure 1c can be electrically connected to an external driving power through the conductive pad structure 220 and 250 via the inner connection portions 220I and 250I embedded in the main body 210 and the conductive pad portions 2200 and 2500 located on the surface 203 of the main body 210.

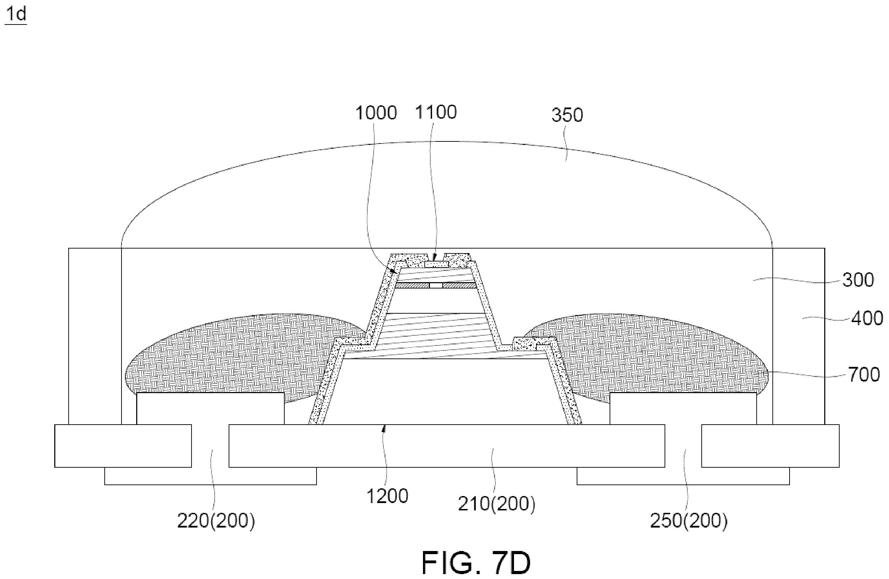

FIG. 7D is another schematic sectional view of a packaging structure 1d according to at least one embodiment of the present disclosure. The embodiment shown in FIG. 7D is similar to the embodiment shown in FIG. 7A, with the main difference being as follows: As shown in FIG. 7D, the packaging structure 1d of the embodiment further includes an adjustment layer 350 protruding on the packaging layer 300. Thus, the light output angle (e.g., output direction, output range, etc.) or output intensity distribution of the packaging structure 1d can be further varied by changing the surface shape of the adjustment layer 350. In the embodiment, the packaging layer 300 may not include filler particles 302, but the present disclosure is not limited thereto.

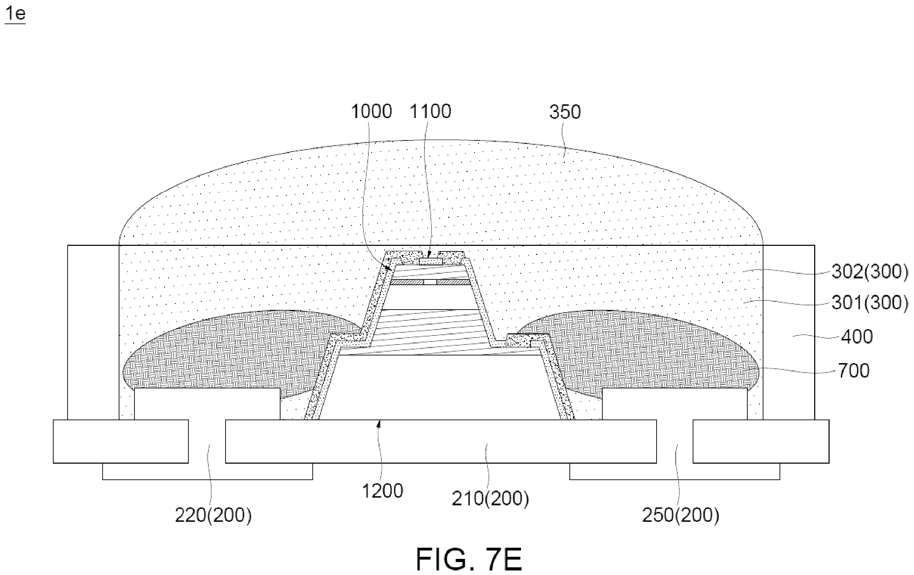

FIG. 7E is a schematic sectional view of a packaging structure 1e according to at least one embodiment of the present disclosure. The embodiment shown in FIG. 7E is similar to the embodiment shown in FIG. 7D, with the main difference being as follows: As shown in FIG. 7E, the packaging layer 300 and the adjustment layer 350 of the packaging structure 1e of the embodiment are further filled with filler particles 302. Thus, by varying the distribution density or particle size of the filler particles 302 in the packaging layer 300 and varying the surface shape of the adjustment layer 350, the light output angle (e.g., output direction, output range, etc.) or output intensity distribution of the packaging structure 1e can be varied.

In some embodiments, the adjustment layer 350 is a lens, and the upper surface of the lens can be a curved surface or a serrated surface. In some embodiments, the upper surface of the lens can be a concave surface or a convex surface.

In some embodiments, the adjustment layer 350 and the packaging layer 300 can be made of different materials, but the present disclosure is not limited thereto. In some embodiments, the adjustment layer 350 and the packaging layer 300 can also be made of same material. In some embodiments, the adjustment layer 350 can also include filler particles 302. In some embodiments, the adjustment layer 350 and the packaging layer 300 can be a one-piece structure.

In some embodiments, the semiconductor laser 1000 in the packaging structures 1a, 1c, 1d, and 1e can be replaced with the semiconductor laser 1002 shown in FIG. 3. Specifically, the semiconductor laser 1002 is arranged on the main body 210 of the packaging substrate 200 in a flip-chip manner, that is, the surface 11 of the semiconductor stack 10 of the semiconductor laser 1002 faces the main body 210, and the base layer 40 is away from the main body 210. The electrode structure 20 and the electrode structure 50 located on the side surface 13 of the semiconductor stack 10 can be electrically connected to the conductive pad structure 220 and the conductive pad structure 250 of the packaging substrate 200, respectively, through the connection structure 700. Therefore, without increasing the width of the semiconductor laser 1002 or reducing the spacing between the conductive pad structure 220 and the conductive pad structure 250, the electrode structure 20 and the electrode structure 50 of the semiconductor laser 1002 can extend and distribute to the side surface 13 to increase the contact area with the connection structure 700, thereby avoiding poor electrical contact between the semiconductor laser 1002 and the packaging substrate 200 in the packaging structure.

In some embodiments, the semiconductor laser 1000 in the packaging structures 1a, 1b, 1c, 1d, and 1e can be replaced with the semiconductor laser 1004 shown in FIG. 5. Specifically, the semiconductor laser 1004 is arranged on the main body 210 of the packaging substrate 200 in a flip-chip manner, that is, the surface 11 of the semiconductor stack 10 of the semiconductor laser 1004 faces the main body 210, and the base layer 40 is away from the main body 210. The electrode structure 20 and the electrode structure 50 located on the side surface 13 of the semiconductor stack 10 can be electrically connected to the conductive pad structure 220 and the conductive pad structure 250 of the packaging substrate 200, respectively, through the connection structure 700. Therefore, without increasing the width of the semiconductor laser 1004 or reducing the spacing between the conductive pad structure 220 and the conductive pad structure 250, the electrode structure 20 and the electrode structure 50 of the semiconductor laser 1004 can extend and distribute to the side surface 13 to increase the contact area with the connection structure 700, thereby avoiding poor electrical contact between the semiconductor laser 1004 and the packaging substrate 200 in the packaging structure.

In some embodiments, as shown in FIGS. 7A to 7E, the packaging structures 1a, 1b, 1c, 1d, and 1e, the material of the connection structure 700 includes tin (Sn).

According to some embodiments of the packaging structures 1a, 1b, 1c, 1d, and 1e, by extending the distribution of the electrode structures 20 and 30 to the side surface 13 of the semiconductor stack 10, the distribution area of the electrode structures 20 and 30 can be increased, making it easier to be electrically connected to the conductive pad structures 220 and 250 on the packaging substrate through the connection structure 700, respectively, and allowing the semiconductor laser to maintain the spacing between the conductive pad structure 220 and the conductive pad structure 250 while reducing the chip size and avoiding poor electrical contact during packaging.

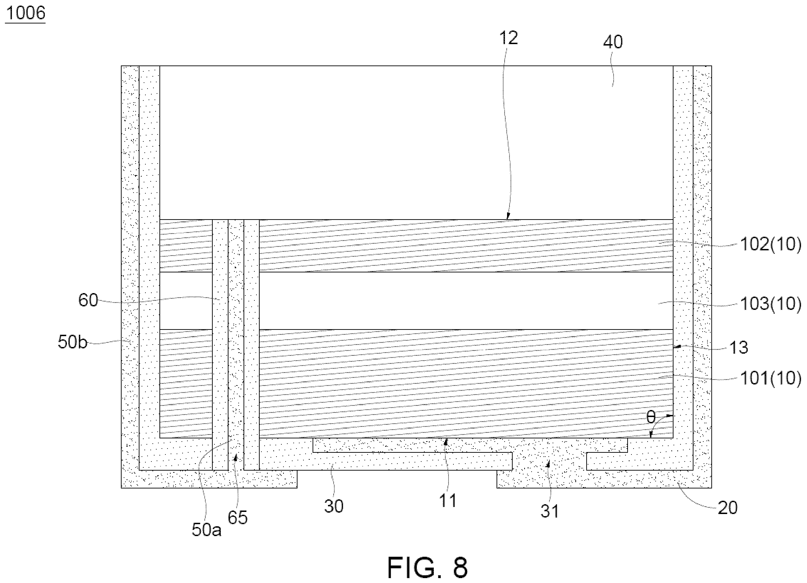

FIG. 8 is a schematic sectional view of a semiconductor laser 1006 according to at least one embodiment of the present disclosure. In the embodiment, the semiconductor laser 1006 includes a semiconductor stack 10, an electrode structure 20, an insulating layer 30, a base layer 40, an electrode structure 50, and an insulating layer 60. The base layer 40 is a conductive and transparent layer, and the electrode structure 50 includes a contact portion 50a and an extended portion 50b.

Referring to FIG. 8, the semiconductor stack 10 has a surface 11, a surface 12, and a side surface 13. The surface 12 is opposite to the surface 11, and the side surface 13 is located between the surface 11 and the surface 12. The side surface 13 forms an angle θ with respect to the surface 11. In the embodiment, the angle θ is substantially 90 degrees. The semiconductor stack 10 includes a first-type semiconductor layer 101, a second-type semiconductor layer 102, and an active layer 103, wherein the active layer 103 is between the first-type semiconductor layer 101 and the second-type semiconductor layer 102.

Referring to FIG. 8, the electrode structure 20 is on the surface 11. The insulating layer 30 is between the semiconductor stack 10 and the electrode structure 20. The insulating layer 30 has an opening 31 located on the surface 11, and the electrode structure 20 is further located in the opening 31 and contacts the first-type semiconductor layer 101. The base layer 40 is on the second-type semiconductor layer 102 opposite to the first-type semiconductor layer 101. The insulating layer 30 is further located between the semiconductor stack 10 and the electrode structure 50, as well as between the electrode structure 20 and the electrode structure 50. The insulating layer 30 has a through-hole 65 that penetrates through the semiconductor stack 10. The contact portion 50a of the electrode structure 50 is located in the through-hole 65 and contacts the base layer 40, so that the electrode structure 50 is electrically connected to the second-type semiconductor layer 102 through the base layer 40. An insulating layer 60 is located in the through-hole 65 and between the contact portion 50a and the semiconductor stack 10, to isolate the contact portion 50a from the first-type semiconductor layer 101 and from the active layer 103. The extended portion 50b of the electrode structure 50 is connected to the contact portion 50a and extends from the surface 11 to the side surface 13.

It should be noted that the embodiment illustrated in FIG. 8 can also include a current confinement layer (such as the current confinement layer 104 shown in FIG. 2), which includes a current limiting region 1041 and a current conducting region 1042 (not shown in FIG. 8).

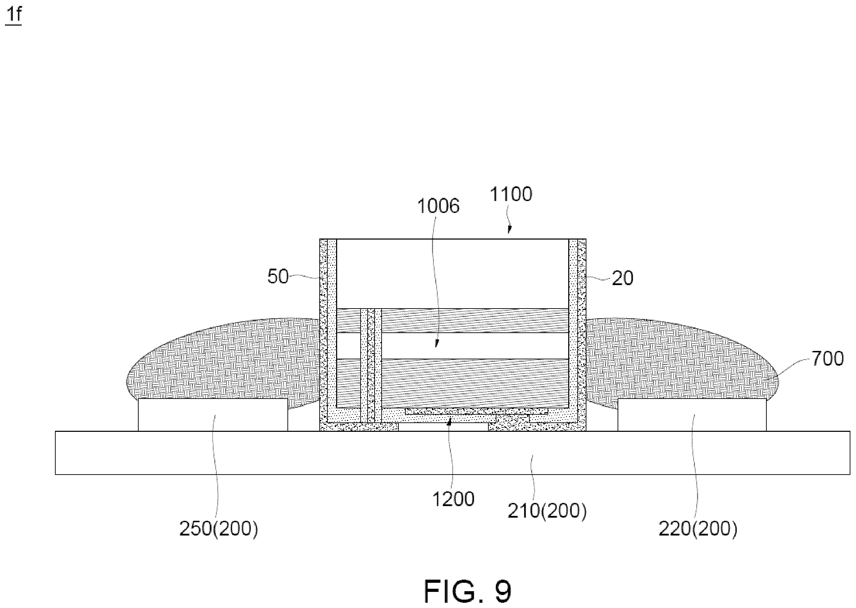

FIG. 9 is a schematic sectional view of a packaging structure according to at least one embodiment of the present disclosure. Referring to FIG. 9 and FIG. 8 together, in the embodiment, the packaging structure 1f includes a packaging substrate 200 and the semiconductor laser 1006, where the packaging substrate 200 includes a main body 210, a conductive pad structure 220, and a conductive pad structure 250.

Further referring to FIGS. 8 and 9, the semiconductor laser 1006 has a light-output surface 1100 and a surface 1200. The semiconductor laser 1006 is arranged on the main body 210 in a flip-chip manner, that is, the surface 1200 of the semiconductor laser 1006 faces the main body 210, and the base layer 40 is away from the main body 210. The electrode structure 20 and the electrode structure 50 located on the side surface 13 of the semiconductor stack 10 can be electrically connected to the conductive pad structure 220 and the conductive pad structure 250 of the packaging substrate 200, respectively, through the connection structure 700.

It should be noted that the embodiment illustrated in FIG. 9 can also include a current confinement layer (such as the current confinement layer 104 shown in FIG. 2), which includes a current limiting region 1041 and a current conducting region 1042 (not shown in FIG. 9).

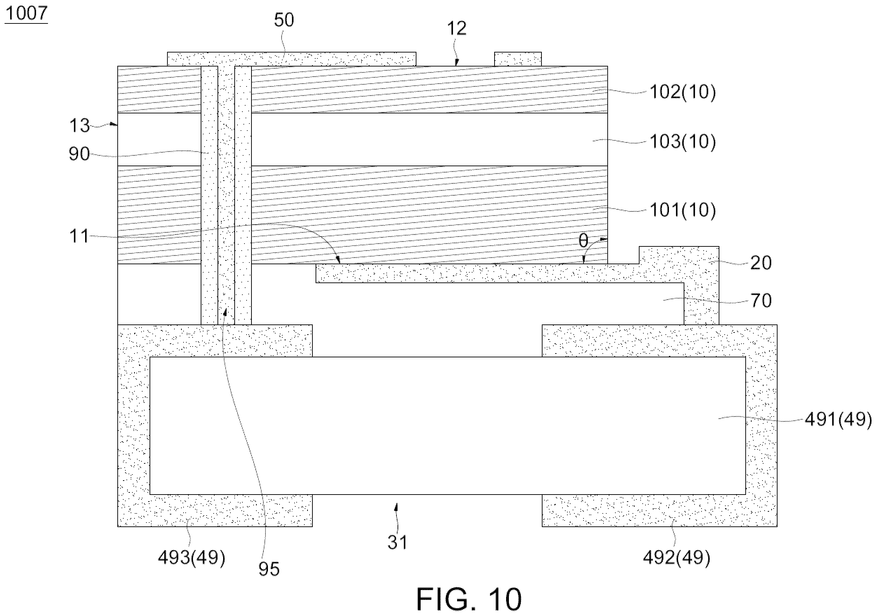

FIG. 10 is a schematic sectional view of a semiconductor laser 1007 according to at least one embodiment of the present disclosure. In the embodiment, the semiconductor laser 1007 includes a semiconductor stack 10, an electrode structure 20, an electrode structure 50, an electrode substrate 49, an adhesive layer 70, and an insulating layer 90. Furthermore, the semiconductor laser 1007 has a through-hole 95 that penetrates through the semiconductor stack 10 and the adhesive layer 70.

Referring to FIG. 10, the semiconductor stack 10 has a surface 11, a surface 12, and a side surface 13. The surface 12 is opposite to the surface 11, and the side surface 13 is between the surface 11 and the surface 12. The side surface 13 forms an angle θ with respect to the surface 11. In the embodiment, the angle θ is substantially 90 degrees. The semiconductor stack 10 includes a first-type semiconductor layer 101, a second-type semiconductor layer 102, and an active layer 103. The active layer 103 is between the first-type semiconductor layer 101 and the second-type semiconductor layer 102.

Referring to FIG. 10, the electrode structure 20 is on the surface 11 and is in electrical contact with the first-type semiconductor layer 101. The electrode structure 50 is on the surface 12 and is in electrical contact with the second-type semiconductor layer 102. The electrode substrate 49 has a body 491, an electrode unit 492, and an electrode unit 493. The body 491 is non-conductive, and the electrode unit 492 and the electrode unit 493 are respectively located on two side surfaces of the body 491 and extend to the upper and lower surfaces of the body 491, and the electrode unit 492 and the electrode unit 493 are not in contact with each other. The adhesive layer 70 is between the first-type semiconductor layer 101 and the electrode substrate 49, and the adhesive layer 70 is non-conductive. The insulating layer 90 is located within the through-hole 95 and between the semiconductor stack 10 and the electrode structure 50, so that the active layer 103, the first-type semiconductor layer 101, and the electrode structure 50 are electrically insulated. The electrode structure 50 extends from the surface 12 to inner of the through-hole 95, and electrically contacts the electrode unit 493 of the electrode substrate 49. Additionally, the electrode structure 20 is electrically connected to the electrode unit 492.

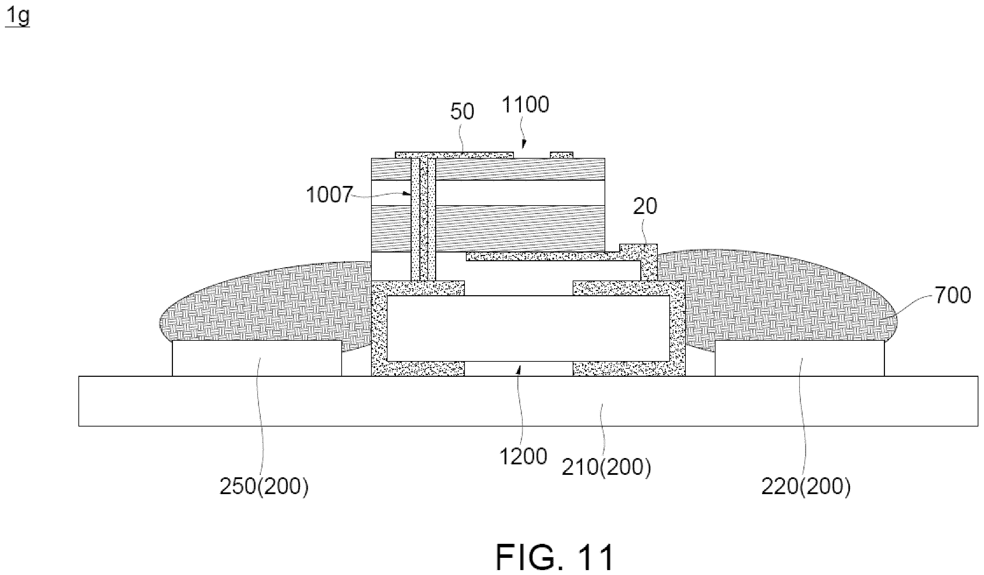

FIG. 11 is a schematic sectional view of a packaging structure according to at least one embodiment of the present disclosure. As shown in FIG. 11, the present disclosure further provides a corresponding packaging structure 1g for the aforesaid semiconductor laser 1007. In the embodiment, the packaging structure 1g includes a packaging substrate 200, the semiconductor laser 1007, and a connection structure 700, wherein the packaging substrate 200 includes a main body 210, a conductive pad structure 220, and a conductive pad structure 250.

Please refer to FIGS. 11 and 10 together, the semiconductor laser 1007 has a light-output surface 1100 and a surface 1200. The semiconductor laser 1007 is on the packaging substrate 200, with the surface 1200 of the semiconductor laser 1007 facing the packaging substrate 200, and the light-output surface 1100 being away from the packaging substrate 200. In other words, the electrode substrate 49 of the semiconductor laser 1007 is on the side closer to the main body 210, and the semiconductor stack 10 of the semiconductor laser 1007 is farther away from the main body 210. The electrode structure 20 is electrically connected to the conductive pad structure 220 of the packaging substrate 200 through the connection structure 700 and the electrode unit 492. The electrode structure 50 is electrically connected to the conductive pad structure 250 through the connection structure 700 and the electrode unit 493.

It should be noted that the semiconductor laser 1007 shown in the embodiment of FIG. 10 can also include a current confinement layer (such as the current confinement layer 104 shown in FIG. 2), which includes a current limiting region 1041 and a current conducting region 1042 (not shown in FIG. 10).

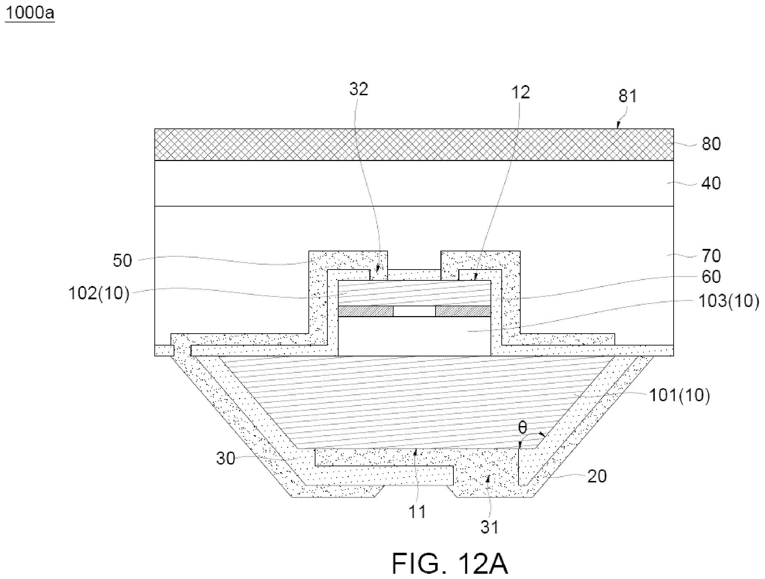

FIG. 12A is a schematic sectional view of a semiconductor laser 1000a according to at least one embodiment of the present disclosure. As shown in FIG. 12A, in the embodiment, the structure of the semiconductor laser 1000a is similar to the semiconductor lasers 1004 and 1005 shown in FIGS. 5 and 6. The semiconductor laser 1000a includes a semiconductor stack 10, an electrode structure 20, an insulating layer 30, an electrode structure 50, an insulating layer 60, an adhesive layer 70, a base layer 40, and an optical element 80.

In the embodiment, the optical element 80 is on the base layer 40. The optical element 80 has a patterned structure, such that the light outputted from the surface 12 of the semiconductor stack 10 further passes through the optical element 80 on the base layer 40, changing the propagation direction, the emission angle (e.g., emission orientation, emission range, etc.) or the intensity distribution of the light emitted from the semiconductor laser 1000a.

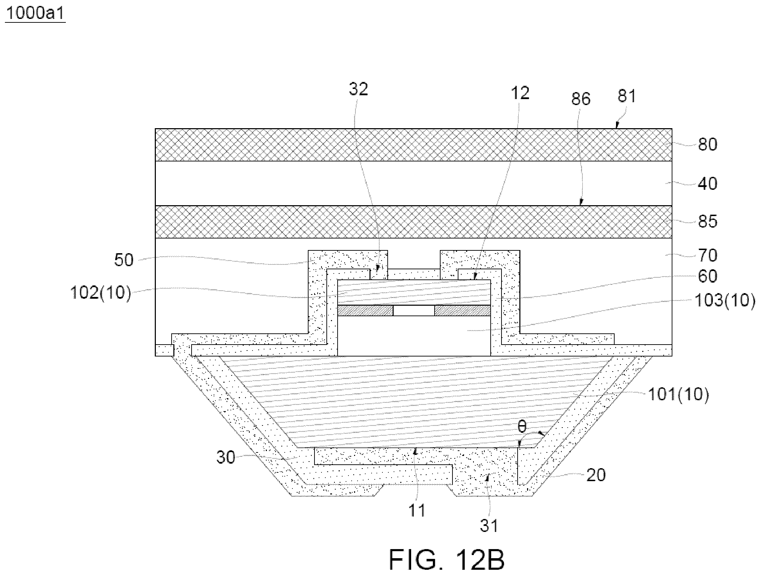

FIG. 12B is a schematic sectional view of a semiconductor laser 1000a1 according to at least one embodiment of the present disclosure. As shown in FIG. 12B, in the embodiment, the semiconductor laser 1000a1 can include optical elements 80 and 85 located at different positions on the base layer 40. For example, as shown in FIG. 12B, the optical element 80 is located above the base layer 40, and the optical element 85 is located below the base layer 40.

Please refer to the schematic views of the fabrication process in FIGS. 23E to 23F, as well as FIGS. 12A and 12B. In some embodiments, the laser chip 4 with the insulating layer 60 and the electrode structure 50 is bonded to the base layer 40 through the adhesive layer 70, wherein the base layer 40 includes the structure of the optical element 80 and/or the optical element 85. During the fabrication process of the laser chip 4, the base layer 40 with the optical elements is directly integrated and packaged with the laser chip 4. Thus, depending on different requirements for light outputting, a base layer 40 with the corresponding optical element structure can be provided, producing miniaturized semiconductor lasers with a wafer-level optical packaging structure to meet requirements of various light outputting applications.

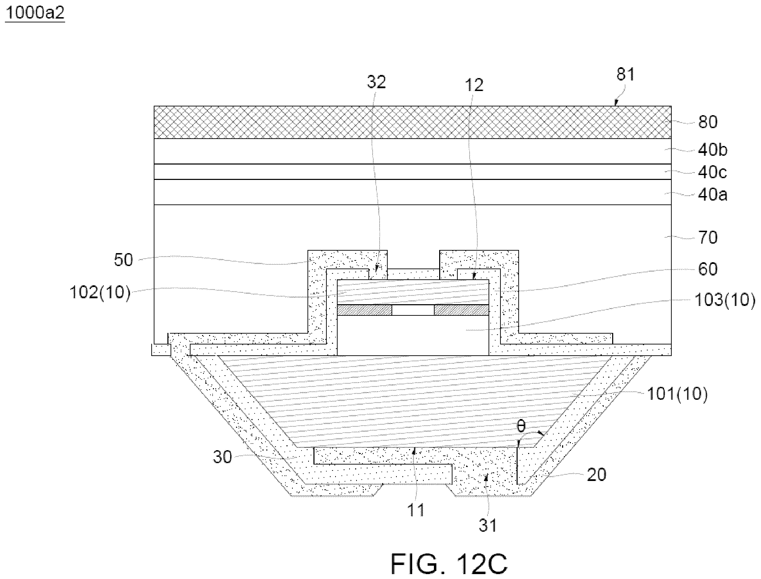

FIG. 12C is a schematic sectional view of a semiconductor laser 1000a2 according to at least one embodiment of the present disclosure. As shown in FIG. 12C, in some embodiments, the base layer 40 can include a multilayer structure. For example, the base layer 40 includes a first base layer 40a, a second base layer 40b, and an adhesive layer 40c, wherein the second base layer 40b is bonded to the first base layer 40a through the adhesive layer 40c. In the embodiment, the second base layer 40b includes an optical element 80 as mentioned previously. The optical element 80 of the second base layer 40b further changes the propagation direction of light, thereby changing the emission angle (e.g., emission orientation, emission range, etc.) or the intensity distribution of the light emitted from the semiconductor laser 1000a2.

Please also refer to the schematic views of the fabrication process in FIGS. 23F to 23K, as well as FIG. 12C. In the embodiment, during the fabrication process shown in FIG. 23F, the first base layer 40a can be bonded to the laser chip 4 first. After the process shown in FIG. 23K, the second base layer 40b with the optical element 80 can be bonded to the first base layer 40a through the adhesive layer 40c, however, the present disclosure is not limited thereto. In another embodiment (not shown), the optical element 80 of the second base layer 40b can face the first base layer 40a and be bonded to the first base layer 40a through the adhesive layer 40c.

In some embodiments, the structures of the optical elements 80 and 85 can be located at surface region of the base layer 40 or inside the body of the base layer 40.

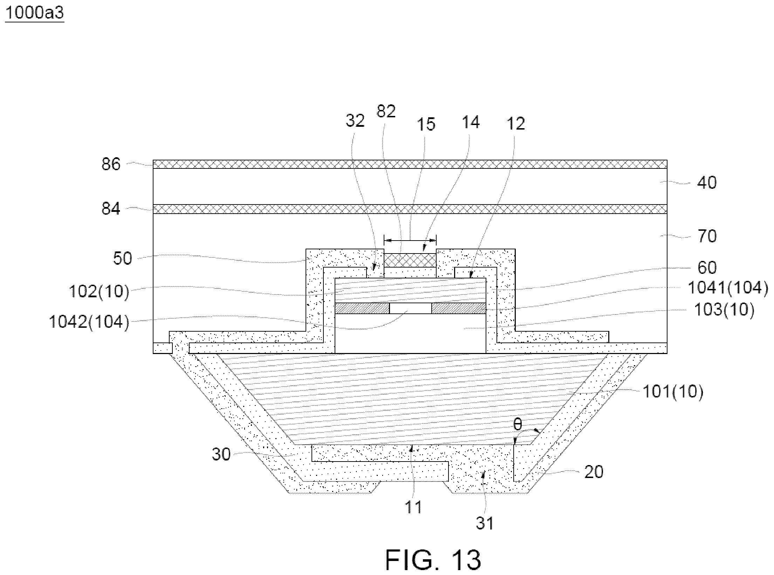

FIG. 13 is a schematic sectional view of a semiconductor laser 1000a3 according to at least one embodiment of the present disclosure. As shown in FIG. 13, in the embodiment, the structure of the semiconductor laser 1000a3 is similar to the semiconductor laser 1004 shown in FIG. 4. The semiconductor laser 1000a3 further includes an optical element 82 located on the surface 12 of the semiconductor stack 10. The optical element 82 is located in a light-outputting aperture 15, which is an opening of the electrode structure 50. The location of the light-outputting aperture 15 corresponds to the location of the current conducting region 1042 in the semiconductor stack 10.

Referring to FIG. 13, in the embodiment, the optical element 82 includes a metasurface structure, which is a nanostructure with periodic arrangements. Accordingly, the optical element 82 can be directly formed in the light-outputting aperture 15 on the surface 12 of the semiconductor stack 10 to further change the emission angle (emission direction, emission range) or the intensity distribution of the light emitted from the semiconductor laser 1000a3 through the optical element 82 on the surface 12.

In the embodiment, as shown in FIG. 13, the semiconductor laser 1000a3 further includes an optical element 84 between the adhesive layer 70 and the base layer 40 to change the propagation direction of the light incident on the base layer 40. Furthermore, an optical element 86 is on the light-outputting side of the base layer 40 to change the propagation direction of the light outputted from the base layer 40.

In the embodiment, as shown in FIG. 13, the optical element 84 is a structural layer between the insulating layer 60 and the adhesive layer 70, however, the present disclosure is not limited thereto. In some embodiments, the optical element 82 can be an interfacial structure between the insulating layer 60 and the adhesive layer 70.

In some embodiments, the optical elements 80, 82, 84, 85, and 86 can be diffraction optical element structures, microlens array structures, metasurface structures or metalenses, or a combination of the aforesaid optical element structures.

In some embodiments, the structures of the optical elements 84 and 86 can be located at the surface region of the base layer 40 or inside the body of the base layer 40.

In some embodiments, the structure of the optical element 84 can also be located inside the body of the adhesive layer 70.

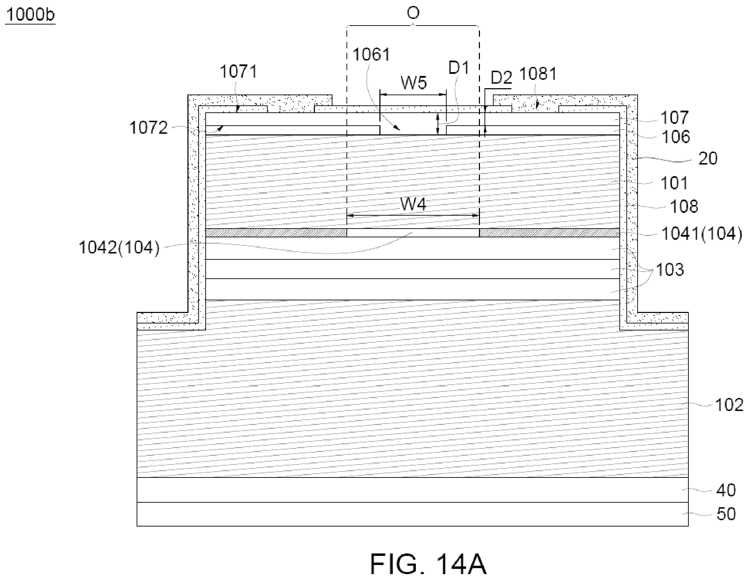

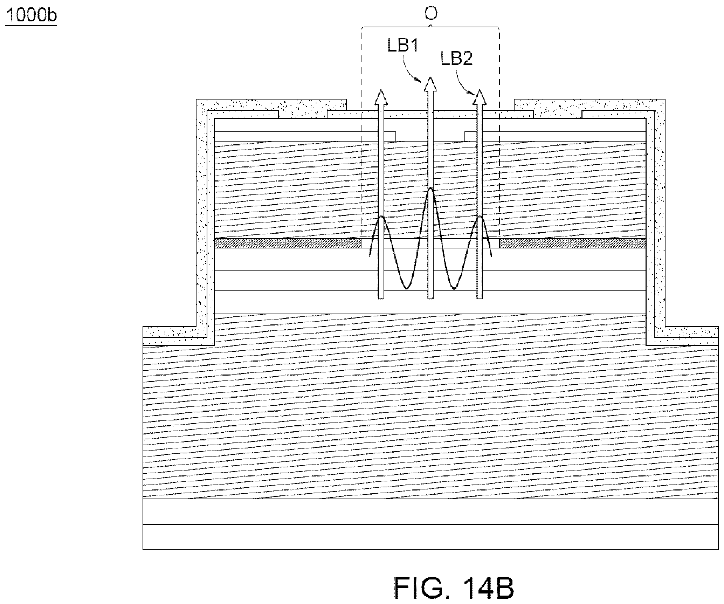

FIG. 14A is a schematic sectional view of a semiconductor laser 1000b according to at least one embodiment of the present disclosure. FIG. 14B is a schematic sectional view with schematic mode distribution of the semiconductor laser 1000b according to at least one embodiment of the present disclosure. In some embodiments, as shown in FIG. 14A, the semiconductor laser 1000b includes a semiconductor stack 10, an electrode structure 20, an insulating layer 30, a base layer 40, and an electrode structure 50, wherein the base layer 40 is a growth substrate for the semiconductor stack 10, i.e., the base layer 40 is, for example, the growth substrate for the semiconductor stack 10, but the present disclosure is not limited thereto.

Referring to FIGS. 14A and 1B together, the structure of the semiconductor laser 1000b is similar to the structure of the VCSEL device 1 shown in FIG. 1B. As shown in FIG. 14A, the semiconductor laser 1000b further includes a transparent conductive layer 107, a current limiting layer 106, and an insulating layer 108, wherein the transparent conductive layer 107 is stacked between the semiconductor stack 10 and the electrode structure 20, the current limiting layer 106 is stacked between the transparent conductive layer 107 and the semiconductor stack 10, and the current limiting layer 106 is transparent.

As shown in FIG. 14A, in the embodiment, the semiconductor stack 10 of the semiconductor laser 1000b includes a first-type semiconductor layer 101, a second-type semiconductor layer 102, an active layer 103, and a current confinement layer 104. The active layer 103 is stacked between the first-type semiconductor layer 101 and the second-type semiconductor layer 102, and the current confinement layer 104 is stacked between the first-type semiconductor layer 101 and the active layer 103. The current confinement layer 104 includes a current conducting region 1042 and a current limiting region 1041.

As shown in FIG. 14A, in the embodiment, the current limiting layer 106 located on the first-type semiconductor layer 101 has an opening 1061, wherein the location of the opening 1061 corresponds to the current conducting region 1042. The transparent conductive layer 107 is on the current limiting layer 106 and in the opening 1061, contacting the first-type semiconductor layer 101. The insulating layer 108 is on the transparent conductive layer 107 and has an opening 1081, wherein the opening 1081 does not overlap with the opening 1061. The first electrode layer 20 is on the insulating layer 108 and in the opening 1081, contacting the transparent conductive layer 107 to electrically connect to the first-type semiconductor layer 101. The second electrode layer 50 is located below the second-type semiconductor layer 102 and electrically connected to the second-type semiconductor layer 102.

As shown in FIG. 14B, for the light beam LB1 corresponding to the opening 1061 of the current limiting layer 106, it is emitted from the active layer 103, and then passes through the first-type semiconductor layer 101, the transparent conductive layer 107, and the insulating layer 108, thereby having the first emission mode (main emission mode). On the other hand, for the light beam LB2 not corresponding to the opening 1061 of the current limiting layer 106, it is emitted from the active layer 103, and then passes through the first-type semiconductor layer 101, the current limiting layer 106, the transparent conductive layer 107, and the insulating layer 108, thereby having the second emission mode (non-main emission mode). In the embodiment, to suppress the light beam LB2 with non-main emission mode, the thickness configuration of the current limiting layer 106, the transparent conductive layer 107, and the insulating layer 108 is adjusted to reduce the reflection to the light beam LB2 inside the semiconductor laser 1000b, thereby causing the light beam LB2 with the non-main emission mode to be less likely to be outputted from the semiconductor laser 1000b due to poor reflection. In other words, through this way, in the embodiment, the semiconductor laser 1000b can only output the light beam LB1 with the main emission mode, thereby reducing the emission angle of the semiconductor laser 1000b.

In some embodiments, as shown in FIG. 14A, the transparent conductive layer 107 is formed on the current limiting layer 106 and in the opening 1061. The portion of the transparent conductive layer 107 located in the opening 1061 has a first thickness D1, and the portion of the transparent conductive layer 107 not located in the opening 1061 has a second thickness D2, where the first thickness D1 is greater than the second thickness D2.

In some embodiments, the transparent conductive layer 107 of the semiconductor laser 1000b has an upper surface 1071 and a lower surface 1072, where the lower surface 1072 is relatively lower than the upper surface 1071. As shown in FIG. 14A, the upper surface 1071 is a plane, and the lower surface 1072 has a downwardly protruding surface within the opening 1061.

In some embodiments, as shown in FIG. 14A, the location of the current conducting region 1042 corresponds to the location of the opening 1061. The current conducting region 1042 has a conduction width W4, and the opening 1061 has an opening width W5, where the width W4 is greater than the width W5.

In some embodiments, the insulating layer 108 is a transparent single-layer or multi-layer structure.

In some embodiments, the transparent conductive layer 107 is a single-layer or multi-layer structure.

In some embodiments, the material of the current limiting layer 106 can be, but is not limited to, silicon nitride or silicon dioxide.

In some embodiments, the material of the transparent conductive layer 107 can be, but is not limited to, indium tin oxide (ITO) or indium zinc oxide (IZO).

In some embodiments, the material of the insulating layer 108 can be, but is not limited to, silicon nitride or silicon dioxide.

It should be noted that the current limiting layer 106 and the insulating layer 108 can be made of the same material, but they are given different names because they serve different functions in the semiconductor laser. Specifically, in the embodiment, the current path injected into the semiconductor laser 1000b does not pass through the current limiting layer 106.

Furthermore, in the embodiment, the difference between the total thickness of the current limiting layer 106, the transparent conductive layer 107, and the insulating layer 108 corresponding to the main emission mode region and the total thickness of the current limiting layer 106, the transparent conductive layer 107, and the insulating layer 108 corresponding to the non-main emission mode region is λ/4n, where λ is the wavelength of the light emitted by the semiconductor laser 1000b, and n is the refractive index.

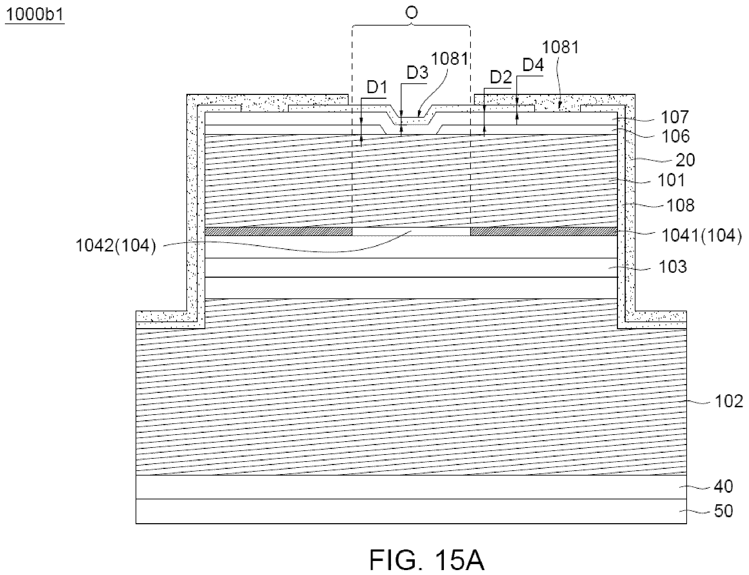

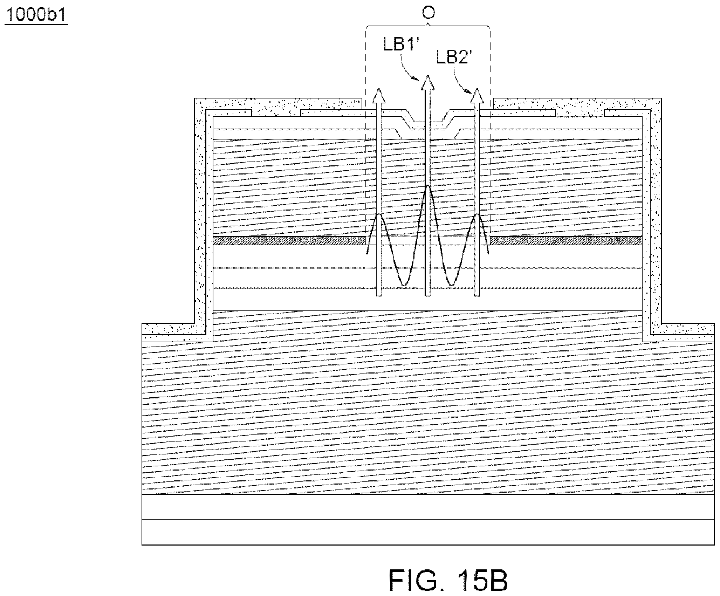

FIG. 15A is a schematic sectional view of a semiconductor laser 1000b1 according to at least one embodiment of the present disclosure. FIG. 15B is a schematic sectional view with schematic mode distribution of the semiconductor laser 1000b1 according to at least one embodiment of the present disclosure.

As shown in FIG. 15A, the transparent conductive layer 107 of the semiconductor laser 1000b1 is formed on the current limiting layer 106 and includes a first recessed region 1073. The first recessed region 1073 is located above the opening 1061. The portion of the transparent conductive layer 107 located in the first recessed region 1073 has a first thickness D1, and the portion of the transparent conductive layer 107 not located in the first recessed region 1073 has a second thickness D2. The first thickness D1 is equal to or approximately equal to the second thickness D2. In some embodiments, the transparent conductive layer 107 is conformally formed on the current limiting layer 106.

Referring to FIG. 15A, in some embodiments, the insulating layer 108 of the semiconductor laser 1000b1 is formed on the transparent conductive layer 107 and includes a second recessed region 1082. The second recessed region 1082 is located above the first recessed region 1073. The portion of the insulating layer 108 located in the second recessed region 1082 has a third thickness D3, and the portion of the insulating layer 108 not located in the second recessed region 1082 has a fourth thickness D4. The third thickness D3 is equal to or approximately equal to the fourth thickness D4. In some embodiments, the insulating layer 108 is conformally formed on the transparent conductive layer 107.

As shown in FIGS. 15A and 15B, for the light beam LB1' corresponding to the opening 1061 of the current limiting layer 106, it is emitted from the active layer 103, and then passes through the first-type semiconductor layer 101, the transparent conductive layer 107, and the insulating layer 108, thereby having the first emission mode (main emission mode). On the other hand, for the light beam LB2' not corresponding to the opening 1061 of the current limiting layer 106, it is emitted from the active layer 103, and then passes through the first-type semiconductor layer 101, the current limiting layer 106, the transparent conductive layer 107, and the insulating layer 108, thereby having the second emission mode (non-main emission mode). In the embodiment, to suppress the light beam LB2' with non-main emission mode, the thickness configuration of the current limiting layer 106, the transparent conductive layer 107, and the insulating layer 108 is adjusted to reduce the reflection to the light beam LB2' inside the semiconductor laser 1000b1, thereby causing the light beam LB2' with the non-main emission mode to be less likely to be outputted from the semiconductor laser 1000b1 due to poor reflection. In other words, through this way, in the embodiment, the semiconductor laser 1000b1 can only output the light beam LB1' with the main emission mode, thereby reducing the emission angle of the semiconductor laser 1000b1.

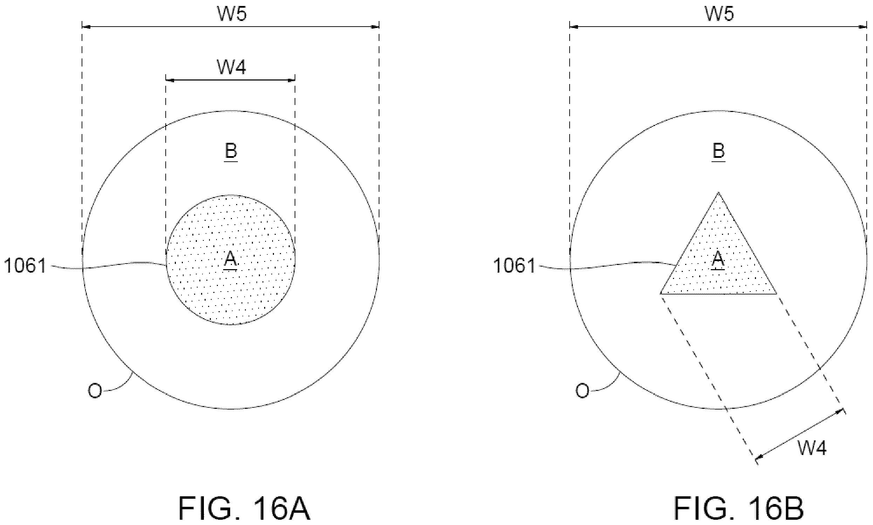

FIGS. 16A and 16B are schematic top views of the emission aperture O of a semiconductor laser (e.g., the semiconductor laser 1000b in FIG. 14A or the semiconductor laser 1000b1 in FIG. 15A) according to at least one embodiment of the present disclosure, illustrating the configuration of the opening 1061 of the emission aperture O. Referring to FIG. 16A, in the embodiment, the opening 1061 and the emission aperture O can be circular, and furthermore, the opening 1061 and the emission aperture O can be in a concentric circle configuration, but the is not limited. Referring to FIG. 16B, in the embodiment, the opening 1061 can also be a polygonal configuration, such as a triangular. Therefore, as described above, for the light with the main emission mode, it will be outputted from the position corresponding to the region A of the opening 1061, while for the light with the non-main emission mode, it will be outputted from the region B outside the opening 1061 but within the emission aperture O. Furthermore, referring to FIGS. 14A and 14B or FIGS. 15A and 15B, the structural layers that respectively passed through by the light emitted from the active layer 103 and outputted from the region A (e.g., the light beam LB1 or LB1') and by the light emitted from the active layer 103 and outputted from the region B (e.g., the light beam LB2 or LB2') are different, thereby causing the emission from region B to be suppressed or attenuated, resulting in a semiconductor laser with a smaller emission angle range mainly outputted from region A, but the present disclosure is not limited thereto.

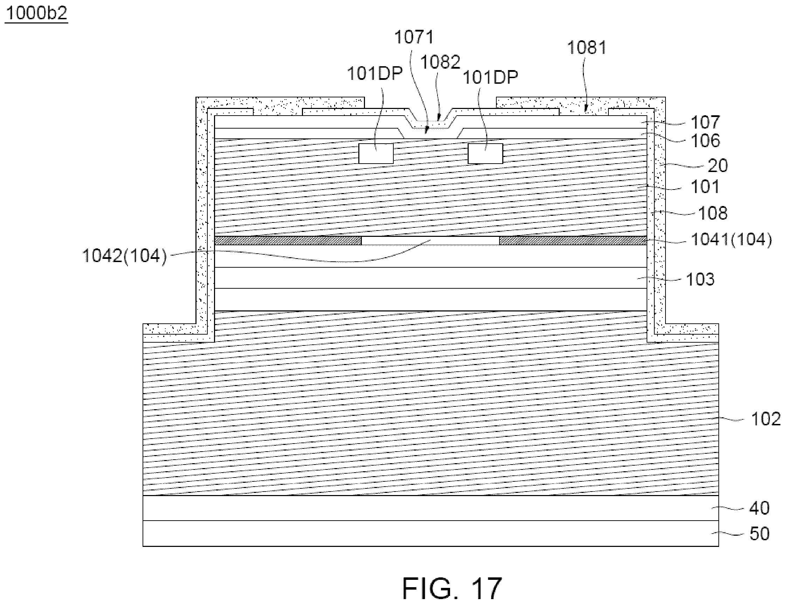

FIG. 17 is a schematic sectional view of a semiconductor laser 1000b2 according to at least one embodiment of the present disclosure. As shown in FIG. 17, the first-type semiconductor layer 101 of the semiconductor laser 1000b2 further includes a doped region 101DP. In the embodiment, the location of the doped region 101DP corresponds to the region above the current conducting region 1042 and does not overlap with the center position of the current conducting region 1042, but the present disclosure is not limited thereto.

In some embodiments, the doped region 101DP is formed by a high-temperature process, causing a diffusion material (e.g., zinc) to diffuse into a region corresponding to the current conducting region 1042 and not corresponding to the opening 1061.

For the light beam corresponding to the opening 1061 of the current limiting layer 106, it is emitted from the active layer 103, and then passes through the first-type semiconductor layer 101, the transparent conductive layer 107, and the insulating layer 108, thereby having the first emission mode (main emission mode). On the other hand, for the light beam not corresponding to the opening 1061 of the current limiting layer 106, it is emitted from the active layer 103, and then passes through the first-type semiconductor layer 101, the doped region 101DP, the current limiting layer 106, the transparent conductive layer 107, and the insulating layer 108, thereby having the second emission mode (non-main emission mode). In the embodiment, to suppress the non-main emission mode light, the configuration of the doped region 101DP, in combination with the thickness configuration of the current limiting layer 106, the transparent conductive layer 107, and the insulating layer 108, is used to reduce the reflection to the light with the non-main emission mode inside the semiconductor laser 1000b2, thereby causing the light with the non-main emission mode to be less likely to be outputted from the semiconductor laser 1000b2 due to poor reflection. In other words, through this way, in the embodiment, the semiconductor laser 1000b2 can only output light with the main emission mode, thereby reducing the emission angle of the semiconductor laser 1000b2.

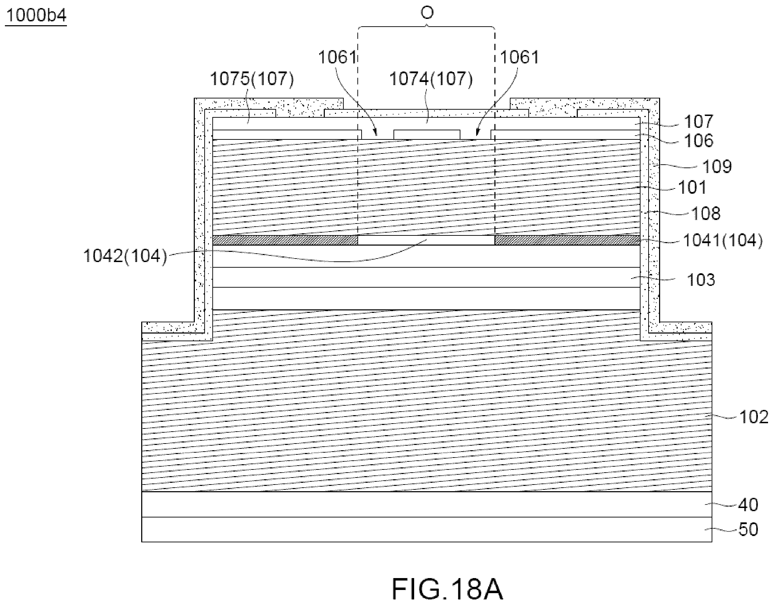

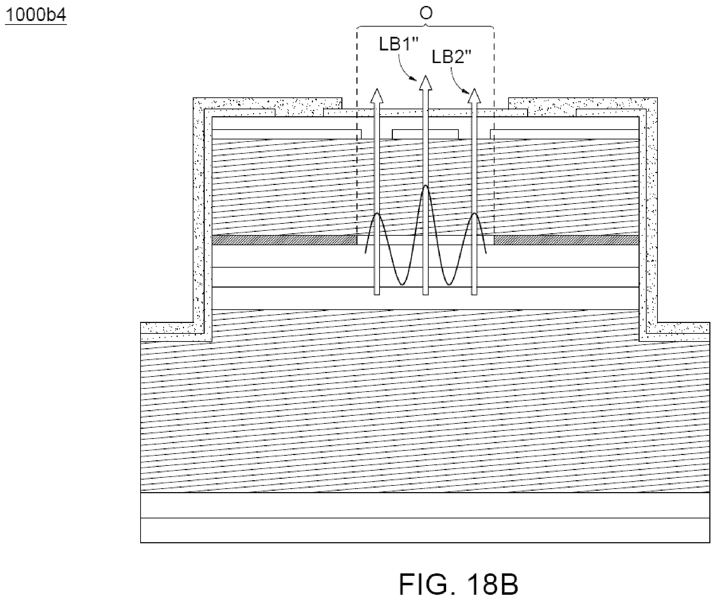

FIG. 18A is a schematic sectional view of a semiconductor laser 1000b3 according to at least one embodiment of the present disclosure. FIG. 18B is a schematic sectional view with schematic mode distribution of the semiconductor laser 1000b3 according to at least one embodiment of the present disclosure. As shown in FIG. 18A, the transparent conductive layer 107 of the semiconductor laser 1000b3 includes a first transparent conductive region 1074 and a second transparent conductive region 1075. The second transparent conductive region 1075 surrounds the first transparent conductive region 1074, and the opening 1061 is located between the first transparent conductive region 1074 and the second transparent conductive region 1075.

As shown in FIG. 18B, for the light beam LB2" corresponding to the opening 1061 of the current limiting layer 106, it is emitted from the active layer 103, and then passes through the first-type semiconductor layer 101, the transparent conductive layer 107, and the insulating layer 108, thereby having the first emission mode (main emission mode). On the other hand, for the light beam LB1" not corresponding to the opening 1061 of the current limiting layer 106, it is emitted from the active layer 103, and then passes through the first-type semiconductor layer 101, the current limiting layer 106, the transparent conductive layer 107, and the insulating layer 108, thereby having the second emission mode (non-main emission mode). In the embodiment, to suppress the light beam LB1" with non-main emission mode, the thickness configuration of the current limiting layer 106, the transparent conductive layer 107, and the insulating layer 108 is adjusted to reduce the reflection to the light beam LB1" inside the semiconductor laser 1000b3, thereby causing the light beam LB1" with the non-main emission mode to be less likely to be outputted from the semiconductor laser 1000b3 due to poor reflection. In other words, through this way, in the embodiment, the semiconductor laser 1000b3 can only output the light beam LB2" with the main emission mode, thereby reducing the emission angle of the semiconductor laser 1000b3.

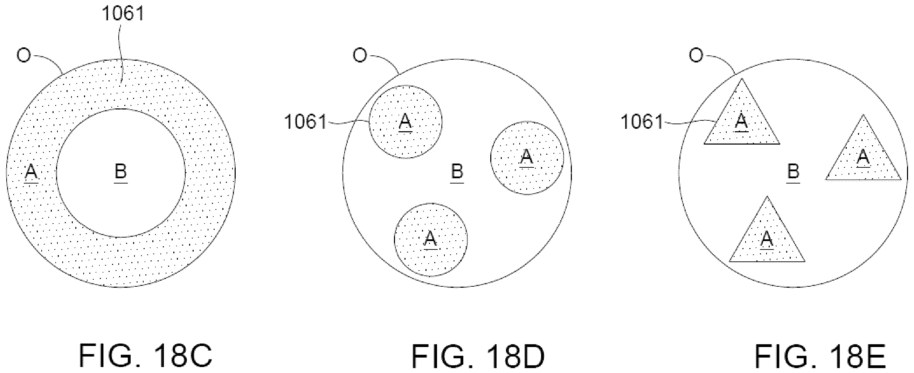

FIGS. 18C to 18E are schematic top views of the emission aperture O of the semiconductor laser 1000b3 according to at least one embodiment of the present disclosure, illustrating the configuration of the opening 1061 of the current limiting layer 106 within the emission aperture O. Referring to FIG. 18C, in the embodiment, the opening 1061 has an annular configuration, but the is not limited. Referring to FIG. 18D, in the embodiment, there can be plural circular openings 1061, and each opening 1061 is at the periphery region of the emission aperture. Further referring to FIG. 18E, in the embodiment, there can be plural triangular openings 1061, and each opening 1061 is at the periphery region of the emission aperture. Therefore, as described above, for the light with the main emission mode, it will be outputted from the region A corresponding to the opening 1061, while for the light with the non-main emission mode, it will be outputted from the region B corresponding to the first transparent conductive region 1074 within the emission aperture O. Furthermore, referring to FIGS. 18A and 18B, the structural layers that respectively passed through by the light emitted from the active layer 103 and outputted from the region A (e.g., the light beam LB2") and by the light emitted from the active layer 103 and outputted from the region B (e.g., the light beam LB1") are different, thereby causing the emission from region B to be suppressed or attenuated, resulting in a semiconductor laser with a larger emission angle range mainly outputting from region A, but the present disclosure is not limited thereto.

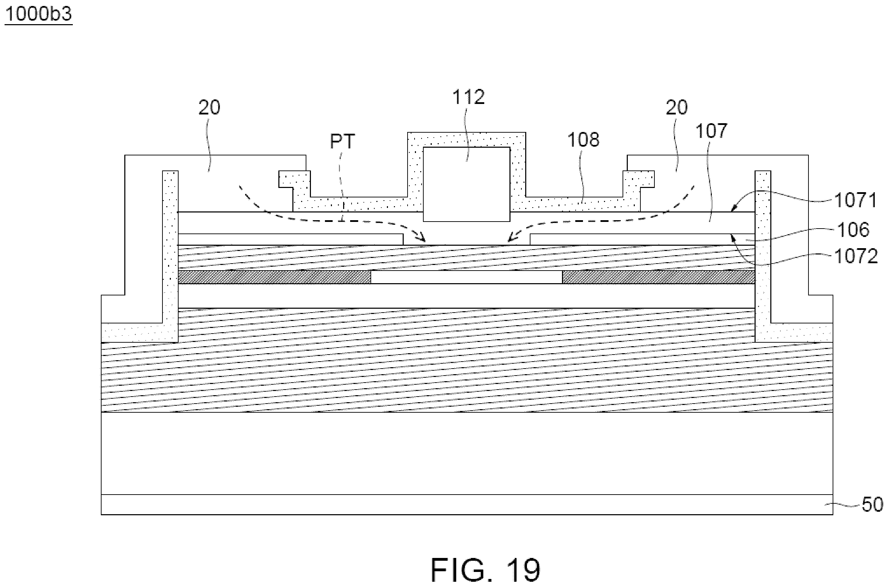

FIG. 19 is a schematic sectional view of a semiconductor laser 1000b4 according to at least one embodiment of the present disclosure. As shown in FIG. 19, the semiconductor laser 1000b4 further includes a reflective layer 112 on an upper surface 1071 of the transparent conductive layer 107, and the reflective layer 112 is located within the opening defined by the electrode structure 20, and the insulating layer 108 is distributed between the reflective layer 112 and the electrode structure 20 to electrically insulate the reflective layer 112 from the electrode structure 20.

In some embodiments, as shown in FIG. 19, the reflective layer 112 can be a DBR structure, and further, the reflective layer 112 can be formed by stacking two or more dielectric films with different refractive indices, such as alternating layers of silicon oxide and titanium oxide.

In some embodiments, as shown in FIG. 19, the current (carrier flow) injected into the first-type semiconductor layer 101 from the electrode structure 20 will mainly be injected into the active layer 103 along the shortest impedance path PT, thus reducing the number of films of the DBR reflector formed inside the first-type semiconductor layer 101, and replacing those reduced DBR films with the dielectric DBR reflective layer 112, thereby reducing the absorption of the emission from the active layer 103 by the first-type semiconductor layer 101.

In some embodiments, a width of the reflective layer 112 will be less than or equal to a width of the opening 1061.

For the outputted light corresponding to the opening 1061 of the current limiting layer 106, it is emitted from the active layer 103, and then passes through the first-type semiconductor layer 101, the transparent conductive layer 107, the reflective layer 112, and the insulating layer 108, thereby having the first emission mode (main emission mode). On the other hand, for the outputted light not corresponding to the opening 1061 of the current limiting layer 106, it is emitted from the active layer 103, and then passes through the first-type semiconductor layer 101, the current limiting layer 106, the transparent conductive layer 107, and the insulating layer 108, thereby having the second emission mode (non-main emission mode). In the embodiment, the configuration of the reflective layer 112 can increase the reflection to the light with the main emission mode inside the semiconductor laser 1000b4, and further, the thickness configuration of the current limiting layer 106, the transparent conductive layer 107, and the insulating layer 108 can reduce the reflection to the light with the non-main emission mode inside the semiconductor laser 1000b4. In other words, through this way, in the embodiment, the semiconductor laser 1000b4 can only emit light with the main emission mode, thereby reducing the emission angle of the semiconductor laser 1000b4.

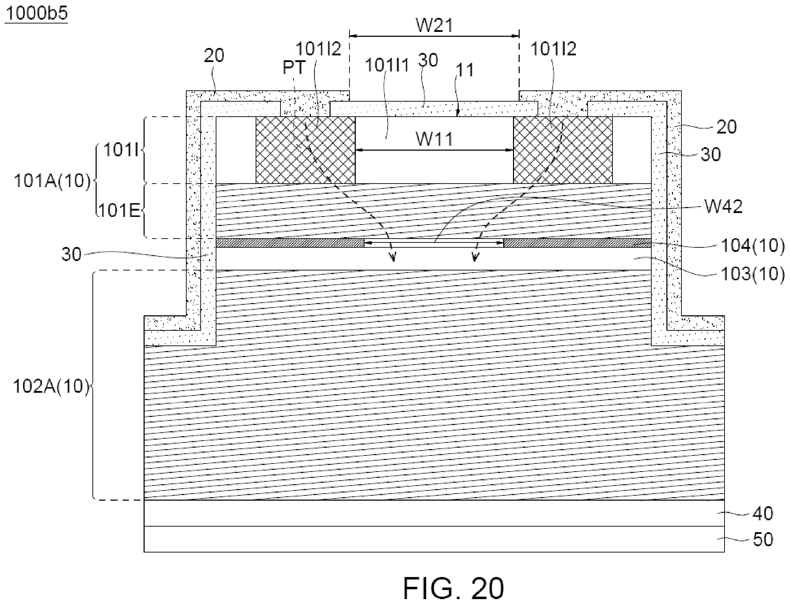

FIG. 20 is a schematic sectional view of a semiconductor laser 1000b5 according to at least one embodiment of the present disclosure. As shown in FIG. 20, the semiconductor laser 1000b5 includes a semiconductor stack 10, a base layer 40, an electrode structure 20, an electrode structure 50, and an insulating layer 30.

As shown in FIG. 20, in the embodiment, the semiconductor stack 10 is on the base layer 40, the insulating layer 30 is between the semiconductor stack 10 and the electrode structure 20, and the insulating layer 30 includes an opening 31. The electrode structure 20 is distributed on the insulating layer 30 and extends into the opening 31 to electrically connect with the semiconductor stack 10. The base layer 40 is between the semiconductor stack 10 and the electrode structure 50. In the embodiment, the base layer 40 is conductive to enable the electrode structure 50 to electrically connect with the semiconductor stack 10.

As shown in FIG. 20, in the embodiment, the semiconductor stack 10 includes an upper reflector layer 101A, a lower reflector layer 102A, and an active layer 103, where the active layer 103 is between the upper reflector layer 101A and the lower reflector layer 102A. In the embodiment, the lower reflector layer 102A is a second-type semiconductor layer and includes a DBR structure.

As shown in FIG. 20, in the embodiment, the upper reflector layer 101A includes a reflector layer 101E and a reflector layer 101I. The reflector layer 101E is between the active layer 103 and the reflector layer 101I, and the reflector layer 101I is between the reflector layer 101E and the electrode structure 20, where the reflector layer 101E is a first-type semiconductor layer and includes a DBR structure. In the embodiment, the second-type semiconductor layer is an N-type semiconductor layer, and the first-type semiconductor layer is a P-type semiconductor layer, but the embodiments of the present disclosure are not limited thereto, i.e., in another embodiment, the first-type semiconductor layer can be an N-type semiconductor layer, and the second-type semiconductor layer can be a P-type semiconductor layer.

As shown in FIG. 20, the reflector layer 101I includes an intermediate reflection region 101I1 and a current path region 101I2, where the current path region 101I2 is on both sides of the intermediate reflection region 101I1, and the electrode structure 20 is electrically connected with the current path region 101I2 of the reflector layer 101I through the opening 31 of the insulating layer 30.

As shown in FIG. 20, in the embodiment, the upper reflector layer 101A includes a DBR structure, where the DBR structure located inside the current path region 101I2 includes dopants or dopants with higher concentration (compared to the intermediate reflection region 101I1). The dopants in the current path region 101I2 can be formed through ion implantation or ion diffusion process.

As shown in FIG. 20, in the embodiment, the semiconductor stack 10 further includes a current confinement layer 104 located between the active layer 103 and the upper reflector layer 101A. The current confinement layer 104 includes a current limiting region 1041 and a current conducting region 1042, and the current conducting region 1042 is surrounded by the current limiting region 1041. The current conducting region 1042 surrounded by the current limiting region 1041 has a distribution width W42.

As shown in FIG. 20, the electrode structure 20 has an opening 21 located on the insulating layer 30, and the location of the opening 21 corresponds to the location of the current conducting region 1042. The opening 21 has an opening width W21.

As shown in FIG. 20, the intermediate reflection region 101I1 located between the current path regions 101I2 has a distribution width W11, and the location of the intermediate reflection region 101I1 corresponds to the location of the current conducting region 1042.

In some embodiments, as shown in FIG. 20, the opening width W21 of the electrode structure 20 is less than or equal to the distribution width W11 of the intermediate reflection region 101I1.

In some embodiments, as shown in FIG. 20, the opening width W21 of the electrode structure 20 is greater than or equal to the distribution width W42 of the current conducting region 1042.

In some embodiments, as shown in FIG. 20, the opening width W21 of the electrode structure 20 is greater than or equal to the distribution width W11 of the intermediate reflection region 101I1, and the distribution width W11 is greater than or equal to the distribution width W42 of the current conducting region 1042.

In some embodiments, as shown in FIG. 20, the current (carrier flow) injected into the upper reflector layer 101A from the electrode structure 20 will mostly be injected into the active layer 103 along the shortest impedance path PT. Since the DBR layers in the intermediate reflection region 101I1 do not have dopants (or the doping concentration in the intermediate reflection region 101I1 is lower compared to the reflector layer 101E), the current (carrier flow) will flow through the current path regions 101I2 in the upper reflector layer 101A, pass through the reflector layer 101E with the second-type semiconductor layer and the current conducting region 1042, and then be injected into the active layer 103. The upward emission from the active layer 103 near the current conducting region 1042 will pass through the intermediate reflection region 101I1 of the upper reflector layer 101A before being outputted from the surface 11A. Since the main emission path in the semiconductor laser 1000b5 is separated from the current (carrier flow) path, this can reduce the absorption effect of carriers in the upper reflector layer 101A on the emission from the active layer 103.

In some embodiments, referring to FIG. 20, the current path regions 101I2 in the upper reflector layer 101A can be closer to the active layer 103 to reduce the number of layers of the second-type semiconductor layer with the reflector layer 101E, thereby further reducing the absorption effect of the second-type semiconductor layer in the reflector layer 101E on the emission from the active layer 103.

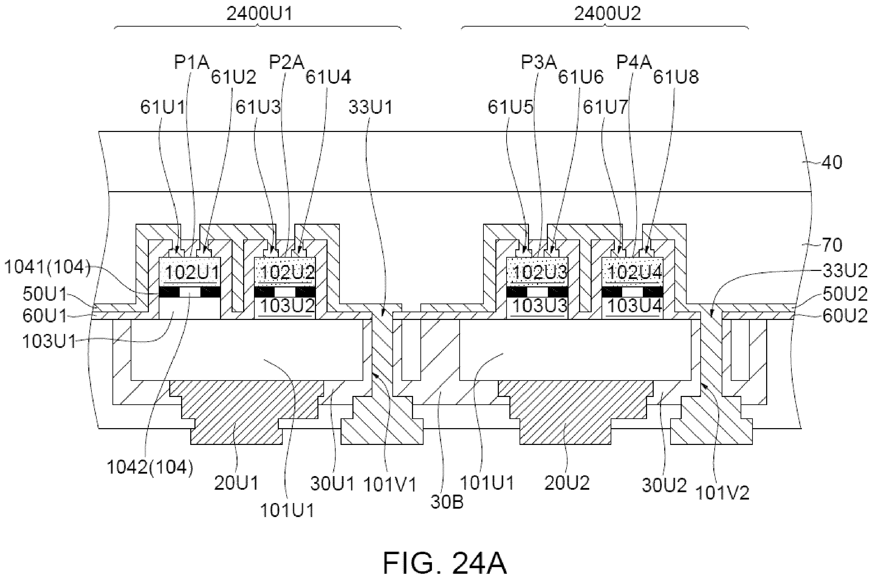

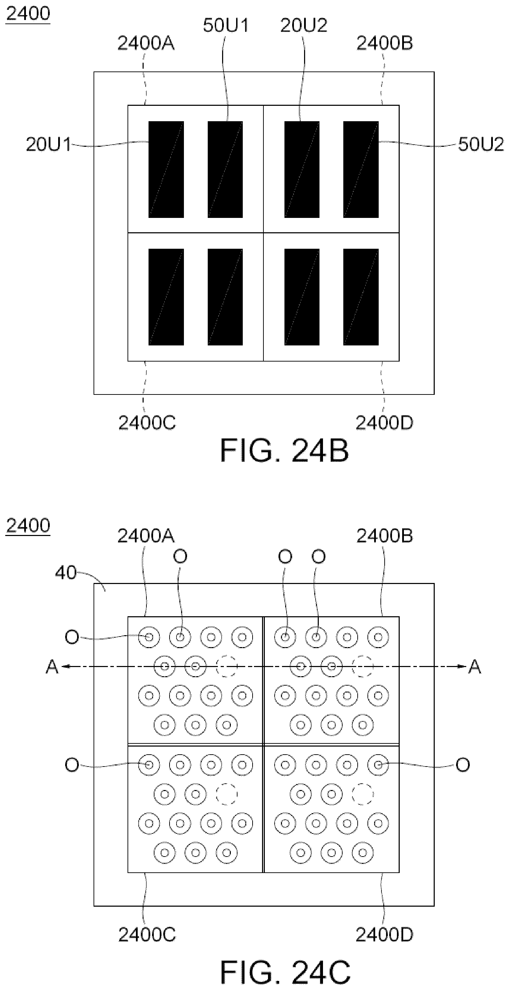

FIGS. 24A to 24C are schematic sectional views, bottom views, and top views, respectively, of a semiconductor laser 2400 according to at least one embodiment of the present disclosure. FIG. 24A shows a schematic sectional view along the line A-A' in FIG. 24C. As shown in FIG. 24A, the semiconductor laser 2400 includes plural semiconductor laser units (e.g., semiconductor laser unit 2400U1 and semiconductor laser unit 2400U2), where the semiconductor laser unit 2400U1 includes mesa structures (e.g., mesa structures P1A and P2A) on the first-type semiconductor layer 101U1, and the semiconductor laser unit 2400U2 includes mesa structures (e.g., mesa structures P3A and P4A) on the first-type semiconductor layer 101U2.

As shown in FIG. 24A, the mesa structures P1A, P2A are pillar structures protruding from a surface of the first-type semiconductor layer 101U1, and the mesa structures P3A, P4A are pillar structures protruding from a surface of the first-type semiconductor layer 101U2.

As shown in FIG. 24A, the semiconductor laser 2400 further includes a transparent base layer 40 and an adhesive layer 70, where the adhesive layer 70 is located between the base layer 40 and the mesa structures P1A~P4A, i.e., the base layer 40 is bonded to the mesa structures P1A~P4A through the adhesive layer 70. As shown in FIG. 24A, the mesa structures P1A, P2A protrude upward from the surface of the first-type semiconductor layer 101U1 into the adhesive layer 70, and the mesa structures P3A, P4A protrude upward from the surface of the first-type semiconductor layer 101U2 into the adhesive layer 70, i.e., the adhesive layer 70 encapsulates these mesa structures P1A~P4A.

As shown in FIG. 24A, the mesa structures P1A, P2A, P3A, P4A respectively include second-type semiconductor layers 102U1, 102U2, 102U3, 102U4 and active layers 103U1, 103U2, 103U3, 103U4, where the active layer 103U1 is between the first-type semiconductor layer 101U1 and the second-type semiconductor layer 102U1, the active layer 103U2 is between the first-type semiconductor layer 101U1 and the second-type semiconductor layer 102U2, the active layer 103U3 is between the first-type semiconductor layer 101U2 and the second-type semiconductor layer 102U3, and the active layer 103U4 is between the first-type semiconductor layer 101U2 and the second-type semiconductor layer 102U4.

As shown in FIG. 24A, the semiconductor laser unit 2400U1 has an electrode structure 20U1 on the bottom of the first-type semiconductor layer 101U1 and electrically contacting the first-type semiconductor layer 101U1. As shown in FIG. 24A, the semiconductor laser unit 2400U2 has an electrode structure 20U2 on the bottom of the first-type semiconductor layer 101U2 and electrically contacting the first-type semiconductor layer 101U2.

As shown in FIG. 24A, the semiconductor laser unit 2400U1 includes an insulating layer 60U1 located on the top of the second-type semiconductor layers 102U1, 102U2 and extending to the side of the mesa structures P1A, P2A. The insulating layer 60U1 is located between an electrode structure 50U1 and the mesa structures P1A, P2A, and the insulating layer 60U1 includes plural openings 61U1~61U4 respectively located on the top surfaces of the second-type semiconductor layers 102U1, 102U2. The electrode structure 50U1 of the semiconductor laser unit 2400U1 is in the openings 61U1~61U4 to electrically contact the second-type semiconductor layers 102U1, 102U2, and the electrode structure 50U1 extends from the openings 61U1~61U4 to the side of the insulating layer 60U1 on the mesa structures P1A, P2A. As shown in FIG. 24A, the insulating layer 60U1 further extends from the side surface of the mesa structure P2A to the top surface of the first-type semiconductor layer 101U1 and includes an opening 33U1.

As shown in FIG. 24A, the first-type semiconductor layer 101U1 of the semiconductor laser unit 2400U1 includes a through-hole 101V1 corresponding to the location of the opening 33U1. The electrode structure 50U1 further extends along the surface of the insulating layer 60U1 on the mesa structure P2A to the top of the first-type semiconductor layer 101U1 and into the through-hole 101V1, and the electrode structure 50U1 further extends from the through-hole 101V1 to the bottom of the first-type semiconductor layer 101U1, i.e., a portion of the electrode structure 50U1 and the electrode structure 20U1 are both located below the first-type semiconductor layer 101U1. As shown in FIG. 24A, the semiconductor laser unit 2400U1 includes an insulating layer 30U1 located between the electrode structure 50U1 and the first-type semiconductor layer 101U1 to electrically isolate the electrode structure 50U1 from the first-type semiconductor layer 101U1.

As shown in FIG. 24A, the semiconductor laser unit 2400U2 includes an insulating layer 60U2 located on the top surface of the second-type semiconductor layers 102U3, 102U4 and extending to the side surfaces of the mesa structures P3A, P4A. The insulating layer 60U2 is located between the electrode structure 50U2 and the mesa structures P3A, P4A, and the insulating layer 60U2 includes plural openings 61U5~61U8 respectively located on the top surfaces of the second-type semiconductor layers 102U3, 102U4. The electrode structure 50U2 of the semiconductor laser unit 2400U2 is in the openings 61U5~61U8 to electrically contact the second-type semiconductor layers 102U3, 102U4, and the electrode structure 50U2 extends from the openings 61U5~61U8 to the side surfaces of the insulating layer 60U2 on the mesa structures P3A, P4A. As shown in FIG. 24A, the insulating layer 60U2 further extends from the side surface of the mesa structure P4A to the top surface of the first-type semiconductor layer 101U2 and includes an opening 33U2.

As shown in FIG. 24A, the first-type semiconductor layer 101U2 of the semiconductor laser unit 2400U2 includes a through-hole 101V2 corresponding to the location of the opening 33U2. The electrode structure 50U2 further extends along the surface of the insulating layer 60U2 on the mesa structure P4A to the top of the first-type semiconductor layer 101U2 and into the through-hole 101V2, and the electrode structure 50U2 further extends from the through-hole 101V2 to the bottom of the first-type semiconductor layer 101U2, i.e., a portion of the electrode structure 50U2 and a portion of the electrode structure 20U2 are both located below the first-type semiconductor layer 101U2. As shown in FIG. 24A, the semiconductor laser unit 2400U2 includes an insulating layer 30U2 located between the electrode structure 50U2 and the first-type semiconductor layer 101U2 to electrically isolate the electrode structure 50U2 from the first-type semiconductor layer 101U2.

As shown in FIGS. 24A and 24B, an insulating layer 30B is filled between the first-type semiconductor layer 101U1 of the semiconductor laser unit 2400U1 and the first-type semiconductor layer 101U2 of the semiconductor laser unit 2400U2. As shown in FIG. 24B, the insulating layers 30U1, 30B, and 30U2 are connected as an insulating layer 30, and the insulating layer 30 is filled between the electrode structures 20U1, 50U1, 20U2, and 50U2 to isolate the electrode structures 20U1, 50U1, 20U2, and 50U2.

As shown in FIGS. 24A and 24B, the insulating layer 30 includes plural openings located on the bottom surfaces of the first-type semiconductor layers 101U1 and 101U2 to individually expose the bottom electrode structures 20U1 and 50U1 of the semiconductor laser unit 2400U1, and to individually expose the bottom electrode structures 20U2 and 50U2 of the semiconductor laser unit 2400U2.

As shown in FIGS. 24A to 24C, the semiconductor laser 2400 is divided into plural emitting regions 2400A, 2400B, 2400C, and 2400D, each emitting region having an independent pair of electrodes for addressing and controlling the individual emitting region. However, the number of emitting regions and the number of electrode structures in the present embodiment are not limited and can be modified according to the application requirements (e.g., sensing applications or illumination applications) to control the emitting position (which emitting region emits) and brightness (the number of emitting regions) of the semiconductor laser 2400. Taking the emitting regions 2400A and 2400B as examples, for instance, the semiconductor laser unit 2400U1 located in the emitting region 2400A includes a pair of electrode structures 20U1, 50U1, and the semiconductor laser unit 2400U2 located in the emitting region 2400B includes another pair of electrode structures 20U2, 50U2. The electrode structure pairs 20U1, 50U1 and 20U2, 50U2 are electrically connected to a current control device (not shown). The current control device can determine whether to apply current to a specific pair of electrode structures (electrode structure pair 20U1, 50U1 and/or electrode structure pair 20U2, 50U2) based on the intensity of external light, thereby turning on different emitting regions of the semiconductor laser 2400 to achieve addressing control of the emission.

As shown in FIG. 24A, in the embodiment, the mesa structures P1A~P4A respectively have current confinement layers 104, respectively located between the active layer 103U1 and the second-type semiconductor layer 102U1, between the active layer 103U2 and the second-type semiconductor layer 102U2, between the active layer 103U3 and the second-type semiconductor layer 102U3, and between the active layer 103U4 and the second-type semiconductor layer 102U4, but the present embodiment is not limited thereto. As shown in FIG. 24A, the current confinement layer 104 includes a current limiting region 1041 and a current conducting region 1042, where the current limiting region 1041 surrounds the current conducting region 1042, and the conductivity of the current conducting region 1042 is higher than that of the current limiting region 1041, so that the current is concentrated and conducted through the current conducting region 1042.

Referring to FIG. 24A, the semiconductor laser 2400 has a flip-chip packaging structure of a VCSEL. Subsequently, the semiconductor laser 2400 can be bonded to an external circuit board (e.g., a printed circuit board) or a packaging substrate by solder.

Referring to FIG. 24A, in the embodiment, the second-type semiconductor layers 102U1~102U4 and the first-type semiconductor layers 101U1, 101U2 contain multiple layers with different refractive indices alternately stacked (e.g., high aluminum content AlGaAs layers and low aluminum content AlGaAs layers periodically alternately stacked) to form a DBR structure, so that the light emitted from the active layers 103U1~103U4 can be reflected between the two reflectors to form resonant light. In the embodiment, the reflectivity of the second-type semiconductor layers 102U1, 102U2 is lower than the reflectivity of the first-type semiconductor layer 101U1, and the reflectivity of the second-type semiconductor layers 102U3, 102U4 is lower than the reflectivity of the first-type semiconductor layer 101U2, thereby allowing the resonant light to emit towards the substrate 40.

In some embodiments, the materials of the first-type semiconductor layers 101U1, 101U2 and the second-type semiconductor layers 102U1, 102U2, 102U3, 102U4 include III-V compound semiconductors, such as: AlGaInAs series, AlGaInP series, AlInGaN series, AlAsSb series, InGaAsP series, InGaAsN series, AlGaAsP series, etc., such as AlGaInP, GaAs, InGaAs, AlGaAs, GaAsP, GaP, InGaP, AlInP, GaN, InGaN, AlGaN, and other compounds.

Depending on the materials, the active layers 103U1, 103U2, 103U3, 103U4 can emit infrared light with a peak wavelength between 700 nm and 1700 nm, red light with a peak wavelength between 610 nm and 700 nm, yellow light with a peak wavelength between 530 nm and 570 nm, green light with a peak wavelength between 490 nm and 550 nm, blue light or deep blue light with a peak wavelength between 400 nm and 490 nm, or ultraviolet light with a peak wavelength between 250 nm and 400 nm. In the embodiment, the peak wavelength of light emitted from the active layers 103U1, 103U2, 103U3, 103U4 is infrared light between 750 nm and 1200 nm.

In some embodiments, the material of the current confinement layer 104 can be the aforesaid III-V semiconductor material. As shown in FIG. 1A, the material of the current confinement layer 104 is AlGaAs, and the materials of the active layers 103U1, 103U2, 103U3, 103U4 all contain aluminum. The aluminum content of the current confinement layer 104 is higher than the aluminum content of the active layers 103U1, 103U2, 103U3, 103U4. For example, the aluminum content of the current confinement layer 104 is greater than 97%. In the embodiment, the oxygen content of the current limiting region 1041 is higher than the oxygen content of the current conducting region 1042A, causing the conductivity of the current limiting region 1041 to be much lower than the conductivity of the current conducting region 1042.

The adhesive layer 70 has high optical transparency to the light emitted from the active layers 103U1, 103U2, 103U3, 103U4, for example, a material with a transmittance greater than 80%.

The adhesive layer 70 includes insulating material (non-conductive material), such as benzocyclobutene resin, epoxy resin, polyimide, spin-on glass, silicone gel, or perfluorocyclobutane.

The insulating layers 30U1, 30U2, 30B contain non-conductive materials. The non-conductive material can be an organic material or an inorganic material. Organic materials include epoxy photoresist, benzocyclobutene resin, perfluorocyclobutane, epoxy resin, acrylic resin, cycloolefin polymer, polymethylmethacrylate, polyethylene terephthalate, polycarbonate, polyetherimide, or fluorocarbon polymer. Inorganic materials include silicone gel or glass, aluminum oxide, silicon nitride, silicon oxide, titanium oxide, or magnesium fluoride. In some embodiments, the insulating layers 30U1, 30U2, 30B are a single layer or multiple layers (e.g., a DBR structure formed by alternately stacking two kinds of material layers, such as silicon oxide layers and titanium oxide layers).

The material of the electrode structures 20U1, 20U2 may be metal, such as aluminum, silver, chromium, platinum, nickel, germanium, beryllium, gold, titanium, tungsten, or zinc. The material of the electrode structures 50U1, 50U2 may be metal material, such as gold, tin, titanium, or alloys thereof. The electrode structures 20U1, 20U2 and the electrode structures 50U1, 50U2 can be a single layer or multi-layer structure. The electrode structures 20U1, 20U2 and the electrode structures 50U1, 50U2 can each be a multi-layer structure with different compositions.

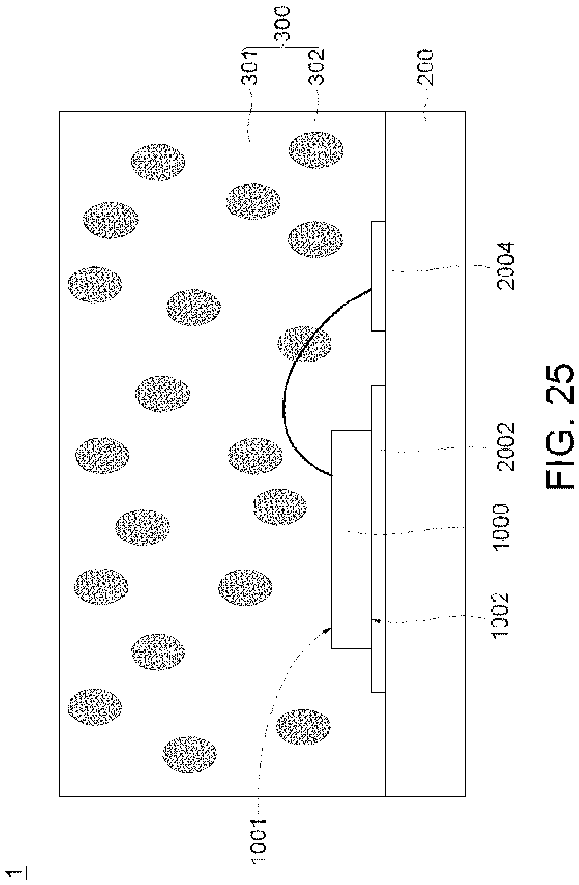

FIG. 25 is a schematic sectional view of a packaging structure of a light-emitting device 100 according to at least one embodiment of the present disclosure. In the embodiment, the packaging structure of the light-emitting device 100 includes a packaging substrate 200, a semiconductor laser 1000, and an adjustment layer 300'.

Referring to FIGS. 25 and 1B together, the semiconductor laser 1000 can be a VCSEL element as shown in FIG. 1B, used to provide a laser light source.

As shown in FIG. 25, the semiconductor laser 1000 includes a light-output surface 1001 and a surface 1002 opposite to the light-output surface 1001, and the semiconductor laser 1000 is electrically connected to the packaging substrate 200. The adjustment layer 300' is on the light-output surface 1001 of the semiconductor laser 1000, wherein the adjustment layer 300' includes a packaging material 301 and particles 302, wherein the particles 302 are filled in the packaging material 301, and the particles 302 are transparent or semi-transparent and dispersed in the packaging material 301.

As shown in FIG. 25, a bottom electrode (e.g., the electrode structure 50 of the VCSEL element shown in FIG. 1B) of the semiconductor laser 1000 is connected to a conductive pad 2002 on the packaging substrate 200, and a top electrode (e.g., the electrode structure 20 of the VCSEL element shown in FIG. 1B) of the semiconductor laser 1000 is wire-bonded to another conductive pad 2004 on the packaging substrate 200, thereby electrically connecting to the packaging substrate 200, wherein the bottom electrode and the top electrode of the semiconductor laser 1000 have different polarities.

Referring to FIG. 25 again, in the embodiment, the adjustment layer 300' covers the semiconductor laser 1000, thereby contacting the light-output surface 1001 of the semiconductor laser 1000 and the packaging substrate 200. Thus, the doping (filling) concentration of the particles 302 in the packaging material 301 or the particle size can be varied to change the light emission angle range or the light emission direction of the light-emitting device 1.

In some embodiments, the packaging substrate 200 can be a ceramic substrate, a plastic substrate formed by injection molding or molding, an FR4 (epoxy glass multilayer) substrate, a Bismaleimide Triazine (BT) substrate, an aluminum substrate, or another substrate with conductive lines. The substrate includes corresponding conductive structures (not shown) for electrical connection.

In some embodiments, the packaging material 301 of the adjustment layer 300' can be silicone gel, epoxy resin, a hybrid packaging material, or a gel material used for packaging.

In some embodiments, the filler particles 302 of the adjustment layer 300' can be silicone gel, glass powder, filler, or a material that can change the light source angle after filling.

In some embodiments, the size of the particles 302 may vary depending on the material composition or form.

In some embodiments, the doping (filling) concentration of the particles 302 may vary depending on the material composition or form and the desired light emission angle.

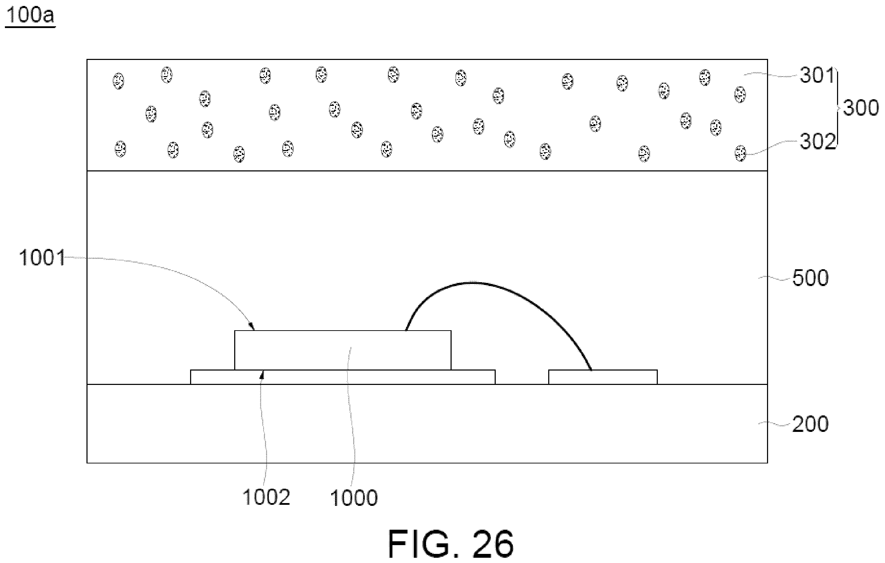

FIG. 26 is a schematic sectional view of a packaging structure of a light-emitting device 100a according to at least one embodiment of the present disclosure. In the embodiment, the packaging structure of the light-emitting device 100a further includes a transparent packaging layer 500 on a light-output surface 1001 of the laser element 1000, wherein the transparent packaging layer 500 contacts the light-output surface 1001 of the semiconductor laser 1000 and the packaging substrate 200, and the adjustment layer 300' is on the transparent packaging layer 500.

In some embodiments, the material of the transparent packaging layer 500 can be the same or different from the packaging material 301 of the adjustment layer 300'.

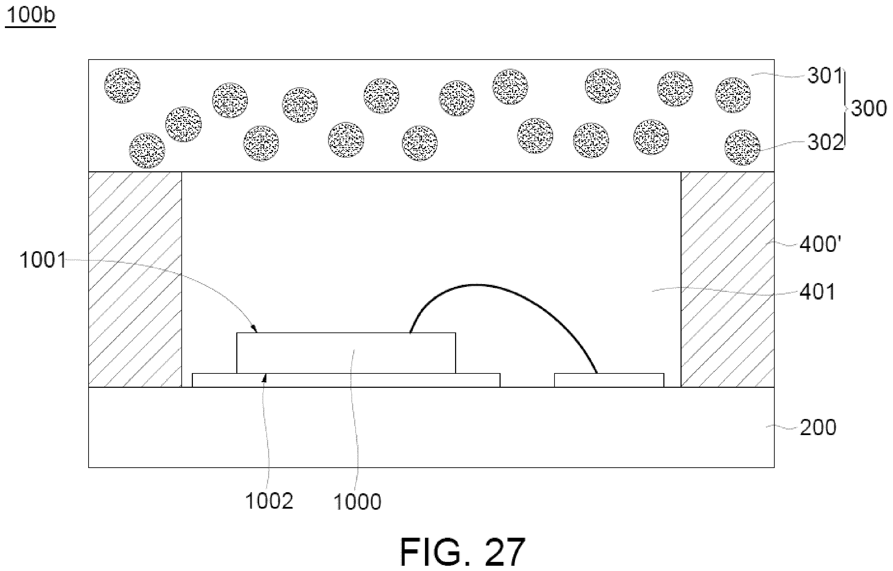

FIG. 27 is a schematic sectional view of a packaging structure of a light-emitting device 100b according to at least one embodiment of the present disclosure. In the embodiment, the packaging structure of the light-emitting device 100b further includes a support member 400', wherein the support member 400' and the packaging substrate 200 together define an accommodation space 401, the semiconductor laser 1000 is located in the accommodation space 401, and the adjustment layer 300' is on the support member 400' and covers the accommodation space 401 and the semiconductor laser 1000. In some embodiments, the support member 400' can have the structure of the aforesaid wall 400, but the embodiments of the present disclosure are not limited thereto.

In some embodiments, the accommodation space 401 can be filled with air, inert gas, nitrogen, or maintained in a vacuum.

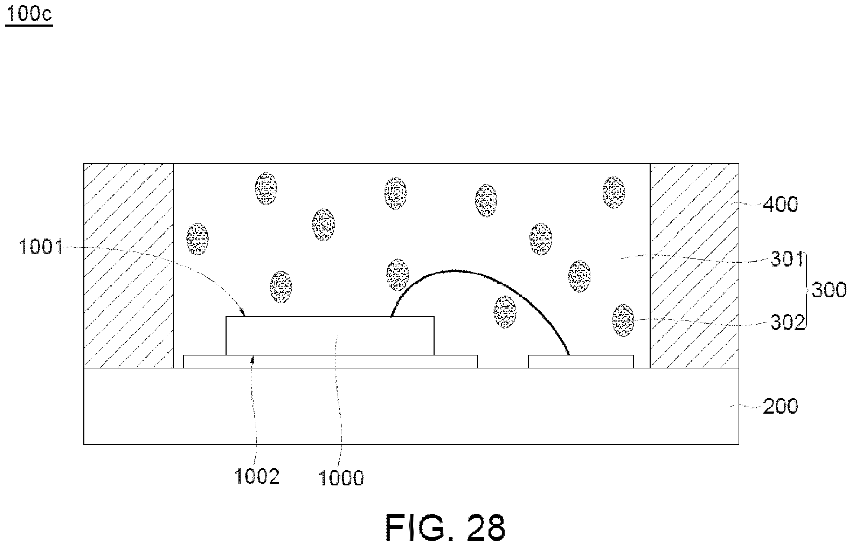

FIG. 28 is a schematic sectional view of a packaging structure of a light-emitting device 100c according to at least one embodiment of the present disclosure. In the embodiment, the packaging structure of the light-emitting device 100c also includes a wall 400, wherein the wall 400 and the packaging substrate 200 together define an accommodation space 401. In the embodiment, the semiconductor laser 1000 and the adjustment layer 300' are located in the accommodation space 401, and the adjustment layer 300' contacts the light-output surface 1001 of the semiconductor laser 1000. In other words, in the embodiment, the adjustment layer 300' is filled into the accommodation space 401 jointly defined by the wall 400 and the packaging substrate 200, and covers the semiconductor laser 1000, thereby contacting the light-output surface 1001 of the semiconductor laser 1000 and the packaging substrate 200.

In some embodiments, the material of the wall 400 can be silicone gel, epoxy resin, a hybrid material, a ceramic material (e.g., but not limited to aluminum oxide or aluminum nitride), a metal material, or any material that can serve as a support member.

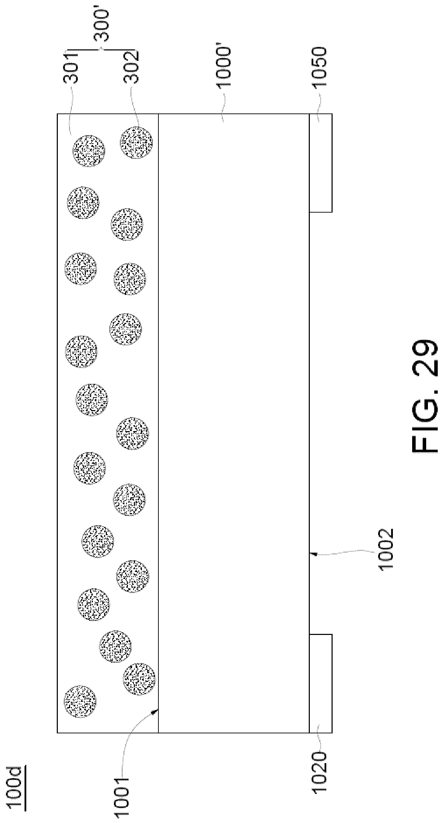

FIG. 29 is a schematic sectional view of a packaging structure of a light-emitting device 100d according to at least one embodiment of the present disclosure. In the embodiment, the packaging structure of the light-emitting device 100d includes a semiconductor laser 1000 and an adjustment layer 300'. The semiconductor laser 1000 includes a light-output surface 1001 and a surface 1002 opposite to the light-output surface 1001. The electrodes 1020 and 1050 of the semiconductor laser 1000 are both located on the surface 1002 for electrical connection to a packaging substrate or a circuit substrate. The adjustment layer 300' is on the light-output surface 1001 of the semiconductor laser 1000, wherein the adjustment layer 300' includes a packaging material 301 and particles 302, wherein the particles 302 are doped (filled) in the packaging material 301, and these particles 302 are transparent or semi-transparent and dispersed in the packaging material 301. In other words, in the embodiment, the semiconductor laser 1000 has a horizontal electrode architecture, i.e., the positive electrode pad and the negative electrode pad of the semiconductor laser 1000 are distributed on the same side (e.g., the electrode structure 20 and electrode structure 50 of the semiconductor laser 1006 shown in FIG. 8 are on the same side of the semiconductor stack 10), and are disposed on the packaging substrate through a flip-chip process, thereby achieving chip-scale packaging (CSP).

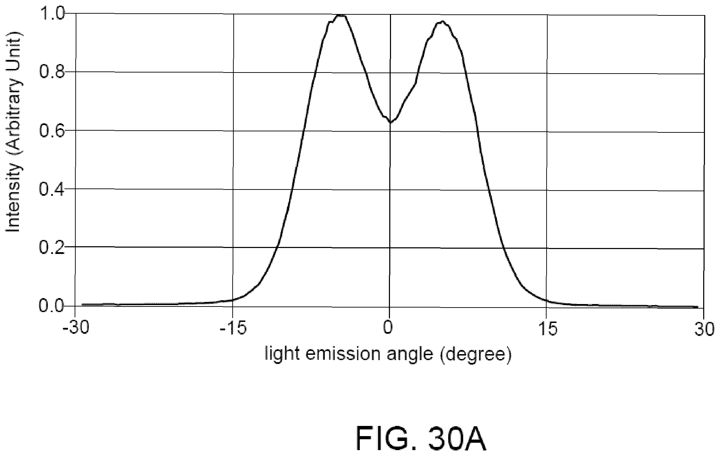

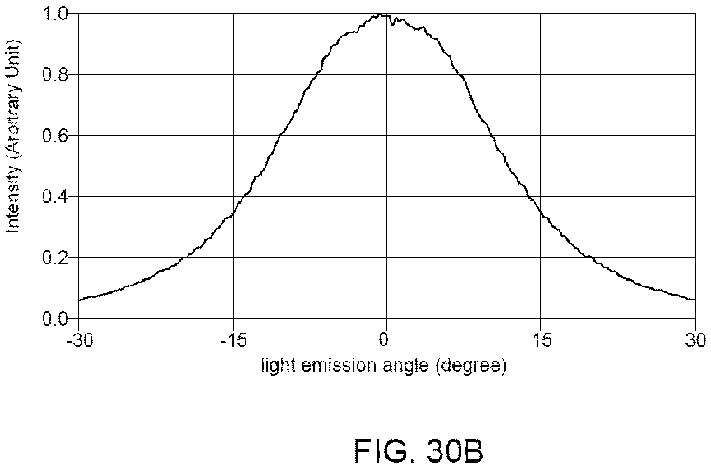

FIG. 30A is a schematic view of the light emission angle of a light-emitting device without the adjustment layer 300'. FIG. 30B is a schematic view of the light emission angle of a light-emitting device including the adjustment layer 300' based on the example of FIG. 30A.

As shown in FIGS. 30A and 30B, compared to the packaging structure without the adjustment layer 300', the packaging structure according to some embodiments of the present application can increase the light emission angle of the semiconductor laser 1000 from 30 degrees (-15 degrees to +15 degrees) to about 60 degrees (-30 degrees to +30 degrees), to meet a requirement for a light-emitting device with a large light emission angle range.

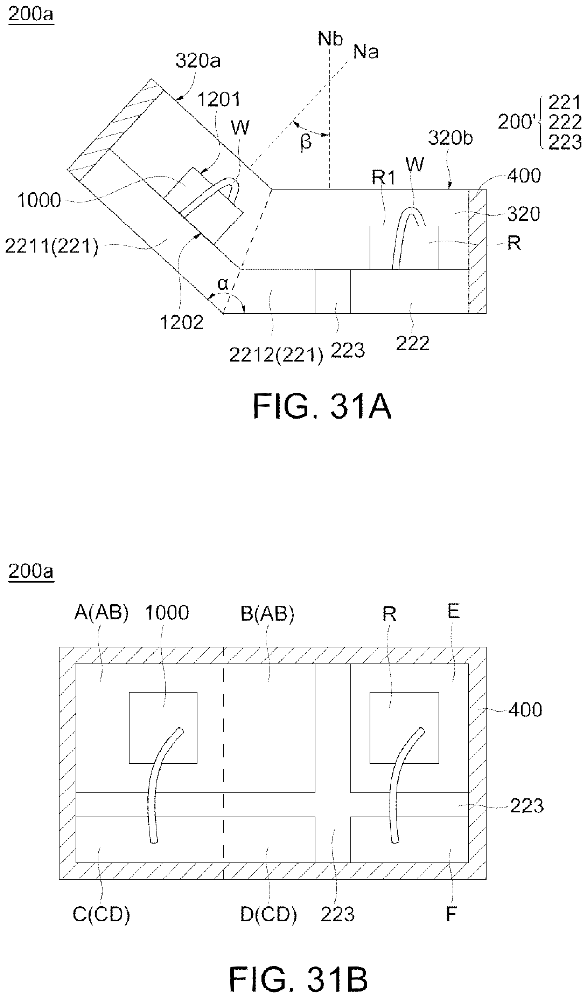

FIG. 31A is a side perspective schematic view of a packaging structure of an optical transmitting and receiving device 200a according to at least one embodiment of the present disclosure, and FIG. 31B is a top view of the packaging structure of the optical transmitting and receiving device 200a based on the example of FIG. 31A. The packaging structure of the optical transmitting and receiving device 200a in the embodiment includes a packaging substrate 200', at least one light-emitting element 1000, at least one light-receiving element R, and a packaging layer 320. In the embodiment, the number of light-emitting element 1000 and light-receiving element R is one, but the is only for illustration and not a limitation.

As shown in FIG. 31A, the packaging substrate 200' has a first part 221, a second part 222, and an insulating part 223, wherein the insulating part 223 is located between the first part 221 and the second part 222, and the first part 221 has a bent angle α. In other words, in the embodiment, the first part 221 of the packaging substrate 200' can be further divided into a bent portion 2211 and an extending portion 2212, and there is a bent angle α between the bent portion 2211 and the extending portion 2212 of the packaging substrate.

The light-emitting element 1000 has a light-output surface 1201 and a surface 1202 opposite to the light-output surface 1201, wherein the surface 1202 is on the bent portion 2211 of the first part 221 of the packaging substrate 200', and the light-receiving element R is on the second part 222 of the packaging substrate 200'.

The packaging layer 320 is on the light-output surface 1201 of the light-emitting element 1200 and the light-receiving surface R1 of the light-receiving element R. The packaging layer 320 has a light-output surface 320a and a light-receiving surface 320b, corresponding to the light-emitting element 1200 and the light-receiving element R, respectively. Due to the bent angle α between the bent portion 2211 and the extending portion 2212 of the packaging substrate, the normal Na of the light-output surface 320a corresponding to the light-emitting element 1200 and the normal Nb of the light-receiving surface 320b corresponding to the light-receiving element R are not parallel, i.e., there is an angle β between the normal Na of the light-output surface 320a and the normal Nb of the light-receiving surface 320b, where β is not 0 degrees. In the embodiment, the angle β is substantially equal to the bent angle α, but the embodiments of the present disclosure are not limited thereto.

As shown in FIG. 31B, in the embodiment, from a top view, the first part 221 of the packaging substrate 200' can be divided into connected areas A and B (collectively referred to as area AB) and connected areas C and D (collectively referred to as area CD), wherein there is an insulating part 223 between area A and area C, and there is also an insulating part 223 between area B and area D. The second part 222 of the packaging substrate 200' can be divided into area E and area F, and there is also an insulating part 223 between area E and area F. In the embodiment, from a top view, the insulating part 223 appears in a cross shape, separating the area AB and area CD of the first part, separating the area E and area F of the second part, separating the area AB of the first part and the area E of the second part, and separating the area CD of the first part and the area F of the second part. In the embodiment, the light-emitting element 1000 is located in area A of the first part 221, the bottom electrode of the light-emitting element 1000 is electrically connected to the electrode pad in area A, and the top electrode of the light-emitting element 1000 is electrically connected to the electrode pad in area C through a wire W. Correspondingly, the light-receiving element R is located in area E of the second part 222, the bottom electrode of the light-receiving element R is electrically connected to the electrode pad in area E, and the top electrode of the light-receiving element R is electrically connected to the electrode pad in area F through a wire W. In the way, the electrical connections between the light-emitting element 1200 and the packaging substrate 200', and between the light-receiving element R and the packaging substrate 200', can be completed individually. Afterwards, the packaging material is applied to encapsulate the light-emitting element 1200 and the light-receiving element R through a dispensing method, and after the packaging material is cured, it forms the packaging layer 320, thereby obtaining the packaging structure of the optical transmitting and receiving device 200a. In some embodiments, as shown in FIGS. 7A and 7B, in order to fix the packaging material on the packaging substrate 200' so that the packaging material can be applied to encapsulate the light-emitting element 1200 and the light-receiving element R through a dispensing method, the packaging structure of the optical transmitting and receiving device 200a may further include a frame 400, which is arranged around the periphery of the packaging substrate 200' and surrounds the first part 221, the second part 222, and the insulating part 223 of the packaging substrate 200'. In the way, when using the dispensing method to apply the packaging material on the packaging substrate 200' to encapsulate the light-emitting element 1200 and the light-receiving element R, the configuration of the frame 400 can position the packaging material that is not yet cured and still flowable.

In the embodiment, the packaging structure of the optical transmitting and receiving device 200a is, for example, a proximity sensor. Specifically, by having an angle β between the normal of the light-output surface 320a and the normal of the light-receiving surface 320b, the light emitted from the light-emitting element 1000 will not be directly received by the light-receiving element R adjacent to the light-emitting element 1000. In the way, it can be avoided that the light emitted from the light-emitting element 1000 is directly received by the light-receiving element R when the proximity sensor is in use (e.g., applied to a mobile phone or other electronic device), thereby avoiding false sensing of the proximity sensor. Therefore, the light emitted from the light-emitting element 1000 can be reflected by an obstacle to the light-receiving element R, allowing the proximity sensor to detect the presence of the obstacle.

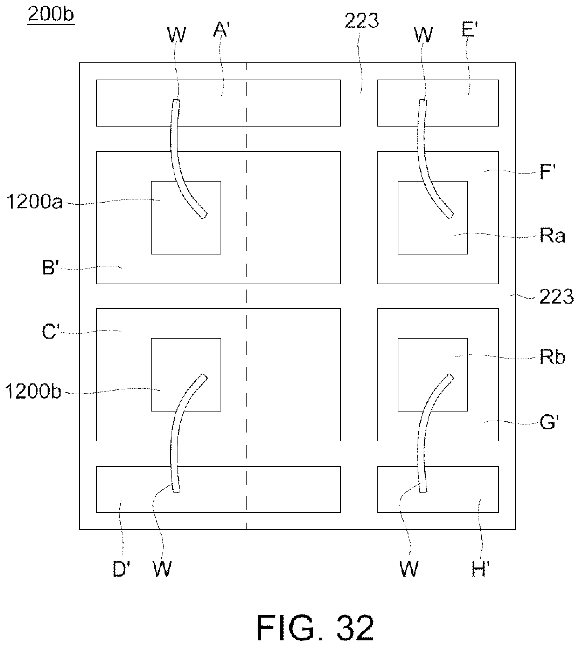

FIG. 32 is a top view of the packaging structure of the optical transmitting and receiving device 200b according to at least one embodiment of the present disclosure. In the embodiment, the packaging structure of the optical transmitting and receiving device 200b includes a packaging substrate 200', light-emitting elements 1200a, 1200b, light-receiving elements Ra, Rb, and a packaging layer 320.

In the embodiment, the number of light-emitting elements and light-receiving elements is two, but the application is not limited thereto. Furthermore, in the embodiment, the number of light-emitting elements is, but not limited to, the same as the number of light-receiving elements. In some embodiments, there can be one light-emitting element combined with plural light-receiving elements or plural light-emitting elements combined with one light-receiving element.

In the embodiment, the first part 221 of the packaging substrate 200' further includes plural first areas A', B', C', D', and the insulating part 223 is further located between these first areas. The light-emitting elements 1200a, 1200b are located on different ones of these first areas, and these light-emitting elements 1200a, 1200b are electrically connected to the remaining different ones of these first areas through wires W. As shown in FIG. 32, from the top view of the packaging structure 2a, the top electrodes of the light-emitting elements 1200a, 1200b are individually electrically connected to the first areas A' and D' located on the two sides through wires W, while the light-emitting elements 1200a, 1200b are located on different ones of these first areas B' and C', thereby allowing the bottom electrodes of the light-emitting elements 1200a, 1200b to be individually electrically connected to the corresponding first areas B' and C' where they are located.

Similarly, in the embodiment, the second part 222 further includes plural second areas E', F', G', H', and the insulating part 223 is further located between these second areas. These light-receiving elements Ra, Rb are located on different ones of these second areas, and these light-receiving elements Ra, Rb are individually electrically connected to the remaining different ones of these second areas through wires W. As shown in FIG. 32, from the top view of the packaging structure 2a, the top electrodes of the light-receiving elements Ra, Rb are individually electrically connected to the second areas E' and H' located on the two sides through wires W, while the light-receiving elements Ra, Rb are located on different ones of these second areas F' and G', thereby allowing the bottom electrodes of the light-receiving elements Ra, Rb to be individually electrically connected to the corresponding second areas F' and G' where they are located.

Specifically, in the embodiment, the first areas of the first part 221 include areas A' to D', and the second areas of the second part 222 include areas E' to H'. The light-emitting element 1200a is in area B', and the bottom electrode of the light-emitting element 1200a is electrically connected to the conductive pad in area B', while the top electrode of the light-emitting element 1200a is electrically connected to the conductive pad in area A' through a wire W. The light-emitting element 1200b is located in area C', and the bottom electrode of the light-emitting element 1200b is electrically connected to the conductive pad in area C', while the top electrode of the light-emitting element 1200b is electrically connected to the conductive pad in area D' through a wire W. Correspondingly, the light-receiving element Ra is located in area F', and the bottom electrode of the light-receiving element Ra is electrically connected to the conductive pad in area F', while the top electrode of the light-receiving element Ra is electrically connected to the conductive pad in area E' through a wire W. The light-receiving element Rb is in area G', and the bottom electrode of the light-receiving element Rb is electrically connected to the conductive pad in area G', while the top electrode of the light-receiving element Rb is electrically connected to the conductive pad in area H' through a wire W. Therefore, through the embodiment, independent electrode configurations can be achieved between the light-emitting element 1200a and the light-emitting element 1200b, as well as between the light-receiving element Ra and the light-receiving element Rb.

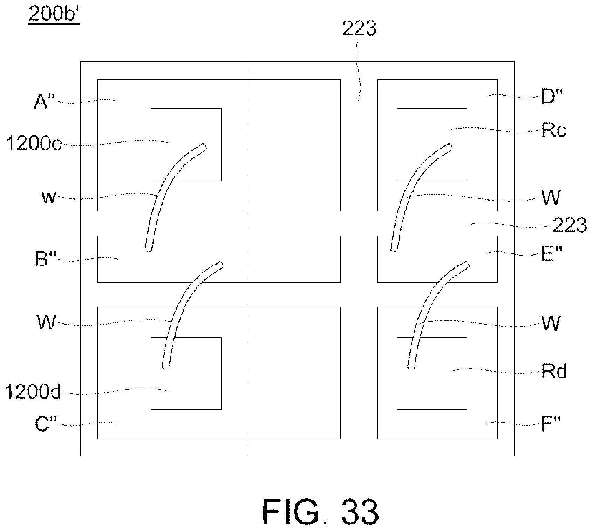

FIG. 33 is a top view of the packaging structure 200b according to at least one embodiment of the present disclosure. In the embodiment, the packaging structure 200b includes a packaging substrate 200', light-emitting elements 1200c, 1200d, light-receiving elements Rc, Rd, and a packaging layer 320.

In the embodiment, the number of light-emitting elements and light-receiving elements is also two, but not limited thereto.

In the embodiment, the first part 221 further includes plural first areas, and the insulating part 223 is further located between these first areas. These light-emitting elements 1200c, 1200d are located on different ones of these first areas, and these light-emitting elements 1200c, 1200d are electrically connected to the remaining same first area through wires W. As shown in FIG. 33, from the top view of the packaging structure 200b, these light-emitting elements 1200c, 1200d are located on the first areas on the two sides, and these light-emitting elements 1200c, 1200d are electrically connected to the first area in the middle through wires W.

Similarly, in the embodiment, the second part 222 further includes plural second areas, and the insulating part 223 is further located between these second areas. These light-receiving elements Rc, Rd are located on different ones of these second areas, and these light-receiving elements Rc, Rd are electrically connected to the remaining same second area through wires W. As shown in FIG. 33, from the top view of the packaging structure 200b, these light-receiving elements Rc, Rd are located on the second areas on the two sides, and these light-receiving elements Rc, Rd are electrically connected to the second area in the middle through wires W.

In the embodiment, the first areas of the first part 221 include areas A"-C", and the second areas of the second part 222 include areas D"-F". The light-emitting element 1200c is in area A", and the bottom electrode of the light-emitting element 1200c is electrically connected to the conductive pad in area A", while the top electrode of the light-emitting element 1200c is electrically connected to the conductive pad in area B" through a wire W. The light-emitting element 1200d is located in area C", and the bottom electrode of the light-emitting element 1200d is electrically connected to the conductive pad in area C", while the top electrode of the light-emitting element 1200d is also electrically connected to the conductive pad in area B" through a wire W. Correspondingly, the light-receiving element Rc is located in area D", and the bottom electrode of the light-receiving element Rc is electrically connected to the conductive pad in area D", while the top electrode of the light-receiving element Rc is electrically connected to the conductive pad in area E" through a wire W. The light-receiving element Rd is in area F", and the bottom electrode of the light-receiving element Rd is electrically connected to the conductive pad in area F", while the top electrode of the light-receiving element Rd is electrically connected to the conductive pad in area E" through a wire W. Therefore, through the embodiment, a shared electrode configuration can be achieved between the light-emitting element 1200c and the light-emitting element 1200d, as well as between the light-receiving element Rc and the light-receiving element Rd.

In some embodiments, the emission wavelengths of these light-emitting elements can be the same or different.

In some embodiments, the light-emitting element can be a vertical cavity surface emitting laser (VCSEL), and the light-receiving element can be a photo-detector integrated circuit (PDIC).

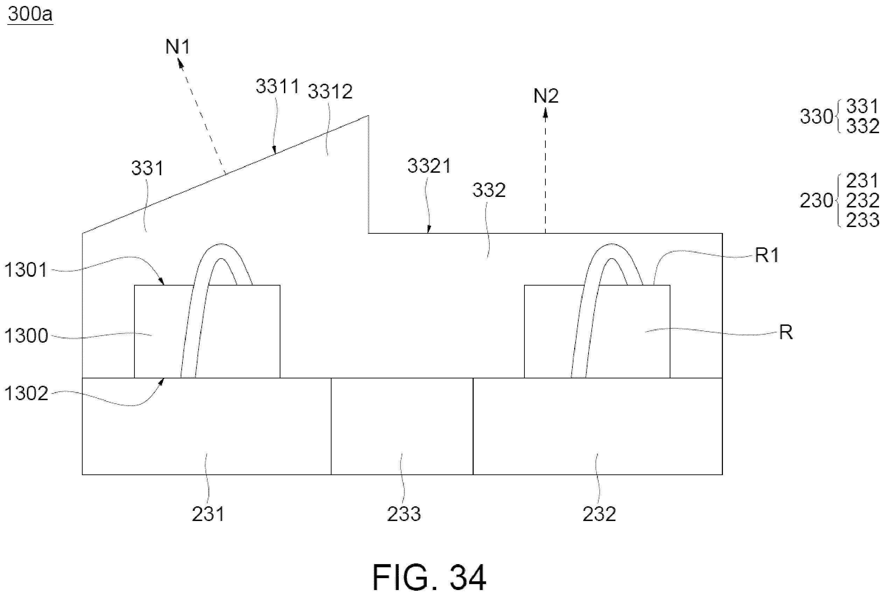

FIG. 34 is a schematic sectional view of the packaging structure 300a according to at least one embodiment of the present disclosure. the embodiment of the packaging structure 300a includes a packaging substrate 230, a light-emitting element 1300, a light-receiving element R, and a packaging layer 330.

The packaging substrate 230 has a first part 231, a second part 232, and an insulating part 233, where the insulating part 233 is located between the first part 231 and the second part 232. The light-emitting element 1300 has a light-output surface 1301 and a surface 1302, where the surface 1302 is opposite to the light-output surface 1301 and is on the packaging substrate 230, and the light-emitting element 1300 is electrically connected to the packaging substrate 230. The light-receiving element R has a light-receiving surface R1, where the light-receiving element R is electrically connected to the packaging substrate 230. The packaging layer 330 includes a first packaging region 331 and a second packaging region 332, where the first packaging region 331 is on the light-output surface 1301 of the light-emitting element 1300, and the second packaging region 332 is on the light-receiving surface R1 of the light-receiving element R. The first packaging region 331 has a first packaging surface 3311, and the second packaging region 332 has a second packaging surface 3321, and the normal direction N1 of the first packaging surface 3311 and the normal direction N2 of the second packaging surface 3321 are not parallel.

Please continue to refer to FIG. 34. In the embodiment, the first packaging region 331 has a first protrusion 3312, and the first packaging surface 3311 is a surface of the first protrusion 3312.

Furthermore, in the embodiment, the first protrusion 3312 includes an inclined surface, and the inclined surface rises from the first packaging region 331 of the packaging layer 320 towards the second packaging region 332, but the application is not limited thereto.

In the embodiment, the packaging structure 300a is a proximity sensor. Specifically, by having the normal direction N1 of the first packaging surface 3311 and the normal direction N2 of the second packaging surface 3321 not parallel, the light emitted from the light-emitting element 1300 will not be directly received by the light-receiving element R adjacent to the light-emitting element 1300. In the way, it can avoid the situation where the light emitted from the light-emitting element 1300 is directly received by the light-receiving element R when the proximity sensor is in use (e.g., applied to a mobile phone or other electronic device), thereby avoiding false sensing of the proximity sensor. Therefore, the light emitted from the light-emitting element 1300 can be reflected by an obstacle to the light-receiving element R, allowing the proximity sensor to detect the presence of the obstacle.

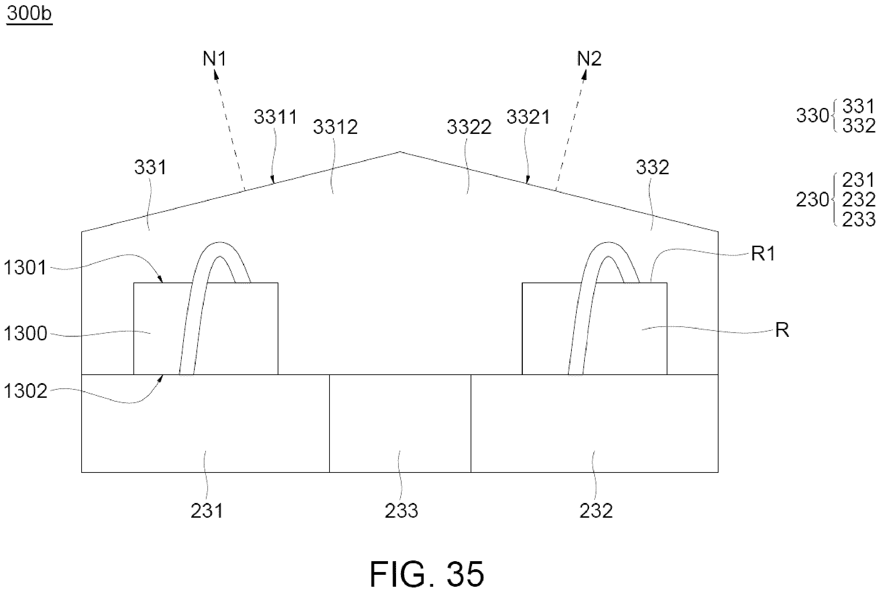

FIG. 35 is a schematic sectional view of the packaging structure 300b according to at least one embodiment of the present disclosure. In the embodiment, the first packaging region 331 has a first protrusion 3312, the second packaging region 332 has a second protrusion 3322, the first packaging surface 3311 is the surface of the first protrusion 3312, and the second packaging surface 3321 is the surface of the second protrusion 3322. Furthermore, in the embodiment, both the first protrusion 3312 and the second protrusion 3322 are inclined surfaces, and the inclined surface of the first protrusion 3312 rises from the first packaging region 331 of the packaging layer 320 towards the second packaging region 332, while the inclined surface of the second protrusion 3322 rises from the second packaging region 332 of the packaging layer 320 towards the first packaging region 331, thereby causing the highest point of the first protrusion 3312 and the highest point of the second protrusion 3322 to be adjacent to each other, but the application is not limited thereto.

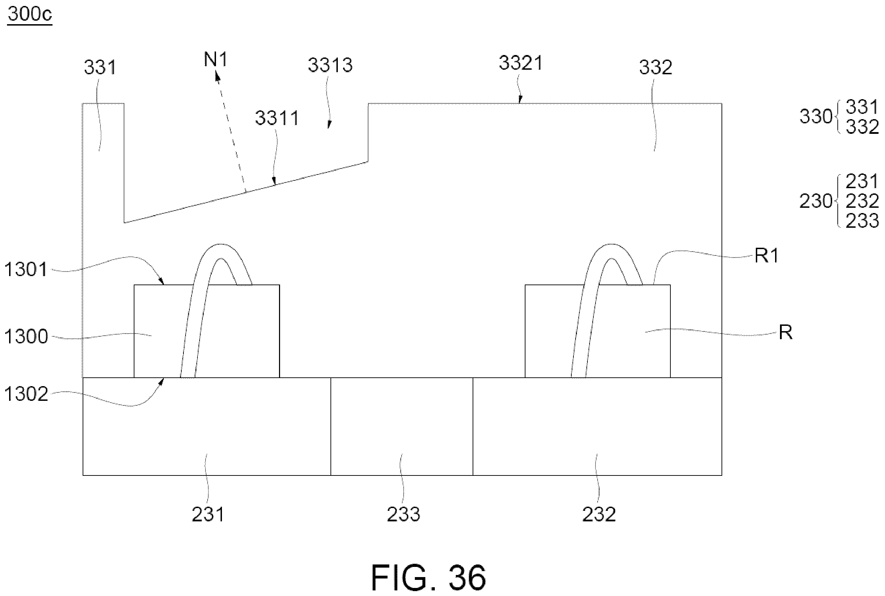

FIG. 36 is a schematic sectional view of the packaging structure 300c according to at least one embodiment of the present disclosure. In some embodiments, the first packaging region 331 has a first recess 3313, and the first packaging surface 3311 is the surface of the first recess 3313. In the embodiment, the first recess 3313 completely corresponds to the light-output surface 1301 of the light-emitting element 1300. In other words, in the embodiment, the entire light-output surface 1301 of the light-emitting element 1300 is within the range of the first recess 3313.

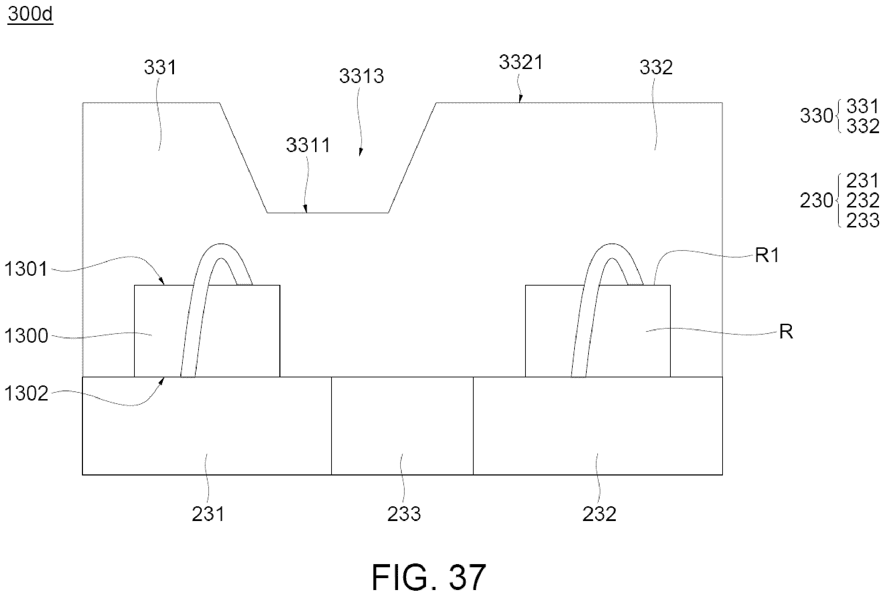

FIG. 37 is a schematic sectional view of the packaging structure 300d according to at least one embodiment of the present disclosure. In some embodiments, the first packaging region 331 has a first recess 3313, and the first packaging surface 3311 is the surface of the first recess 3313. Additionally, in the embodiment, the first recess 3313 partially corresponds to the light-output surface 1301 of the light-emitting element 1300. In other words, in the embodiment, a portions of the light-output surface 1301 of the light-emitting element 1300 is within the range of the first recess 3313.

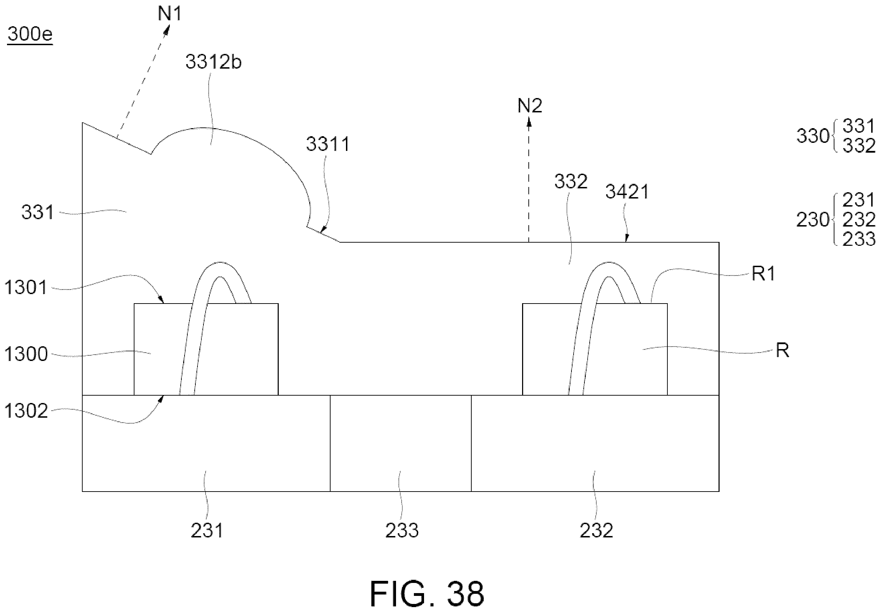

FIG. 38 is a schematic sectional view of the packaging structure 300e according to at least one embodiment of the present disclosure. In some embodiments, the first packaging region 331 has a first molded part 3312b protruding from the first packaging surface 3311. In the embodiment, the first molded part 3312b is dome-shaped, but the application is not limited thereto.

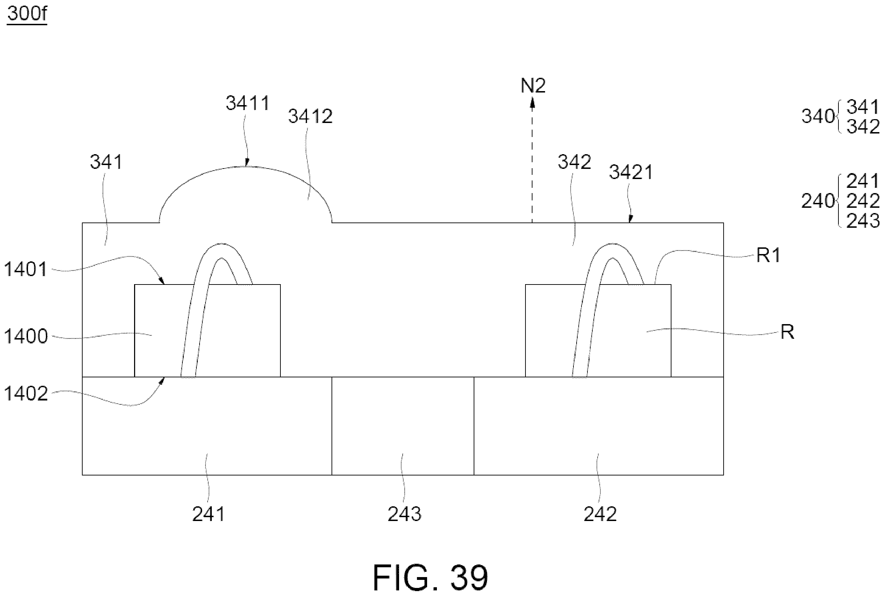

FIG. 39 is a schematic sectional view of the packaging structure 300f according to at least one embodiment of the present disclosure. the embodiment of the packaging structure 300f includes a packaging substrate 240, a light-emitting element 1400, a light-receiving element R, and a packaging layer 340.

The packaging substrate 240 includes a first part 241, a second part 242, and an insulating part 243, where the insulating part 243 is located between the first part 241 and the second part 242. The light-emitting element 1400 has a light-output surface 1401 and a surface 1402, where the surface 1402 is opposite to the light-output surface 1401 and is on the packaging substrate 240, and the light-emitting element 1400 is electrically connected to the packaging substrate 240. The light-receiving element R has a light-receiving surface R1, where the light-receiving element R is electrically connected to the packaging substrate 240. The packaging layer 340 includes a first packaging region 341 and a second packaging region 342, where the first packaging region 341 is on the light-output surface 1401 of the light-emitting element 1400, and the second packaging region 342 is on the light-receiving surface R1 of the light-receiving element R. The first packaging region 341 has a first packaging surface 3411, the first packaging region 341 also has a first molded part 3412, and the second packaging region 342 has a second packaging surface 3421, and the first molded part 3412 protrudes from the first packaging surface 3411. In the embodiment, the first molded part 3412 is dome-shaped, but the application is not limited thereto.

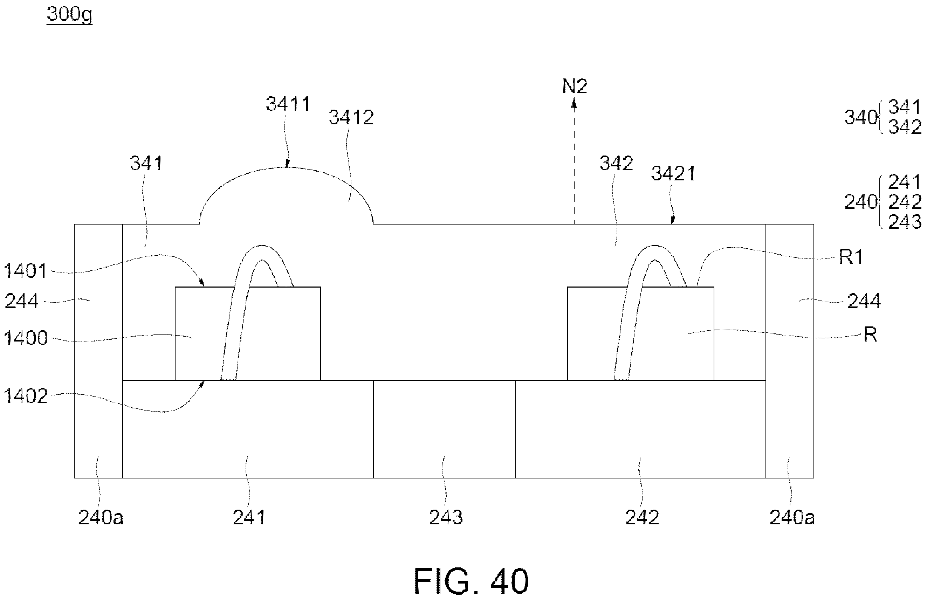

FIG. 40 is a schematic sectional view of the packaging structure 300g according to at least one embodiment of the present disclosure. Compared to the eleventh embodiment, the packaging substrate 240a of the embodiment further includes an encircling part 244 that encircles the first part 241, the second part 242, and the insulating part 243, thereby surrounding the packaging layer 340.

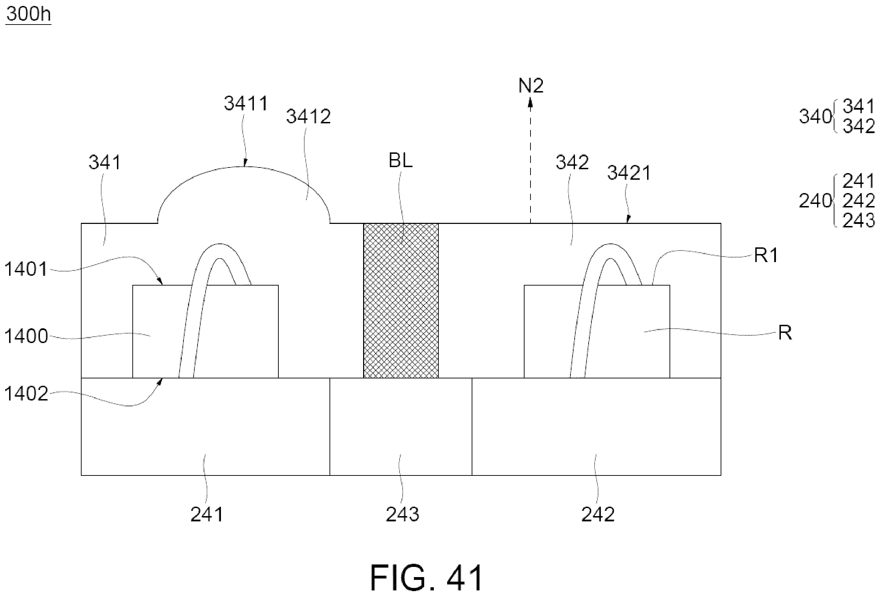

FIG. 41 is a schematic sectional view of the packaging structure 300h according to at least one embodiment of the present disclosure. Compared to the eleventh embodiment, the packaging structure 300h of the embodiment further includes a blocking layer BL located between the first packaging region 341 and the second packaging region 342. The blocking layer BL is made of a non-transparent material, such as plastic or black epoxy resin. Thus, the light can be absorbed by the blocking layer BL located between the first packaging region 341 and the second packaging region 342, thereby avoiding the lateral emitted light from the light-emitting element 1400 from being directly received by the light-receiving element R, which could cause sensing errors in the proximity sensor.

In some embodiments, the sectional shape of the blocking layer BL is not rectangular. In other words, in some embodiments, the sectional shape of the blocking layer BL can be trapezoidal or irregular.

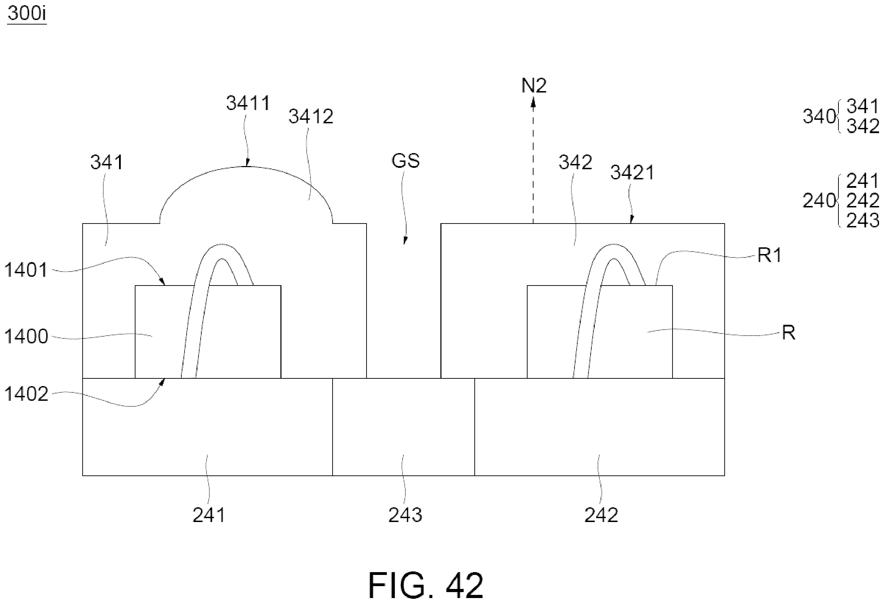

FIG. 42 is a schematic sectional view of the packaging structure 300i according to at least one embodiment of the present disclosure. Compared to the eleventh embodiment, the packaging layer 340 of the packaging structure 300i of the embodiment further includes a gap GS between the first packaging region 341 and the second packaging region 342. Thus, through the gap GS between the first packaging region 341 and the second packaging region 342, the lateral emitted light from the light-emitting element 1400 needs to pass through the first packaging region 341 of the packaging layer 340, the gap GS, and the second packaging region 342 of the packaging layer 340. Since the packaging layer 340 and the gap GS have different refractive indices, the lateral emitted light from the light-emitting element 1400 is less likely to be directly received by the light-receiving element R, thereby avoiding sensing errors in the proximity sensor.

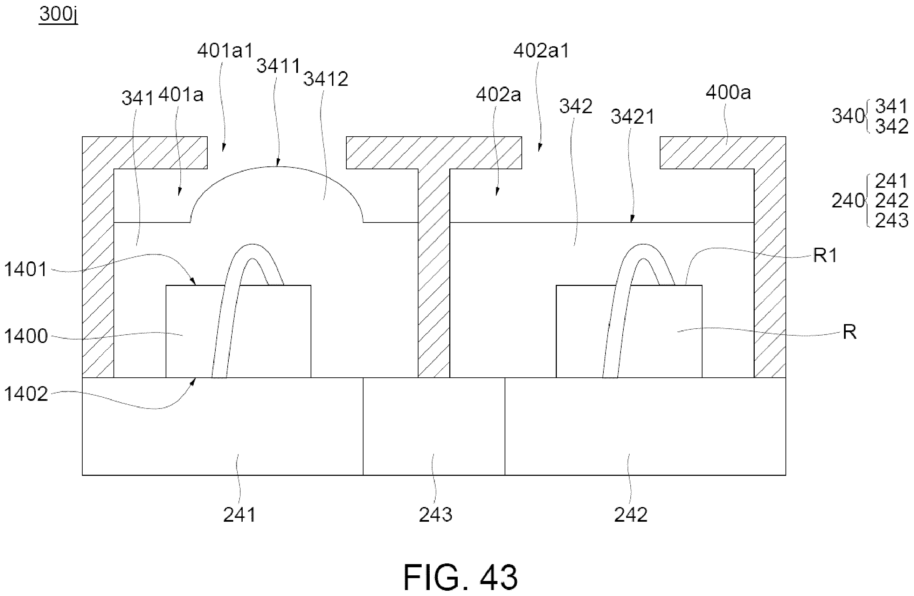

FIG. 43 is a schematic sectional view of the packaging structure 300j according to at least one embodiment of the present disclosure. In some embodiments, the packaging structure 300j further includes a wall 400a, where the wall 400a and the packaging substrate 240 together define a first accommodation space 401a and a second accommodation space 402a. The light-emitting element 1400 is located within the first accommodation space 401a, and the light-receiving element R is located within the second accommodation space 402a. The first accommodation space 401a has a first opening 401a1, and the second accommodation space 402a has a second opening 402a1. A portion of the first packaging surface 3411 is exposed from the first opening 401a1, and a portion of the second packaging surface 3421 is exposed from the second opening 402a1. In other words, in the embodiment, a portion of the first packaging surface 3411 is shielded by the wall 400a, and a portion of the second packaging surface 3421 is also shielded by the wall 400a. The wall 400a can be made of a non-transparent material, such as plastic or black epoxy resin. Thus, according to the embodiment, by using the wall 400a to shield a portion of the first packaging surface 3411 and a portion of the second packaging surface 3421, the light emitted from the light-emitting element 1400 is less likely to be directly received by the light-receiving element R, thereby avoiding sensing errors in the proximity sensor.

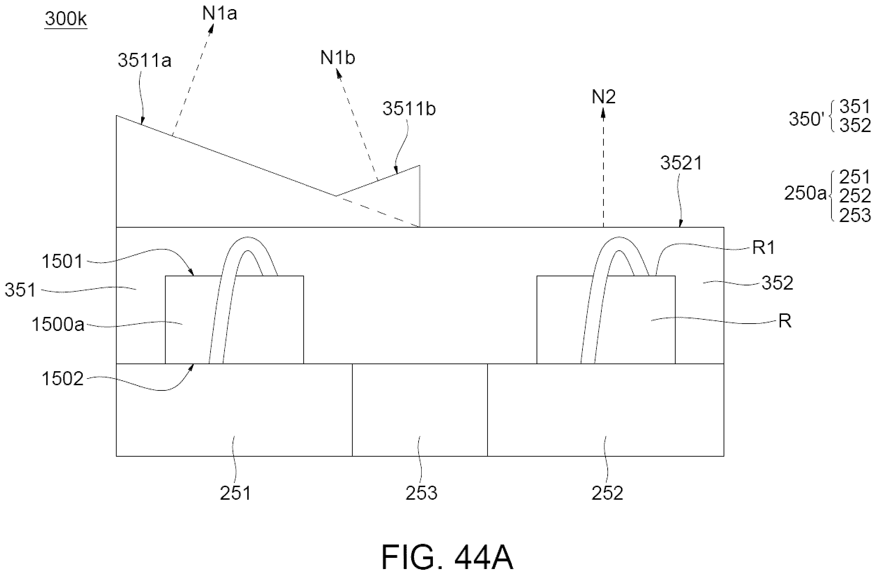

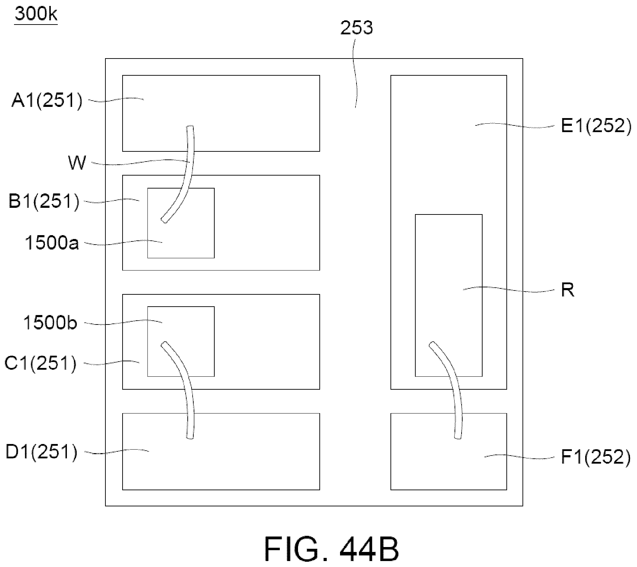

FIG. 44A is a schematic sectional view of the packaging structure 300k according to at least one embodiment of the present disclosure, and FIG. 44B is a top view of the packaging structure 300k of the embodiment in FIG. 44A. In the embodiment, the packaging structure 300k includes a packaging substrate 250a, light-emitting elements 1500a, 1500b, at least one light-receiving element R, and a packaging layer 350'.

In the embodiment, the number of light-emitting elements 1500a, 1500b is two, and the number of light-receiving element R is one, forming a configuration of a single light-receiving element paired with plural light-emitting elements, but the application is not limited thereto.

The packaging substrate 250 has a first part 251, a second part 252, and an insulating part 253, where the insulating part 253 is located between the first part 251 and the second part 252. The first part 251 has plural regions corresponding to the light-emitting elements 1500a, 1500b. Each light-emitting element 1500a, 1500b has a light-output surface 1501 and a surface 1502, where the surface 1502 is opposite to the light-output surface 1501 and is on the packaging substrate 250, and each light-emitting element 1500a, 1500b is electrically connected to the packaging substrate 250. The light-receiving element R has a light-receiving surface R1, where the light-receiving element R is electrically connected to the packaging substrate 250.

In the embodiment, please refer to both FIGS. 44A and 44B. The sub-region B1 of the first part 251 corresponds to the light-emitting element 1500a, while the sub-region C1 of the first part 251 corresponds to the light-emitting element 1500b. Specifically, as can be seen in FIG. 44B, in the embodiment, the light-emitting element 1500a is located in region B1, the bottom electrode of the light-emitting element 1500a is electrically connected to the conductive pad on region B1, and the top electrode of the light-emitting element 1500a is electrically connected to the conductive pad on region A1 through the wiring W. The light-emitting element 1500b is located in region C1, the bottom electrode of the light-emitting element 1500b is electrically connected to the conductive pad on region C1, and the top electrode of the light-emitting element 1500b is electrically connected to the conductive pad on region D1 through the wiring W. Correspondingly, the light-receiving element R is located in region E1, the bottom electrode of the light-receiving element R is electrically connected to the conductive pad on region E1, and the top electrode of the light-receiving element R is electrically connected to the conductive pad on region F1 through the wiring W.

The packaging layer 350' includes a first packaging region 351 and a second packaging region 352. The first packaging region 351 is on the light-output surfaces 1501 of the light-emitting elements 1500a, 1500b, while the second packaging region 352 is on the light-receiving surface R1 of the light-receiving element R.

Please refer again to FIGS. 44A and 44B. The first packaging region 351 corresponding to the sub-regions A1 and B1 has a packaging surface 3511a. The first packaging region 351 corresponding to the sub-regions C1 and D1 has a packaging surface 3511b. The second packaging region 352 has a second packaging surface 3521. In other words, in the embodiment, the surface of the first packaging region 351 corresponding to the sub-regions A1 and B1 of the first part 251 is the packaging surface 3511a. The surface of the first packaging region 351 corresponding to the sub-regions C1 and D1 of the first part 251 is the packaging surface 3511b. The surface of the second packaging region 352 corresponding to the sub-regions E1 and F1 of the second part 252 is the second packaging surface 3521. The normal directions N1a, N1b of these packaging surfaces 3511a, 3511b are not parallel to each other, and the normal directions N1a, N1b of each of these packaging surfaces 3511a, 3511b are also not parallel to the normal direction N2 of the second packaging surface 3521.

In the embodiment, the packaging structure 300k is also applied to a proximity sensor. Specifically, by having the normal directions N1a, N1b of the packaging surfaces 3511a, 3511b not parallel to each other, and the normal directions N1a, N1b of each of these packaging surfaces 3511a, 3511b not parallel to the normal direction N2 of the second packaging surface 3521, the light emitted from the light-emitting elements 1500a, 1500b will not be directly received by the light-receiving element R adjacent to the light-emitting elements 1500a, 1500b. This way, when the proximity sensor is in use (e.g., applied in a mobile phone or other electronic device), the light emitted from the light-emitting elements 1500a, 1500b will not be directly received by the light-receiving element R, thereby avoiding false triggering of the proximity sensor. Therefore, the light emitted from the light-emitting elements 1500a, 1500b can be reflected by an obstacle to the light-receiving element R, allowing the proximity sensor to detect the presence of the obstacle.

The above specific embodiments do not constitute a limitation on the claimed scope of the present disclosure. Those skilled in the art should understand that, depending on design requirements and other factors, various modifications, combinations, sub-combinations, and alternatives may be realized. Any modifications, equivalent substitutions, and improvements made within the spirit and principles of the present disclosure should be included within the claimed scope of the present disclosure.

## Claims

1. A semiconductor laser, comprising:
a semiconductor stack having a first surface, a second surface opposite to the first surface, and a side surface between the first surface and the second surface, the semiconductor stack comprising:
a first-type semiconductor layer;
a second-type semiconductor layer; and
an active layer between the first-type semiconductor layer and the second-type semiconductor layer;
a first electrode structure on the first surface and the side surface;
a second electrode structure on the second-type semiconductor layer and electrically connected to the second-type semiconductor layer; and
an insulating layer between the semiconductor stack and the first electrode structure, and between the semiconductor stack and the second electrode structure, wherein the insulating layer comprises a first opening on the first surface, and the first electrode structure is in the first opening and contacts the first-type semiconductor layer.

2. The semiconductor laser according to claim 1, wherein the side surface form an angle with respect to the first surface, and the angle range is between 90 degrees and 120 degrees.

3. The semiconductor laser according to claim 1 or 2, further comprising a substrate, wherein the substrate is on a side of the second-type semiconductor layer opposite to the first-type semiconductor layer.

4. The semiconductor laser according to claim 3, wherein the second electrode structure is on the substrate; and the insulating layer further comprises a second opening on the surface of the second-type semiconductor layer, and the second electrode structure is distributed into the second opening and contacts the second-type semiconductor layer.

5. The semiconductor laser according to claim 3 or 4, wherein the insulating layer is on the first surface and the side surface.

6. The semiconductor laser according to any one of claims 3-5, wherein the substrate has a third surface and a side connected to the third surface, and the insulating layer and the second electrode structure are distributed onto the side of the substrate.

7. The semiconductor laser according to any one of claims 3-6, further comprising: an adhesive layer located between the second-type semiconductor layer and the substrate, wherein the substrate is bonded to the semiconductor stack through the adhesive layer.

8. The semiconductor laser according to any one of claims 1-7, wherein the first-type semiconductor layer or the second-type semiconductor layer, or both the first-type semiconductor layer and the second-type semiconductor layer, have a reflector layer.

9. The semiconductor laser according to claim 3, wherein,
the substrate is a conductive layer and contacts the second-type semiconductor layer, the insulating layer comprises a second opening on the surface of the substrate,
the second electrode structure comprises a contact electrode portion and an extension electrode portion, the extension electrode portion is connected to the contact electrode portion, the contact electrode portion is in the second opening, and the extension electrode portion extends from the second opening and is distributed onto the side surface.
